# EUROPEAN PATENT APPLICATION

(11) **EP 2 672 407 A1**
(43) Date of publication of application: **11.12.2013**
(21) Application number: 13168872.3
(22) Date of filing: 23.05.2013
(51) Int. Cl.: G06F 17/50

(54) **Simulator, simulation method, and simulation program for semiconductor device**

(30) Priority: 08.06.2012 JP 2012131368
(71) Applicant: Renesas Electronics Corporation, Kanagawa 211-8668 (JP)
(72) Inventor: Koga, Yasuhiro, Kanagawa, 211-8668 (JP)
(74) Representative: Betten & Resch

(57) **Abstract**

A simulator, which is used for simulating a semiconductor device including an AFE unit whose circuitry can be modified, includes: a circuitry configuration unit for configuring the circuitry of the AFE unit in accordance with a sensor that is coupled to the AFE unit; an input pattern selection unit for selecting a waveform pattern of a signal to be input to the sensor; and a simulation execution unit for executing a simulation on a combination of the sensor and the AFE unit that has the configured circuitry using the selected waveform pattern as an input condition.

## Description

### Cross-reference to related applications

The disclosure of Japanese Patent Application No. 2012-131368 filed on June 8, 2012 including the specification, drawings and abstract is incorporated herein in its entirety.

### BACKGROUND

The present invention relates to a simulator, a simulation method, and a computer readable medium storing a simulation program for a semiconductor device, and, can be favorably applied to, for example, a simulator, a simulation method, and a computer readable medium storing a simulation program for a semiconductor device including an analog front-end circuit.

In recent years, sensors have been widely used for various devices in many fields such as household, industrial, and medical usages for meeting the needs of improving the user-friendliness of the devices, developing systems with high economical efficiencies, improving healthcare, strengthening security, and the like. This trend has been backed by the fact that the user-friendliness of sensors has been improved, and analog circuits that are indispensable for materializing sensor functions have become able to operate at low voltages and low power consumption, which leads to the downsizing and cost reduction of various systems. There are many kinds of sensors such as a temperature sensor, an infrared sensor, an optical sensor, an impact sensor, and the like. According to their own operation principles, respective sensors are included in circuits that deal with sensed signals, and they are adjusted to exert their own functions.

In such a device in which these sensors are used, a control device such as a microcomputer performs control processing in accordance with a measurement result obtained from a sensor. Because a measured signal output from the sensor cannot directly be dealt with by the control device such as a microcomputer, an analog front-end (AFE) circuit performs some kinds of front-end processing such as amplifying the measured signal to a certain level, filtering out noises from the measured signal. In order to perform this front-end processing, it is necessary for the front-end circuit to be designed in accordance with the operation principle and characteristics of a sensor to be used, so that design know-how specific to analog circuits is needed. Therefore, on the basis of a better understanding of the operation principles and characteristics of sensors to be used, dedicated AFE circuits or dedicated ICs for individual specific sensors have been developed.

In the related art, circuit simulators (referred to as simulators for short hereinafter) have been used as design aid tools in order to design such an AFE circuit. There have been widely used several types of circuit simulators such as a stand-alone type simulator that executes simulation on a stand-alone computer, and a web server simulator that executes simulation on an online web server (Web server) (a web server simulator will be referred to as a web simulator hereinafter). For example, as a related web simulator, well known is "WEBENCH Designer (online)", which is available from Texas Instruments Incorporated (See URL: http//www.tij.co.jp/tihome/jp/docs/homepage.tsp at the time of May 29, 2012).

"WEBENCH Designer" is a web simulator for semiconductor devices including AFE circuits for sensors. In "WEBENCH Designer", a user can select a sensor to be coupled to an AFE circuit and can configure a physical quantity detected by the sensor in order to execute a simulation. In addition, in "WEBENCH Designer", the user can adjust the gain of an amplifier embedded in the AFE circuit with reference to the simulation result.

In addition, as a related analog circuit simulator, a simulator disclosed in Japanese Unexamined Patent Application Publication No. 2004-145410 is also well-known.

### SUMMARY

In the above-mentioned "WEBENCH Designer", the user inputs the value of a physical quantity detected by a sensor, and "WEBENCH Designer" executes a simulation about the operations of the sensor and the AFE circuit in accordance with the physical quantity.

Actually, it is necessary for an analog circuit such as an AFE circuit to be designed so that its time-dependent characteristics, such as its response characteristic, its frequency characteristic and the like, satisfy required design specifications.

However, in the related simulators such as "WEBENCH Designer", because the physical quantity to be input to a sensor can be configured by only one numerical value, it is difficult to execute a simulation that is suitable for checking time-dependent characteristics, and the like. In other words, the related simulators have a problem in that suitable simulations cannot be executed effectively.

Other problems of the related arts and new features of the present invention will be revealed in accordance with the description about this specification of the present invention and the accompanying drawings hereinafter.

A simulator for semiconductor devices according to an aspect of the present invention is a simulator for semiconductor devices including a front-end circuit whose circuitry can be modified. This simulator includes an input pattern storage unit, a circuitry configuration unit, an input pattern display unit, an input pattern selection unit, and a simulation execution unit. The input pattern storage unit stores plural waveform patterns of signals to be input to sensors. The circuitry configuration unit configures the circuitry of the analog front-end circuit in accordance with a sensor that is coupled to the analog front-end circuit. The input pattern display unit displays the plural waveform patterns stored in the input pattern storage unit. The input pattern selection unit selects a waveform pattern to be input to a sensor out of the displayed plural waveform patterns according to a user operation. The simulation execution unit executes a simulation on a combination of the sensor and the analog front-end circuit that has the configuration circuitry using the selected waveform pattern as an input condition.

According to the aspect of the present invention, a simulation of a sensor and an analog front-end circuit can be effectively executed.

### BRIEF DESCRIPTION OF THE DRAWINGS

Fig. 1 is a block diagram of a sensor system according to an embodiment;
Fig. 2 is a circuit block diagram of a semiconductor device according to the embodiment;
Fig. 3 is a diagram showing a coupling relation among the circuits of the semiconductor device according to the embodiment;
Fig. 4 is a diagram showing a coupling example of a circuit of the semiconductor device according to the embodiment;
Fig. 5 is a diagram showing another coupling example of the circuit of the semiconductor device according to the embodiment;
Fig. 6 is a diagram showing a coupling example of a circuit of the semiconductor device according to the embodiment;
Fig. 7 is a diagram showing another coupling example of the circuit of the semiconductor device according to the embodiment;
Fig. 8 is a circuit diagram showing a circuitry of a circuit of the semiconductor device according to the embodiment;
Fig. 9 is a circuit diagram showing an example of a modified circuitry of the circuit of the semiconductor device according to the embodiment;
Fig. 10 is a circuit diagram showing another example of a modified circuitry of the circuit of the semiconductor device according to the embodiment;
Fig. 11 is a circuit diagram showing another example of a modified circuitry of the circuit of the semiconductor device according to the embodiment;
Fig. 12 is a circuit diagram showing another example of a modified circuitry of the circuit of the semiconductor device according to the embodiment;
Fig. 13 is a circuit diagram showing another example of a modified circuitry of the circuit of the semiconductor device according to the embodiment;
Fig. 14 is a circuit diagram showing another example of a modified circuitry of the circuit of the semiconductor device according to the embodiment;
Fig. 15 is a circuit diagram showing a circuitry of the semiconductor device according to the embodiment;
Fig. 16 is a timing chart showing an operation of the semiconductor device according to the embodiment;
Fig. 17 is a circuit diagram showing a circuitry of the semiconductor device according to the embodiment;
Fig. 18 is a circuit diagram showing a circuitry of the semiconductor device according to the embodiment;
Fig. 19 is a circuit diagram showing a circuitry of the semiconductor device according to the embodiment;
Fig. 20 is a circuit diagram showing a circuitry of the semiconductor device according to the embodiment;
Fig. 21 is a circuit block diagram of another semiconductor device according to the embodiment;
Fig. 22 is a diagram showing coupling relations among the circuits of the semiconductor device according to the embodiment;
Fig. 23 is a circuit block diagram of another semiconductor device according to the embodiment;
Fig. 24 is a diagram showing coupling relations among circuits of the semiconductor device according to the embodiment;
Fig. 25 is a circuit diagram showing a circuitry of a circuit of the semiconductor device according to the embodiment;
Fig. 26 is a block diagram of a simulation system according to the embodiment;
Fig. 27 is a block diagram of hardware included in the simulation system according to the embodiment;
Fig. 28A is a functional block diagram of a web simulator according to the embodiment;
Fig. 28B is a functional block diagram of the web simulator according to the embodiment;
Fig. 28C is a functional block diagram of the web simulator according to the embodiment;
Fig. 29 is a flowchart showing a simulation method of the web simulator according to the embodiment;
Fig. 30 is a flowchart showing the simulation method of the web simulator according to the embodiment;
Fig. 31 is a flowchart showing the simulation method of the web simulator according to the embodiment;
Fig. 32 is a circuit diagram for explaining the simulation method of the web simulator according to the embodiment;
Fig. 33 is a circuit diagram for explaining the simulation method of the web simulator according to the embodiment;
Fig. 34 is a flowchart showing the simulation method of the web simulator according to the embodiment;
Fig. 35 is a flowchart showing the simulation method of the web simulator according to the embodiment;
Fig. 36 is a flowchart showing the simulation method of the web simulator according to the embodiment;
Fig. 37 is a flowchart showing the simulation method of the web simulator according to the embodiment;
Fig. 38 is a display image diagram of a display screen used for the simulation method of the web simulator according to the embodiment;
Fig. 39 is a display image diagram of a display screen used for the simulation method of the web simulator according to the embodiment;
Fig. 40 is a display image diagram of a display screen used for the simulation method of the web simulator according to the embodiment;
Fig. 41 is a display image diagram of a display screen used for the simulation method of the web simulator according to the embodiment;
Fig. 42 is a display image diagram of a display screen used for the simulation method of the web simulator according to the embodiment;
Fig. 43 is a display image diagram of a display screen used for the simulation method of the web simulator according to the embodiment;
Fig. 44 is a display image diagram of a display screen used for the simulation method of the web simulator according to the embodiment;
Fig. 45 is a display image diagram of a display screen used for the simulation method of the web simulator according to the embodiment;
Fig. 46 is a display image diagram of a display screen used for the simulation method of the web simulator according to the embodiment;
Fig. 47 is a display image diagram of a display screen used for the simulation method of the web simulator according to the embodiment;
Fig. 48 is a display image diagram of a display screen used for the simulation method of the web simulator according to the embodiment;
Fig. 49 is a display image diagram of a display screen used for the simulation method of the web simulator according to the embodiment;
Fig. 50 is a display image diagram of a display screen used for the simulation method of the web simulator according to the embodiment;
Fig. 51 is a display image diagram of a display screen used for the simulation method of the web simulator according to the embodiment;
Fig. 52 is an input/output waveform chart for explaining the simulation method of the web simulator according to the embodiment;
Fig. 53 is a display image diagram of a display screen used for the simulation method of the web simulator according to the embodiment;
Fig. 54 is a display image diagram of a display screen used for the simulation method of the web simulator according to the embodiment;
Fig. 55 is a display image diagram of a display screen used for the simulation method of the web simulator according to the embodiment;
Fig. 56 is a display image diagram of a display screen used for the simulation method of the web simulator according to the embodiment;
Fig. 57 is a display image diagram of a display screen used for the simulation method of the web simulator according to the embodiment;
Fig. 58 is a display image diagram of a display screen used for the simulation method of the web simulator according to the embodiment;
Fig. 59 is a display image diagram of a display screen used for the simulation method of the web simulator according to the embodiment;
Fig. 60A is a display image diagram of a display screen used for the simulation method of the web simulator according to the embodiment;
Fig. 60B is a display image diagram of a display screen used for the simulation method of the web simulator according to the embodiment;
Fig. 60C is a display image diagram of a display screen used for the simulation method of the web simulator according to the embodiment;
Fig. 61A is a display image diagram of a display screen used for the simulation method of the web simulator according to the embodiment;
Fig. 61B is a display image diagram of a display screen used for the simulation method of the web simulator according to the embodiment;
Fig. 61C is a display image diagram of a display screen used for the simulation method of the web simulator according to the embodiment;
Fig. 61D is a display image diagram of a display screen used for the simulation method of the web simulator according to the embodiment;
Fig. 62 is a display image diagram of a display screen used for the simulation method of the web simulator according to the embodiment;
Fig. 63 is a display image diagram of a display screen used for the simulation method of the web simulator according to the embodiment;
Fig. 64A is a display image diagram of a display screen used for the simulation method of the web simulator according to the embodiment;
Fig. 64B is a display image diagram of a display screen used for the simulation method of the web simulator according to the embodiment;
Fig. 64C is a display image diagram of a display screen used for the simulation method of the web simulator according to the embodiment;
Fig. 64D is a display image diagram of a display screen used for the simulation method of the web simulator according to the embodiment;
Fig. 64E is a display image diagram of a display screen used for the simulation method of the web simulator according to the embodiment;
Fig. 64F is a display image diagram of a display screen used for the simulation method of the web simulator according to the embodiment;
Fig. 64G is a display image diagram of a display screen used for the simulation method of the web simulator according to the embodiment;
Fig. 65 is a block diagram of a configuration system of the semiconductor device according to the embodiment; and
Fig. 66 is a flowchart showing a configuration method of the semiconductor device according to the embodiment.

### DETAILED DESCRIPTION

Hereinafter, an embodiment of the present invention will be described with reference to the accompanying drawings. In this embodiment, in order to optimally configure a semiconductor device the circuitry and circuit characteristics of which are variable, simulations are executed on a circuit that is equivalent to the semiconductor device.

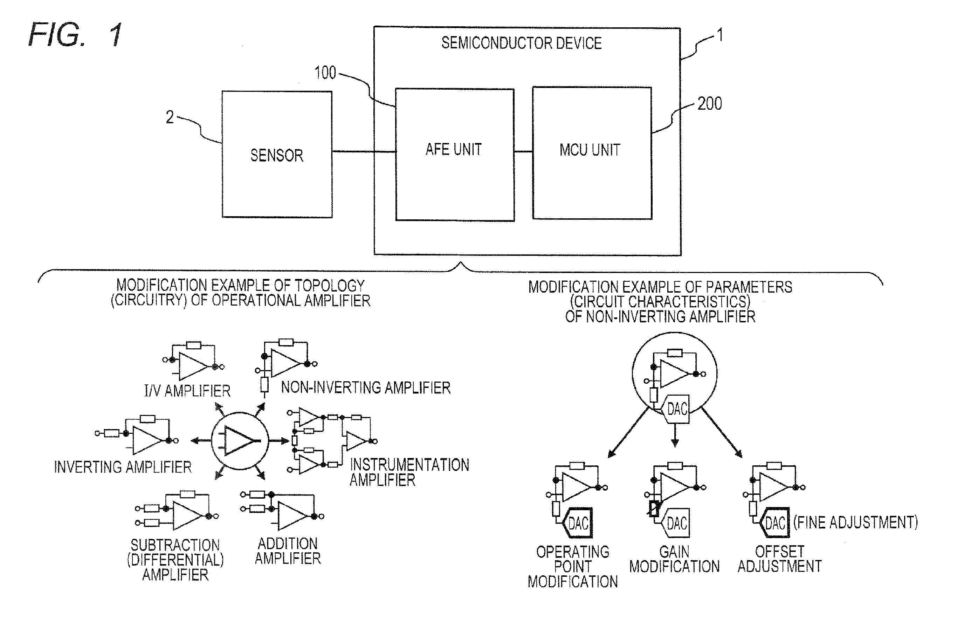

In order to bring about a better understanding of a simulator according to this embodiment, a semiconductor device including a simulation target circuit will be described first. Fig. 1 shows the configuration of a sensor system including a semiconductor device according to the embodiment.

As shown in Fig. 1, this system includes a sensor 2, and a semiconductor 1 coupled to the sensor 2.

As the sensor 2, various sensors such as a current output type sensor that outputs a current corresponding to a detection result, a voltage output type sensor that outputs a voltage corresponding to a detection result, a sensor that outputs a weak differential signal corresponding to a detection result, and the like can be used.

The semiconductor device 1 includes an MCU unit 200 and an AFE unit 100. For example, the semiconductor device 1 is a SoC (System-on-a-Chip) on which the semiconductor chip of the MCU unit 200 and the semiconductor chip of the AFE unit 100 are mounted. Alternatively, the semiconductor device 1 can be fabricated as a one-chip semiconductor device including both the MCU unit 200 and the AFE unit 100. In addition, the semiconductor device 1 can be a combination of a semiconductor device including only the MCU unit 200 and a semiconductor device including only the AFE unit 100. A combination of the sensor 2 and the AFE unit 100 included in the semiconductor device 1 is a simulation target of the after-described simulator according to this embodiment. Hereinafter, there will be a case where a device including the AFE unit 100 and the MCU unit 200 is referred to as the semiconductor device 1, and there will be another case where a device including only the AFE unit 100 is referred to as the semiconductor device 1.

The MCU unit (control unit) 200 is a microcomputer that A/D-converts a measured signal (detected signal) of the sensor 2 input via the AFE unit 100, and performs control processing in accordance with the detected result. In addition, the MCU unit 200 outputs a control signal for modifying the configuration for the circuitry and characteristics of the AFE unit 100 to the AFE unit 100.

The AFE unit (analog input unit) 100 is an analog circuit that performs analog front-end processing such as amplifying, filtering on the measured signal output from the sensor 2 so that the measured signal becomes a signal that can be dealt with by the MCU unit 200. In addition, as shown in Fig. 1, the topology (circuitry) of the AFE unit 100 can be modified, and the parameters (circuit characteristics) of the AFE unit 100 can also be modified.

As shown in Fig. 1, by configuring a circuit including one or more operational amplifiers, the circuit can be changed to any one of an I/V amplifier, a subtraction (differential) amplifier, an addition amplifier, an inverting amplifier, an noninverting amplifier, and an instrumentation amplifier. In addition, by modifying the parameters of the noninverting amplifier shown in the lower right as an example of the operational amplifier, the operation point and gain of the operational amplifier can be changed, and the offset of the operational amplifier can be adjusted.

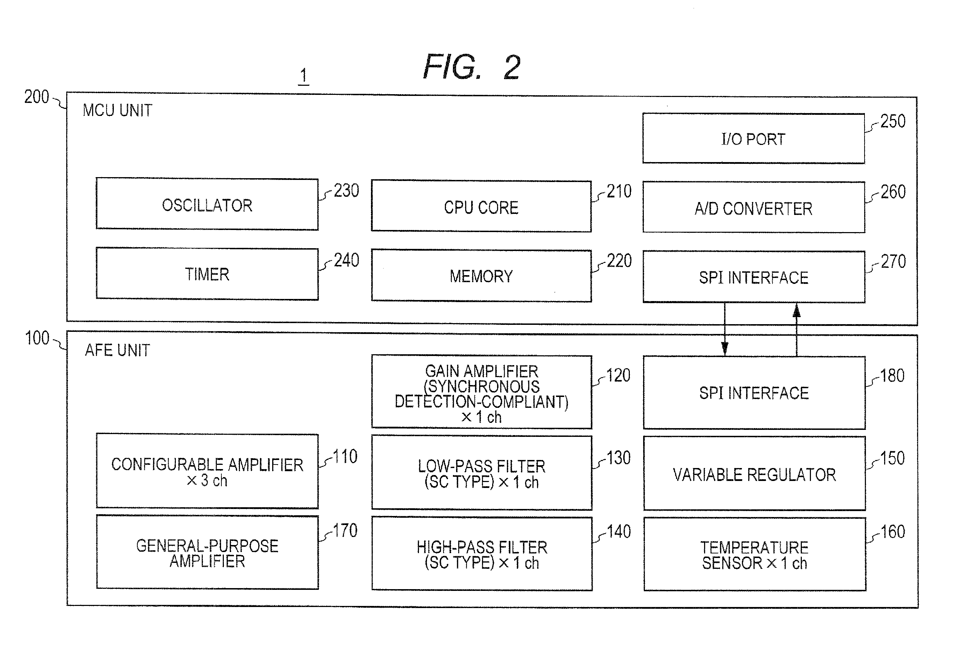

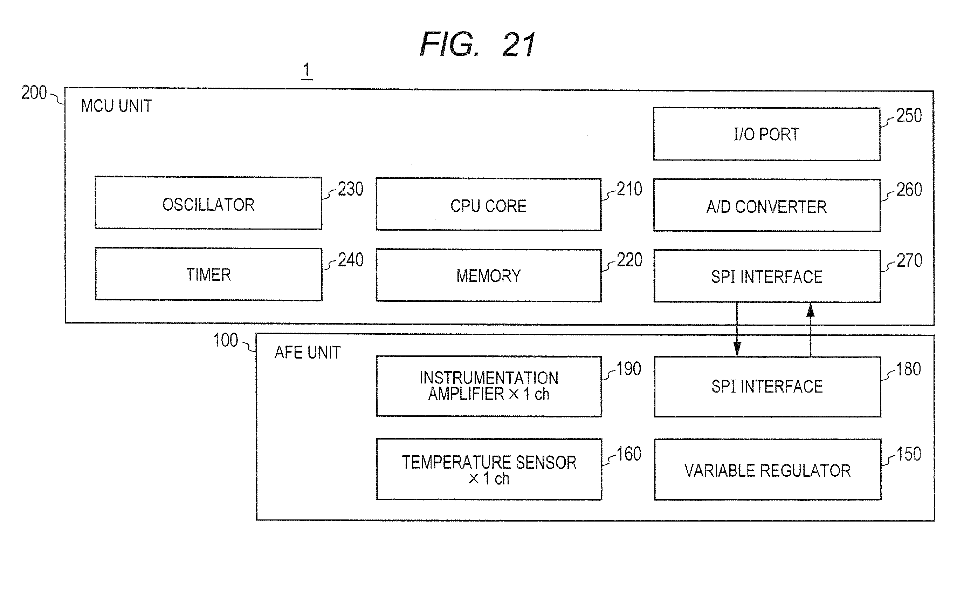

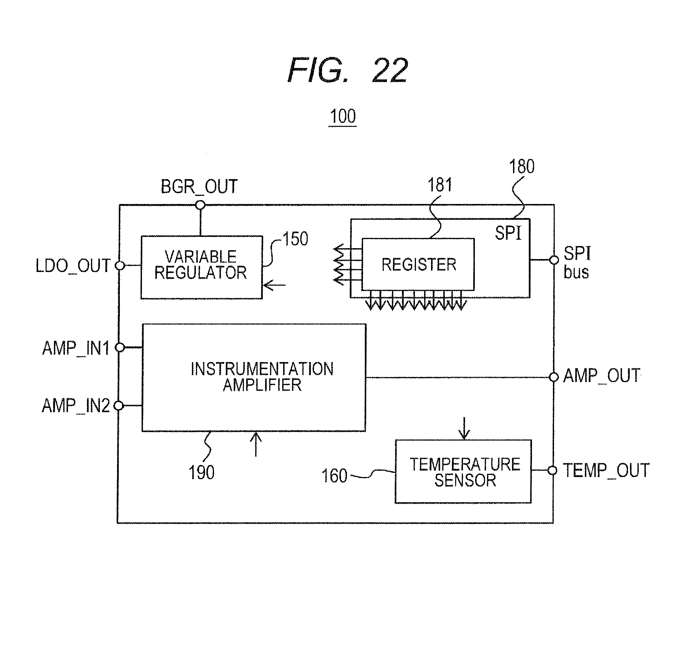

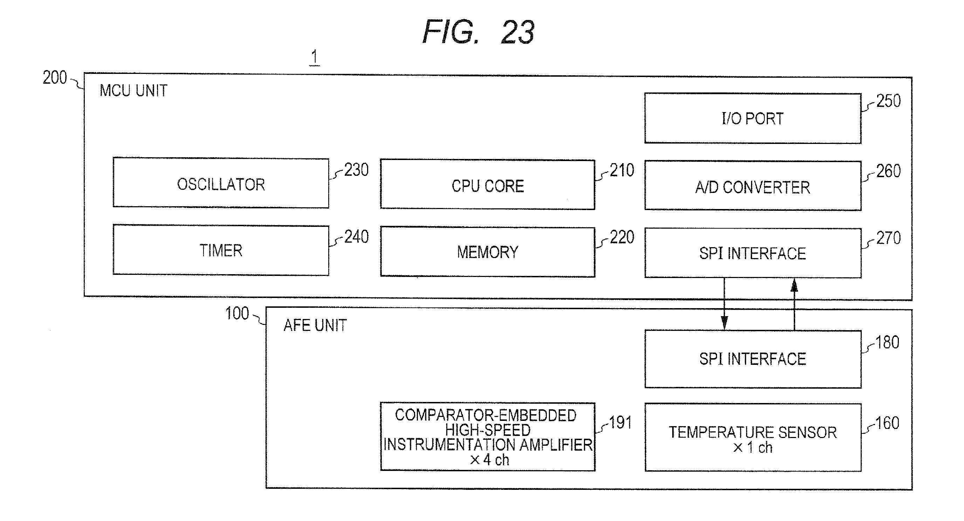

The semiconductor device 1 according to the embodiment can be changed into one of plural types (referred to as TYPE0, TYPE1, etc. hereinafter) of semiconductor devices which are well-adapted to different usages by configuring the internal circuit of the AFE unit 100. The semiconductor device 1 of TYPE0 that is specified for general-purpose systems will be described with reference to Fig. 2 to Fig. 20, the semiconductor device 1 of TYPE1 that is specified for general measuring instruments will be described with reference to Fig. 21 and Fig. 22, and the semiconductor device 1 of TYPE2 that is specified for motor control will be described with reference to Fig. 23 to Fig. 25. In addition, there are cases where any of the semiconductor devices 1 of TYPE0 to TYPE2 will be referred to merely as the semiconductor device 1.

Fig. 2 shows a circuit block diagram of the semiconductor device 1 of TYPE0. As shown in Fig. 2, the MCU unit 200 includes a CPU core 210, a memory 220, an oscillator 230, a timer 240, an I/O port 250, an A/D converter 260, and an SPI (Serial Peripheral Interface) interface 270. In addition, the MCU unit 200 includes other circuits such as a DMA and various computing circuits in order to materialize a microcontroller function.

The CPU core 210 executes programs stored in the memory 220, and performs control processing in accordance with the programs. The memory 220 stores the programs executed by the CPU core 210 and various kinds of data. The oscillator 230 generates an operation clock for the MCU unit 200, and supplies the operation clock to the AFE unit 100, if necessary. The timer 240 is used for the control operation performed by the MCU unit 200.

The I/O port 250 works as an interface for inputting and outputting of data and the like between the semiconductor device 1 and external devices and, for example, it enables the semiconductor device 1 to couple to external computer devices and the like as described later.

The A/D converter 260 A/D converts the measured signal of the sensor 2 input via the AFE unit 100. Here, the power used by the A/D converter 260 is supplied from the AFE unit 100.

The SPI (Serial Peripheral Interface) interface 270 is an interface used for the MCU unit 200 to input and output data and the like from and to the AFE unit 100. In addition, the SPI interface 270 is a general-purpose serial interface, so that it enables other microcontrollers/microcomputers to couple to the AFE unit 100 if their interfaces are compliant with the SPI interface.

The semiconductor device 1 of TYPE0 shown in Fig. 2 is configured to accept general-purpose applications. To put it concretely, the semiconductor device 1 of TYPE0 mounts a complete set of AFE circuits thereon in order to enable the semiconductor device 1 to couple to sensors with various types and characteristics. In other words, the AFE unit 100 includes a configurable amplifier 110, a synchronous detection compliant gain amplifier (also referred to as a gain amplifier) 120, an SC type low-pass filter (also referred to as a low-pass filter) 130, an SC type high-pass filter (also referred to as a high-pass filter) 140, a variable regulator 150, a temperature sensor 160, a general-purpose amplifier 170, and an SPI interface 180.

The configurable amplifier 110 is an amplifying circuit that amplifies signals input from the external devices such as the sensor 2, and its circuitry, its characteristics, and its operation are configurable in accordance with control issued from the MCU unit 200. The configurable amplifier 110 is a three-channel amplifier. In other words, the configurable amplifier 110 includes three amplifiers. Owing to these three amplifiers, the configurable amplifier 110 can materialize various circuitries.

The gain amplifier 120 is a synchronous detection compliant amplifying circuit that amplifies the outputs from the configurable amplifier 110, and signals sent from external devices such as the sensor 2, and its characteristics and its operation are configurable in accordance with control issued from the MCU unit 200.

The low-pass filter 130 is an SC type filter that removes the high frequency components of signals sent from external devices such as the configurable amplifier 110, the gain amplifier 120, and the sensor 2, and passes the low frequency components of the signals, and its characteristics and its operation are configurable in accordance with control issued from the MCU unit 200. The high-pass filter 140 is an SC type filter that removes the low frequency components from the outputs of the configurable amplifier 110 and the gain amplifier 120, and from the signals sent from external devices such as the sensor 2, and passes the low frequency components of the signals, and its characteristics, and operation are configurable in accordance with control issued from the MCU unit 200.

The variable regulator 150 is a variable voltage source that supplies a voltage to the A/D converter 260 of the MCU 200, and its characteristics, and operation are configurable in accordance with control issued from the MCU unit 200. The temperature sensor 160 is a sensor that measures the temperature of the semiconductor device 1, and its characteristics and its operation are configurable in accordance with control issued from the MCU unit 200.

The general-purpose amplifier 170 is an amplifier that amplifies signals sent from external devices such as from the sensor 2, and its operation is configurable in accordance with control issued from the MCU unit 200. The SPI interface 180 is an interface used for the AFE unit 100 to input and output data and the like to and from the MCU unit 200 via an SPI interface 270 and an SPI bus of the MCU unit 200. In addition, if the semiconductor device 1 does not include the MCU unit 200, by coupling the SPI interface 180 to the external terminal of the semiconductor device 1, the AFE unit 100 is coupled to an external microcontroller, an external emulator, and the like via the external terminal.

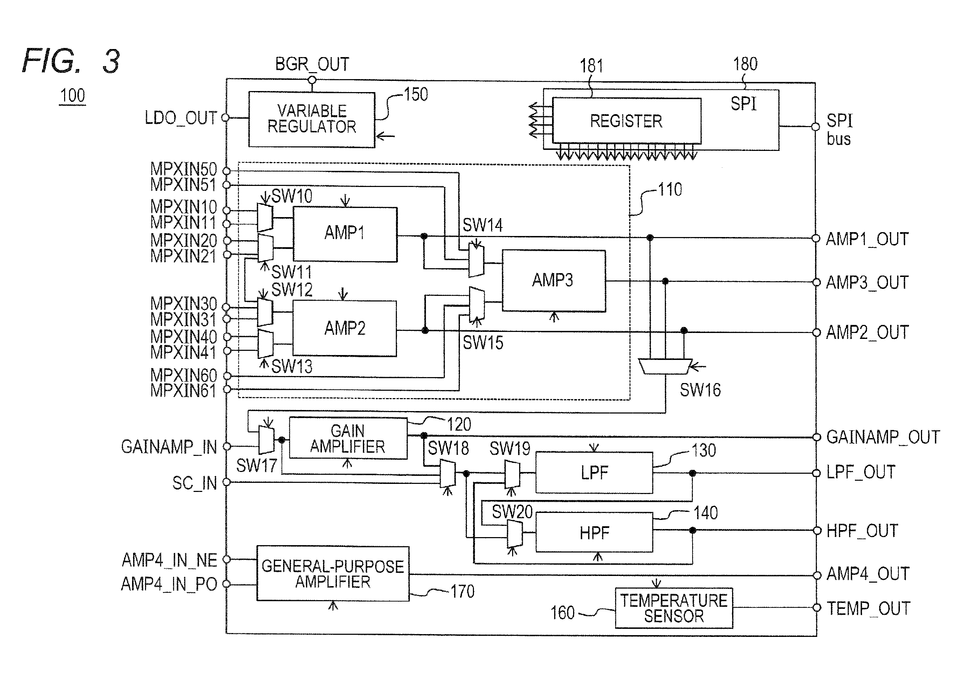

Next, the configuration of the AFE unit 100 in the semiconductor device 1 of TYPE0 will be described in detail. Fig. 3 is a diagram showing a coupling relation among the circuits of the AFE 100. The SPI interface 180 is coupled to the external terminals (CS, SCLK, SDO, and SDI), and includes a register (control register) 181. Configuration information (setting information) for modifying the circuitry and characteristics of the circuits is input from the MCU unit 200 via the SPI interface, and the information is stored in the register 181. The register 181 is coupled to each circuit in the AFE unit 100, the circuitry and characteristics of each circuit in the AFE unit 100 are configured in accordance with the configuration information stored in the register 181.

The configurable amplifier 110 include amplifiers AMP1, AMP2, and AMP3, and these amplifiers are coupled to switches SW10 to SW15 that are used for switching inputs and outputs of these amplifiers.

One input terminal of amplifier AMP1 is coupled to either of terminal MPXIN10 or terminal MPXIN11 via switch SW10, the other input terminal is coupled to either of terminal MPXIN20 or terminal MPXIN21 via switch SW11, and an output terminal of amplifier AMP1 is coupled to terminal AMP1_OUT. In a similar way, one input terminal of amplifier AMP2 is coupled to either of terminal MPXIN30 or terminal MPXIN31 via switch SW12, the other input terminal is coupled to either of terminal MPXIN40 or terminal MPXIN41 via switch SW13, and an output terminal of amplifier AMP2 is coupled to terminal AMP2_OUT.

In addition, one input terminal of amplifier AMP3 is coupled to either of MPXIN50, MPXIN51, or the output terminal of AMP1 via switch SW14, the other input terminal is coupled to either of terminals MPXIN60, MPXIN61, or the output terminal of AMP2 via switch SW15, and an output terminal of amplifier AMP3 is coupled to terminal AMP3_OUT. The output terminals of AMP1, AMP2, and AMP3 are also coupled to the gain amplifier 120, the low-pass filter 130, and the high-pass filter 140.

The internal circuitry and characteristics of the configurable amplifier 110 are modified as described below because the coupling configuration among AMP1, AMP2, and AMP3 are modified by switching switches SW10 to SW15 in accordance with the configuration values of the register 181.

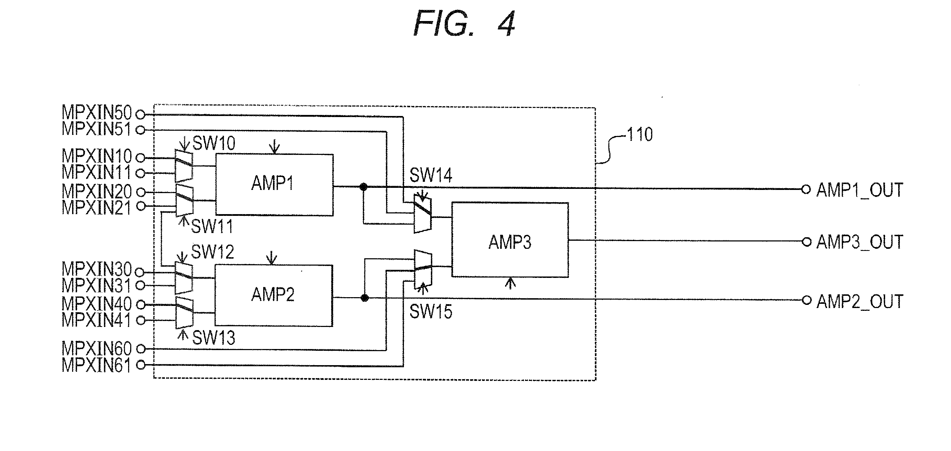

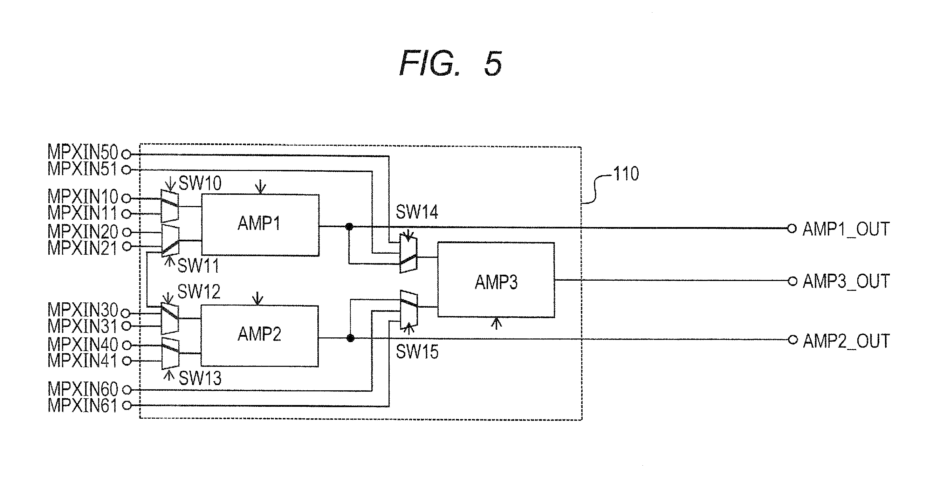

Fig. 4 and Fig. 5 are examples of switching the couplings among AMP1, AMP2, and AMP3 with the use of switches SW10 to SW15. In Fig. 4, in accordance with the configuration values of the register 181, switches SW10 and SW11 are switched so that input terminals of AMP1 are coupled to terminals MPXIN10 and MPXIN20, switches SW12 and SW13 are switched so that the input terminals of AMP2 are coupled to terminals MPXIN30 and MPXIN40, and switches SW14 and SW15 are switched so that the input terminals of AMP3 are coupled to terminals MPXIN50 and MPXIN60. With the above couplings, it becomes possible to make AMP1, AMP2, and AMP3 respectively operate as independent amplifiers.

In Fig. 5, in accordance with the configuration values of the register 181, switch SW10 is switched so that one input terminal of AMP1 is coupled to terminal MPXIN10, switch SW13 is switched so that one input terminal of AMP2 is coupled to terminal MPXIN40, switches SW11 and SW12 are switched so that the other input terminal of AMP1 and the other input terminal of AMP2 are coupled to each other, and switches SW14 and SW15 are switched so that one input terminal of AMP3 is coupled to the output terminal of AMP1 and the other input terminal of AMP3 is coupled to the output terminal of AMP2. With the above couplings, it becomes possible to configure an instrumentation amplifier including AMP1, AMP2, and AMP3.

In addition, as shown in Fig. 3, switches SW16 and SW17 are coupled to the gain amplifier 120 so that the input to the gain amplifier 120 can be switched. The input terminal of the gain amplifier 120 is coupled to the output terminal of AMP1, the output terminal of AMP2, or the output terminal of AMP3 via switch SW16 and switch SW17 and is coupled to terminal GAINAMP_IN via switch 17. In addition, the output terminal of the gain amplifier 120 is coupled to terminal GAINAMP_OUT. The output terminal of the gain amplifier 120 is also coupled to the low-pas filter 130 and the high-pass filter 140. In addition, with the use of switch SW16, the coupling between the output terminals of AMP1 to AMP3 and external terminals or the gain amplifier can be switched.

Switches SW18 and SW19 are coupled to the low-pass filter 130 so as to switch the input to the low-pass filter 130, and switch SW18 and switch SW20 are also coupled to the high-pass filter 140 so as to switch the input to the high-pass filter 140. The input terminal of the low-pass filter 130 is coupled to the output terminals of AMP1 to AMP3 via switches SW16, SW17, SW18, and SW19, coupled to the output terminal of the gain amplifier 120 and SC_IN via switches SW18 and SW19, and coupled to the output terminal of the high-pass filter 140 via switch SW19. In addition, the output terminal of the low-pass filter 130 is coupled to terminal LPF_OUT. The input terminal of the high-pass filter 140 is coupled to the output terminals of AMP1 to AMP3 via switches SW16, SW17, SW18, and SW20, coupled to the output terminal of the gain amplifier 120 and SC_IN via switches SW18 and SW20, and coupled to the output terminal of the low-pass filter 130 via switch SW20. In addition, the output terminal of the high-pass filter 140 is coupled to terminal HPF_OUT. In addition, by installing a switch between the output terminal of the low-pass filter 130 and the corresponding external terminal, the coupling of the output terminal of the low-pass filter 130 to the external terminal and the coupling of the output terminal of the low-pass filter 130 to SW20 can be switched. In addition, by installing a switch between the output terminal of the high-pass filter 140 and the corresponding external terminal, the coupling of the output terminal of the high-pass filter 140 to the external terminal and the coupling of the output terminal of the high-pass filter 140 to SW19 can be switched.

The coupling configurations of the gain amplifier 120, the low-pass filter 130, and the high-pass filter 140 are modified by turning switches SW16 to SW20 on and off in accordance with the configuration values of the register 181, and their internal characteristics are also modified as described later.

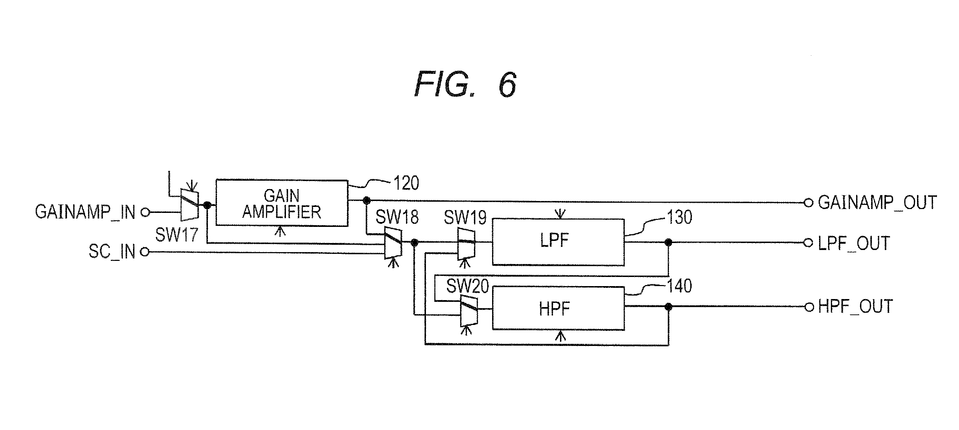

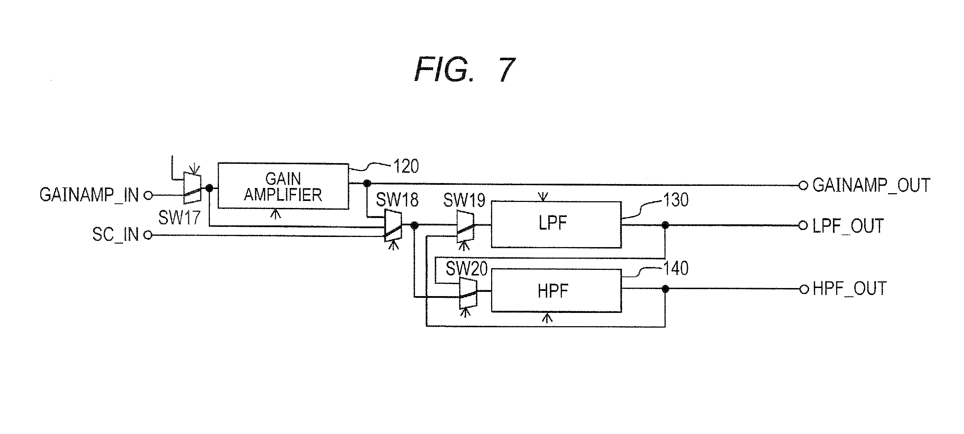

Fig. 6 and Fig. 7 are examples of coupling switchings among the gain amplifiers 120, the low-pass filter 130, and the high-pass filter 140 executed by switches SW17 to SW20. In Fig. 6, in accordance with the configuration values of the register 181, the input terminal of the gain amplifier 120 is coupled to either of the output terminals of AMP1, AMP2, and AMP3 by switching switch SW17, the input terminal of the low-pass filter 130 is coupled to the output terminal of the gain amplifier 120 by switching switches SW18 and SW19, and the input terminal of the high-pass filter 140 is coupled to the output terminal of the low-pass filter 130 by switching switch SW20. By executing such switchings, a circuit, in which any one of AMP1, AMP2, and AMP3, the gain amplifier 120, the low-pass filter 130, and the high-pass filter 140 are coupled in this order, can be configured.

In Fig. 7, in accordance with the configuration values of the register 181, the input terminal of the gain amplifier 120 is coupled to GAINAMP_IN by switching switch SW17, the input terminal of the high-pass filter 140 is coupled to SC_IN by switching switches SW18 and SW20, and the input terminal of the low-pass filter 130 is coupled to the output terminal of the high-pass filter 140 by switching switch SW19. By executing such switchings, it becomes possible to make the gain amplifier 120 function as an independent amplifier, and a circuit, in which the high-pass filter 140 and the low-pass filter 130 are coupled in this order, can be configured.

In addition, as shown in Fig. 3, the output terminals of the variable regulator 150 are respectively coupled to terminals BGR_OUT and LDO_OUT. The characteristics of the variable regulator 150 is modified in accordance with the configuration values of the register 181 as described later.

The output terminal of the temperature sensor 160 is coupled to terminal TEMP_OUT. The characteristics of the temperature sensor 160 are modified in accordance with the configuration values of the register 181 as described later.

One of the input terminals of the general-purpose amplifier 170 is coupled to terminal AMP4_IN_NE, the other of the input terminals of the general-purpose amplifier 170 is coupled to terminal AMP4_IN_PO, and the output terminal of the general-purpose amplifier 170 is coupled to terminal AMP4_OUT. The general-purpose amplifier includes one operational amplifier, and the on-off operation of its power supply is configured in accordance with the configuration values of the register 181.

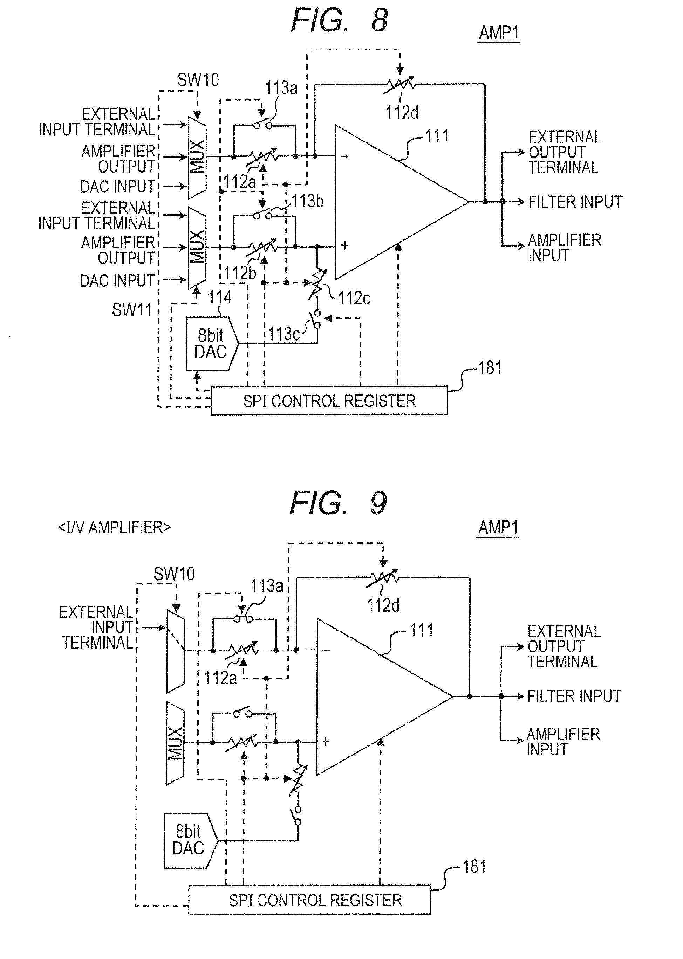

Next, the concrete circuitry of the configurable amplifier 110 will be described with reference to Fig. 8 to Fig. 14.

The configurable amplifier 110 is an amplifier for amplifying the output signal of a sensor, and the parameters (characteristics) as well as the topology (circuitry) of the configurable amplifier 110 can be modified in accordance with the configuration of the control register. One example of the modifications of characteristics is that the gain of the configurable amplifier can be configured to be variable. For example, in the case where the individual amplifiers are independently used, their gains can be configured to be within 6 dB to 46 dB by 2 dB, and in the case where the three amplifiers are used as an instrumentation amplifier, the gain of the instrumentation amplifier can be configured to be within 20 dB to 60 dB by 2 dB. In addition, the through rate of the configurable amplifier 110 can be configured to be variable, and the on-off operation of the power supply can be switched when the configurable amplifier 110 is in the power-off mode.

Fig. 8 shows the circuitry of amplifier AMP1 of the configurable amplifier 110. In addition, the circuitries of amplifiers AMP2 and AMP3 are the same as the circuitry of amplifier AMP1.

AS shown in Fig. 8, amplifier AMP1 includes an operational amplifier 111, variable resistors 112a to 112d that are coupled to the terminals of the operational amplifier 111, switches 113a to 113c, and a DAC 114. In addition, as shown in Fig. 3, multiplexers (switches) SW10 and SW11 are coupled to amplifier AMP1.

In accordance with the configuration values of the register 181, inputs to the operational amplifier 111 are switched by multiplexers SW10 and SW11, the switch 113a switches between the presence and absence of a variable resistor (input resistor) 112a, the switch 113b switches between the presence and absence of a variable resistor (input resistor) 112b, and the switch 113c switches the coupling of the DAC 114. In addition, as shown in Fig. 3, the couplings of the outputs of the operational amplifiers 111 to the gain amplifier 120, to the low-pass filter 130, and to the high-pass filter 140 are switched by switches SW16, SW17, and SW18. In addition, by modifying the resistor values of the variable resistors 112a, 112b, 112c and 112d, and the configuration of the DAC 114 in accordance with the configuration values of the register 181, the gain, operation point, offset, and the like of AMP1 can be changed. In addition, the on-off operation of the power supply of amplifier AMP1 can be controlled in accordance with the configuration values of the register 181. In addition, by modifying the operation mode of the operational amplifier into a high-speed mode, a medium-speed mode, or a low-speed mode in accordance with the configuration values of the register 181, the through rate can be controlled.

The switching of the individual switches and multiplexers of the configurable amplifier 110 makes it possible to configure an I/V amplifier, an inverting amplifier, a subtraction (differential) amplifier, a noninverting amplifier, and an addition amplifier.

Fig. 9 is a diagram showing an example of the configuration of an I/V amplifier. In accordance with the configuration values of the register 181, external terminal MPXIN10 is coupled to the inverting input terminal by switching multiplexer SW10, and the variable resistor 112a is shorted by turning the switch 113a on. This coupling shown in Fig. 9 makes it possible to configure an I/V amplifier. In addition, by modifying the resistor values of the variable resistors 112a and 112d in accordance with the configuration values of the register 181, the gain of the amplifier is configured. When the signal of a current-type sensor is input through the external input terminal into this I/V amplifier, this amplifier converts the input current into a voltage, and outputs the voltage.

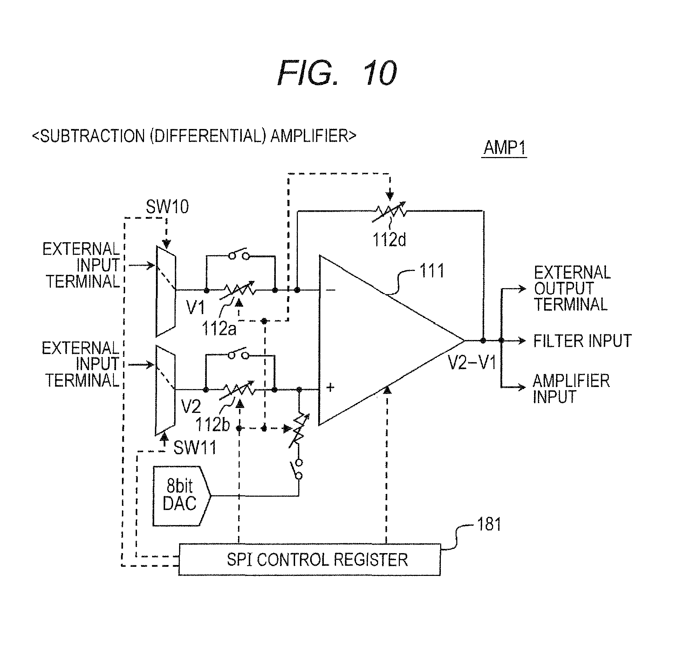

Fig. 10 is a diagram showing an example of the configuration of a subtraction (differential) amplifier. In accordance with the configuration values of the register 181, external input terminal MPXIN10 is coupled to the inverting input terminal and external input terminal MPXIN20 is coupled to the noninverting input terminal by switching multiplexers SW10 and SW11 respectively. This coupling shown in Fig. 10 makes it possible to configure an subtraction amplifier. In addition, by modifying the resistor values of the variable resistors 112a, 112b, and 112d in accordance with the configuration values of the register 181, the gain of the amplifier is configured. When two signals (V1, V2) are input into this subtraction amplifier from the external input terminals, this amplifier outputs a difference obtained by subtracting one input voltage V1 from the other input voltage V2, that is, a voltage (V2 - V1).

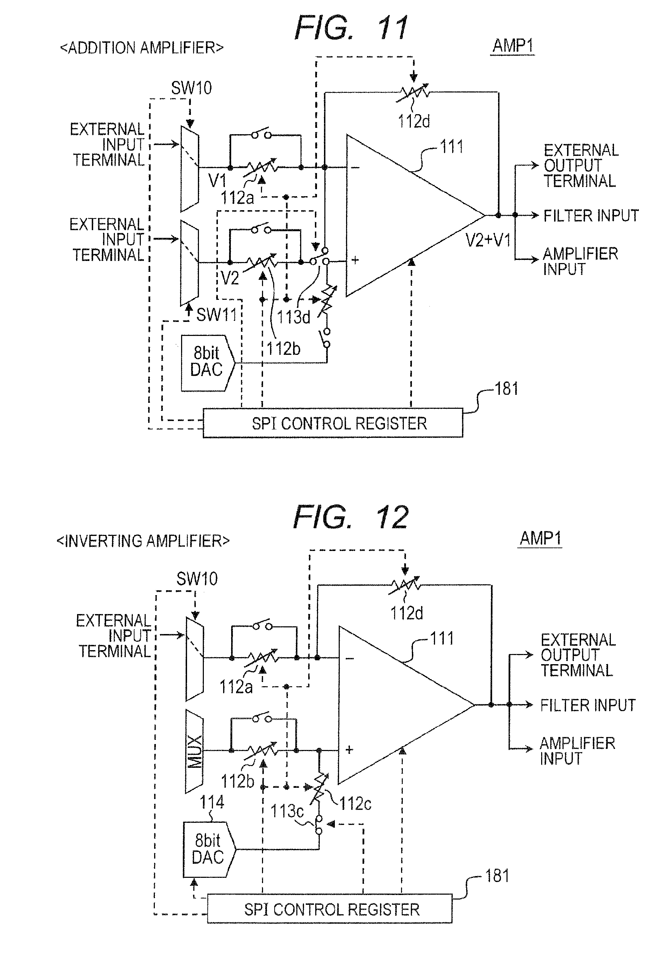

Fig. 11 is a diagram showing an example of the configuration of an addition amplifier. Here, it will be assumed that this circuit includes a switch 113d between the variable resistor 112b and the inverting input terminal. In accordance with the configuration values of the register 181, external input terminal MPXIN10 and external input terminal MPXIN20 are coupled to the inverting input terminal by switching multiplexers SW10, SW11, and the switch 113d. This coupling shown in Fig. 11 makes it possible to configure an addition amplifier. In addition, by modifying the resistor values of the variable resistors 112a, 112b, and 112d in accordance with the configuration values of the register 181, the gain of the amplifier is configured. When two signals (V1, V2) are input into this addition amplifier from the external input terminals, this addition amplifier outputs a sum obtained by adding one input voltage V1 to the other input voltage V2, that is, a voltage (V1 + V2).

Fig. 12 is a diagram showing an example of the configuration of an inverting amplifier. In accordance with the configuration values of the register 181, external terminal MPXIN10 is coupled to the inverting input terminal by switching multiplexer SW10, and the output of the DAC 114 is coupled to the noninverting terminal by turning the switch 113c on. This coupling shown in Fig. 12 makes it possible to configure an inverting amplifier. In addition, by modifying the resistor values of the variable resistors 112a and 112d in accordance with the configuration values of the register 181, the gain of the amplifier is configured, and by modifying the output voltage of the DAC in accordance with the configuration values of the register 181, the operation point and offset of the amplifier are adjusted. When the signal of a voltage-type sensor is input into this inverting amplifier from the external input terminal, this amplifier inverts and amplifies the input voltage, and outputs the resultant voltage.

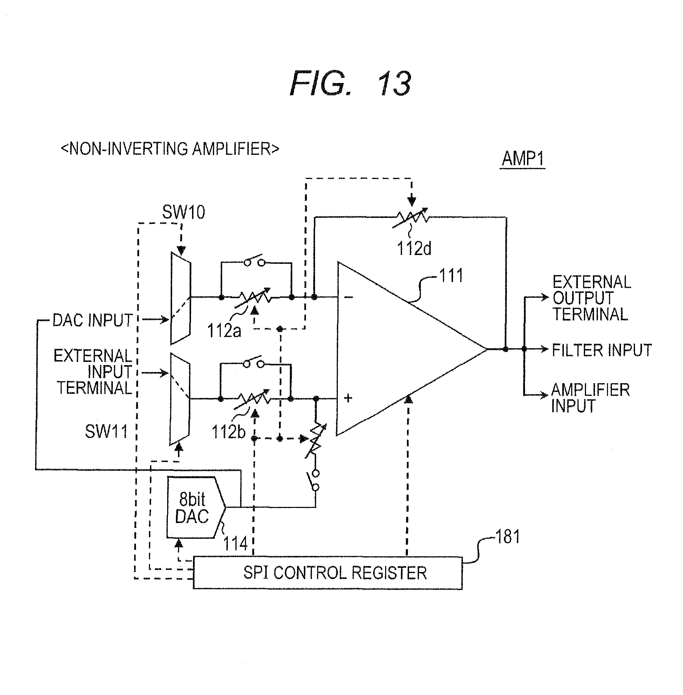

Fig. 13 is a diagram showing an example of the configuration of a noninverting amplifier. In accordance with the configuration values of the register 181, the output of the DAC 114 is coupled to the inverting input terminal by switching multiplexer SW10, and external input terminal MPXIN20 is coupled to the noninverting terminal by switching multiplexer SW11. This coupling shown in Fig. 13 makes it possible to configure a noninverting amplifier. In addition, by modifying the resistor values of the variable resistors 112a and 112d in accordance with the configuration values of the register 181, the gain of the amplifier is configured, and by modifying the output voltage of the DAC in accordance with the configuration values of the register 181, the operation point and offset of the amplifier are adjusted. When the signal of a voltage-type sensor is input into this noninverting amplifier from the external input terminal, this amplifier noninvertingly amplifies the input voltage, and outputs the resultant voltage (that has the same phase as the phase of the input voltage).

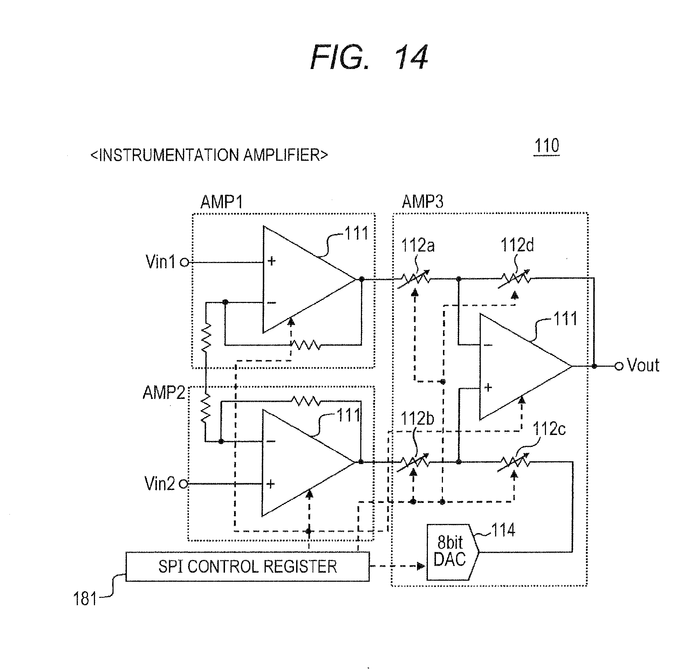

Fig. 14 is a diagram showing an example of the configuration of an instrumentation amplifier including amplifiers AMP1 to AMP3. As described in Fig. 5, by coupling AMP1 to AMP3 with the use of multiplexers (switches) SW10 to SW15 in accordance with the configuration values of the register 181, the instrumentation amplifier shown in Fig. 14 can be configured. In addition, although the switches are not shown, the variable resistor 112b is shorted by turning the switch 113b on in AMP1, the variable resistor 112b is shorted by turning the switch 113b on in AMP2, and the DAC 114 is coupled to the noninverting input terminal by turning the switch 113c on in AMP3.

In addition, by modifying the resistor values of the variable resistors 112a and 112d in amplifier AMP3 in accordance with the configuration values of the register 181, the gain of the instrumentation amplifier is configured, and by modifying the output voltage of the DAC 114 in accordance with the configuration values of the register 181, the operation point and offset of the instrumentation amplifier are adjusted. When two signals that have a weak difference from each other is input into this instrumentation amplifier from two external input terminals, AMP1 and AMP2 respectively and noninvertingly amplify these signals, and then AMP3 differentially amplifies the signals noninvertingly amplified by AMP1 and AMP2, and outputs the resultant voltage.

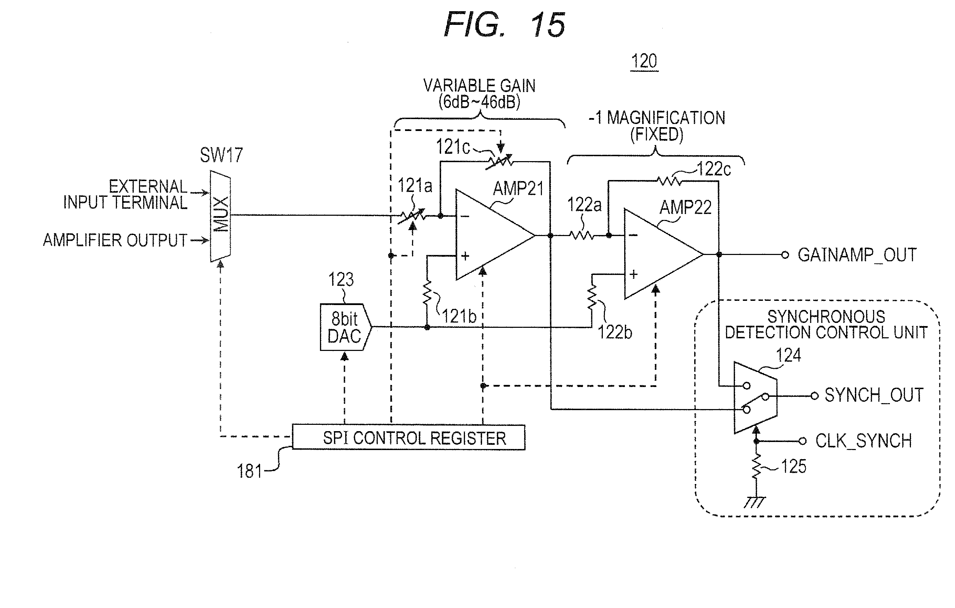

Next, the concrete circuitries of other circuits in the AFE unit 100 will be described with reference to Fig. 15 to Fig. 20.

Fig. 15 is a diagram showing the circuitry of the gain amplifier 120. The gain amplifier 120 is compliant with a synchronous detection function, and executes amplifying and synchronous detection on input signals. As one of modifications of the characteristics of the gain amplifier 120, the gain amplifier 120 can be configured so that its gain is variable. For example, it can be configured for the gain to be variable within 6 dB to 46 dB by 2 dB. In addition, the on-off operation of the power supply of the gain amplifier can be switched when the gain amplifier is in the power-off mode.

As shown in Fig. 15, the gain amplifier 120 includes operational amplifiers AMP21 and AMP22, and the gain amplifier 120 further includes variable resistors 121a, 121c, fixed resistors 121b, 122a, 122b, 122c, and a DAC 123 that are all respectively coupled to the input or output terminals of operational amplifiers AMP21 and AMP22. In addition, as shown in Fig. 3, multiplexer (switch) SW17 is coupled to the gain amplifier 120. In addition, the gain amplifier 120 includes a synchronous detection switch 124 and a fixed resistor 125 as a synchronous detection control unit.

In accordance with the configuration values of the register 181, multiplexer SW17 is controlled to switch the input to the gain amplifier 120. In addition, by modifying the resistor values of the variable resistors 121a and 121c, and the configuration of the DAC 123 in accordance with the configuration values of the register 181, the gain of AMP21, the operation points, the offsets, and the like of AMP21 and AMP22 can be changed. In addition, the on-off operations of the power supplies to operational amplifiers AMP21 and AMP22 can be controlled in accordance with the configuration values of the register 181.

In the gain amplifier 120, a signal input from AMP1 to AMP3, or from the external terminal is invertingly amplified by AMP21, and further invertingly amplified by AMP22. Subsequently, the signal is output to terminal GAINAMP_OUT.

In addition, synchronous clock CLK_SYNCH is input from the MCU unit 200, and the coupling of the synchronous detection switch 124 is switched at the timing of synchronous clock CLK_SYNCH, hence either one of the output signal of AMP21 and the output signal of AMP22 is output to terminal SYNCH_OUT.

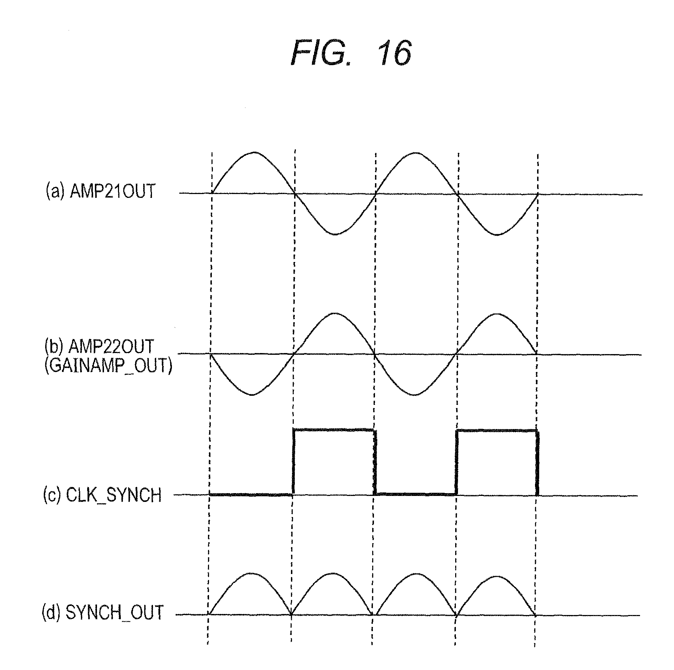

Figs. 16A to 16D show a timing chart showing the output operation of the gain amplifier 120. As shown in Fig. 16A, AMP21 outputs the inversion signal of the input signal, and as shown in Fig. 16B, AMP 22 outputs the inversion signal of the signal sent from AMP21. This output signal of AMP22 is output to terminal GAINAMP_OUT as an output from the gain amplifier 120.

The MCU unit 200 is coupled to terminal GAINAMP_OUT, and generates a clock in synchronization with the signal output from terminal GAINAMP_OUT. In this case, as shown in Fig. 16C, the MCU unit 200 generates CLK_SYNCH whose level becomes high when the signal output from terminal GAINAMP_OUT is higher than a standard value. Subsequently, this synchronous clock CLK_SYNCH is supplied to the gain amplifier 120.

The synchronous detection switch 124 switches between the coupling of AMP21 to terminal SYNCH_OUT and the coupling of AMP22 to terminal SYNCH_OUT in synchronization with synchronous clock CLK_SYNCH. To put it concretely, when the level of clock CLK_SYNCH is low, AMP21 is coupled to terminal SYNCH_OUT, and the output of AMP21 is sent to terminal SYNCH_OUT, and when the level of clock CLK_SYNCH is high, AMP22 is coupled to terminal SYNCH_OUT, and the output of AMP22 is sent to terminal SYNCH_OUT. As a result, as shown in Fig. 16D, a synchronous detection is executed, and a full-wave rectified signal is output from terminal SYNCH_OUT.

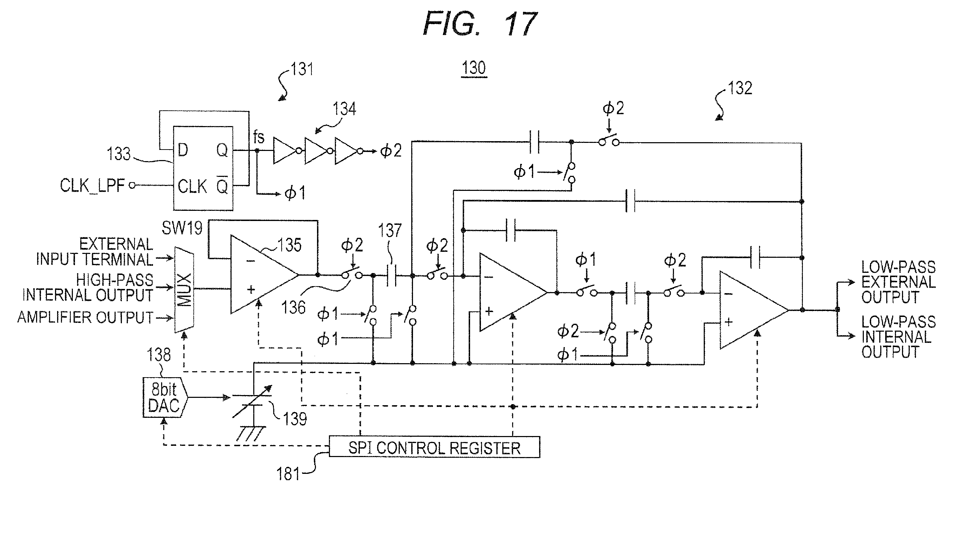

Fig. 17 is a diagram showing the circuitry of the low-pass filter 130. The low-pass filter 130 is an SC (Switched Capacitor) type low-pass filter with a variable cutoff frequency, and is used for filtering input signals.

The low-pass filter 130 has a fixed Q value, for example, 0.702. As one of the modifications of the characteristics of the low-pass filter 130, the cutoff frequency can be configured to be variable. For example, the cutoff frequency can be configured to be a frequency within 9 Hz to 900 Hz. In addition, the on-off operation of the power supply of the low-pass filter can be switched when the low-pass filter is in the power-off mode.

As shown in Fig. 17, the low-pass filter 130 includes a switching signal generation unit 131 that generates a switching signal, and a filter unit 132 that filters an input signal in accordance with the switching signal.

The switching signal generation unit 131 includes a flip-flop 133 and plural inverters 134. The filter unit 132 includes plural operational amplifiers 135, plural switches 136 that are coupled to the operational amplifiers 135, plural condensers 137, and a variable voltage source 139 that is controlled by a DAC 138. In addition, as shown in Fig. 3, multiplexer (switch) SW19 is coupled to the low-pass filter 130.

In accordance with the configuration values of the register 181, multiplexer SW19 is controlled for switching the input to the low-pass filter 130. In addition, by modifying the configuration of the DAC 138 in accordance with the configuration values of the register 181, the variable voltage source 139 is controlled so that the operation points, the offsets, and the like of the operational amplifiers can be changed. In addition, in accordance with the configuration values of the register 181, the on-off operation of the power supply of the low-pass filter 130 can be switched.

In the low-pass filter 130, clock CLK_LPF is input to the switching signal generation unit 131 from the outside, and switching signals Φ1 and Φ2 are generated by the flip-flop 133 and the inverter 134. In the filter unit 132, when a signal is input from an external terminal, the gain amplifier 120, or the like, the signal is output via the three operational amplifiers 135. On this occasion, the switching signals Φ1 and Φ2 turn the switches 136 on-off, so that the couplings of the condensers 137 are switched. As a result, the signal output via the three operational amplifiers becomes a signal whose frequency components higher than the cutoff frequency are removed, and the signal is output.

This cutoff frequency can be modified with the use of clock CLK_LPF sent from the outside by the MCU unit 200. To put it concretely, the cutoff frequency fc = 0.009xfCLK_LPF/2.

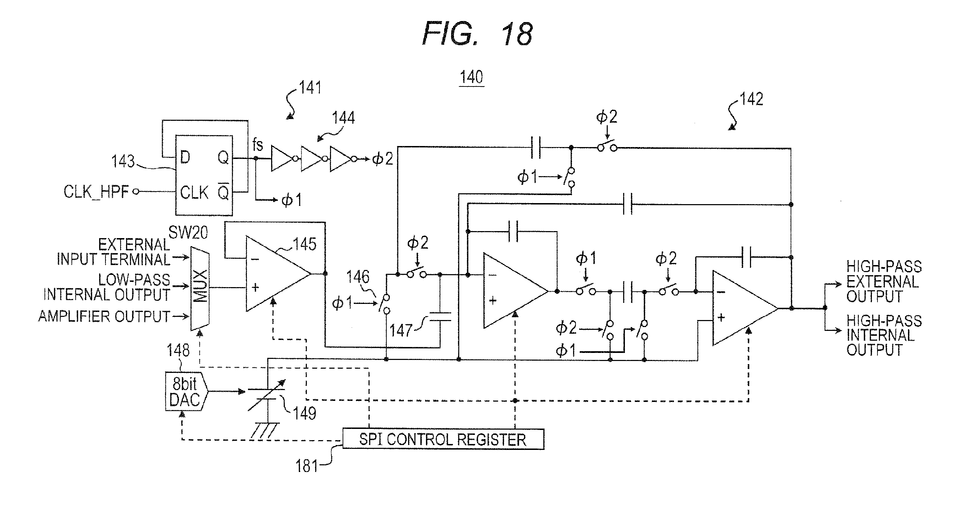

Fig. 18 is a diagram showing the circuitry of the high-pass filter 140. The high-pass filter 140 is an SC type high-pass filter whose cutoff frequency is variable, and is used for filtering input signals.

The high-pass filter 140 has a fixed Q value, for example, 0.702. As one of the modifications of the characteristics of the high-pass filter, the cutoff frequency can be configured to be variable. For example, the cutoff frequency can be configured to be a frequency within 8 Hz to 800 Hz. In addition, the on-off operation of the power supply of the high-pass filter can be switched when the high-pass filter is in the power-off mode.

As shown in Fig. 18, the high-pass filter 140 includes a switching signal generation unit 141 that generates a switching signal, and a filter unit 142 that filters an input signal in accordance with the switching signal.

The switching signal generation unit 141 includes a flip-flop 143 and plural inverters 144. The filter unit 142 includes plural operational amplifiers 145, plural switches 146 that are coupled to the operational amplifiers 145, plural condensers 147, and a variable voltage source 149 that is controlled by a DAC 148. In addition, as shown in Fig. 3, multiplexer (switch) SW20 is coupled to the high-pass filter 140.

In accordance with the configuration values of the register 181, multiplexer SW20 is controlled for switching the input to the high-pass filter 140. In addition, by modifying the configuration of the DAC 148 in accordance with the configuration values of the register 181, the variable voltage source 149 is controlled so that the operation points, the offsets, and the like of the operational amplifiers can be changed. In addition, in accordance with the configuration values of the register 181, the on-off operation of the power supply of the high-pass filter 140 can be switched.

In the high-pass filter 140, clock CLK_HPF is input to the switching signal generation unit 141 from the outside, and switching signals Φ1 and Φ2 are generated by the flip-flop 143 and the inverter 144. In the filter unit 142, when a signal is input from an external terminal, the gain amplifier 120, or the like, the signal is output via the three operational amplifiers 145. On this occasion, the switching signals Φ1 and Φ2 turn the switch 146 on-off, so that the couplings of the condensers 147 are switched. As a result, the signal output via the three operational amplifiers becomes a signal whose frequency components lower than the cutoff frequency are removed.

This cutoff frequency can be modified with the use of clock CLK_HPF sent from the outside by the MCU unit 200. To put it concretely, the cutoff frequency fc = 0.008×fCLK_HPF/2.

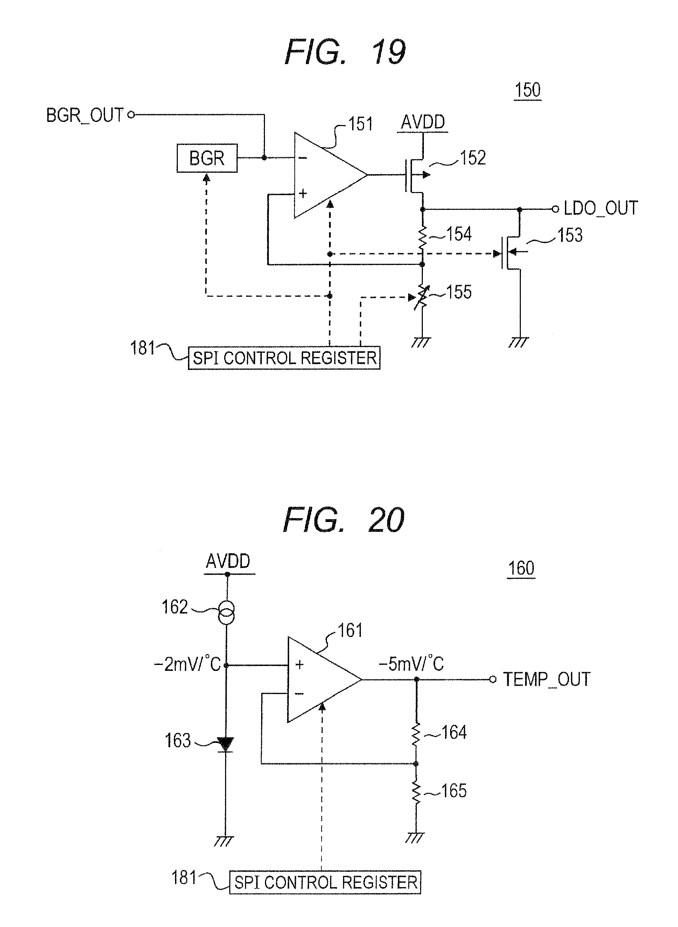

Fig. 19 is a diagram showing the circuitry of the variable regulator 150. The variable regulator 150 is a regulator that can output a variable output voltage, and it is a reference power supply generation circuit for the A/D converter 260 of the MCU unit 200. As one example of modifications of the characteristics of the variable regulator 150, the output voltage of the variable regulator 150 can be configured to be variable within 2.0 V and 3.3 V by 0.1 V with accuracy of 0.5%. In addition, the output current is 15 mA, and the on-off operation of the output power supply can be controlled.

As shown in Fig. 19, the variable regulator 150 includes an operational amplifier 151, and further includes band gap reference BGR that is coupled to the input side of the operational amplifier 151, transistors 152 and 153 that are coupled to the output side of the operational amplifier 151, a fixed resistor 154, and a variable resistor 155.

In accordance with the configuration values of the register 181, the voltage of BGR is configured and the resistor value of the variable resistor 155 is modified, so that the output voltage of the variable regulator 150 can be modified. In addition, in accordance with the configuration values of the register 181, the on-off operation of the operational amplifier 151 and the on-off operation of the transistor 153 are switched, so that the output start/stop operation of the output voltage is controlled.

In the variable regulator 150, the voltage of BGR is output from terminal BGR_OUT. In accordance with the voltage of BGR and the voltage of the variable resistor 155, the operational amplifier 151 operates and the transistor 152 is controlled, so that the voltage is output in accordance with the ratio of the fixed resistor 154 to the variable resistor 155.

Fig. 20 is a diagram showing the circuitry of the temperature sensor 160. The temperature sensor 160 is a sensor for measuring the temperature of the semiconductor device 1, and the MCU unit 200 uses this measurement result for performing correction and the like for the temperature characteristic of the semiconductor device. For example, as one of the temperature characteristics of the temperature sensor 160, the output temperature coefficient is -5 mV/°C. In addition, the on-off operation of the power supply can be switched when the temperature sensor is in the power-off mode.

As shown in Fig. 20, the temperature sensor 160 includes an operational amplifier 161, and further includes a current source 162 and a diode 163 that are coupled to the input side of the operational amplifier 161, and fixed resistors 164 and 165 that are coupled to the output side of the operational amplifier 161. In accordance with the configuration values of the register 181, the on-off operation of the power supply of the operational amplifier 161 can be switched.

In the temperature sensor 160, the voltage of the diode 163 varies at the rate of -2 mV/°C, and this voltage is noninvertingly amplified by the operational amplifier 161, so that the voltage output from the operational amplifier 161 varies at the rate of -5 mV/°C.

As described above, the semiconductor device 1 of TYPE0 includes the AFE unit 100 whose circuitry and characteristics can be configured to be variable. Therefore, only one type of semiconductor device such as the semiconductor device 1 of TYPE0 can be coupled to various sensors and the like, which leads to various usages in many application systems.

For example, if the circuitry of the configurable amplifier 110 is made to be that of a noninverting amplifier, a voltage output type sensor can be coupled to the semiconductor device 1, therefore the semiconductor device 1 can be used for application systems that employ infrared sensors, temperature sensors, magnetic sensors, or the like. As some examples, it is conceivable that the semiconductor device 1 is used for a digital camera including an infrared sensor, a printer including a temperature sensor, a tablet terminal including a magnetic sensor, an air conditioner including an infrared sensor, or the like.

In addition, if the circuitry of the configurable amplifier 110 is made to be that of an instrumentation amplifier, because a sensor having a weak differential output can be coupled to the semiconductor device 1, the semiconductor device 1 can be used for application systems employing stress sensors, gyro sensors, shock sensors, or the like. As some examples, it is conceivable that the semiconductor device 1 is used for a blood-pressure monitor including a pressure sensor, a bathroom scale including a stress sensor, a cellular phone including a gyro sensor, a liquid crystal television set including a shock sensor, or the like.

In addition, if the circuitry of the configurable amplifier 110 is made to be that of an I/V amplifier, because a current output type sensor can be coupled to the semiconductor device 1, the semiconductor device 1 can be used for application systems employing photodiodes, human detection sensors, infrared sensors, or the like. As some examples, it is conceivable that the semiconductor device 1 is used for a digital camera including a photodiode, a toilet seat including a human detection sensor, a bar-code reader including an infrared sensor, or the like.

Fig. 21 is a diagram showing a circuit block of the semiconductor device 1 of TYPE1. The semiconductor device 1 of TYPE0 shown in Fig. 2 is configured to be well-adapted to general-purpose systems, so that it includes the AFE circuit that can accept various types of sensors. On the other hand, the semiconductor device 1 of TYPE1 is configured to be well-adapted to common measuring instruments, and includes an AFE circuit that is necessary for only sensors mounted on the common measuring instruments.

As shown in Fig. 21, the semiconductor device 1 of TYPE1 includes an MCU unit 200 the circuitry of which is the same as that of the MCU unit shown in Fig. 2, and an AFE unit 100 that includes an instrumentation amplifier 190, a variable regulator 150, a temperature sensor 160, and an SPI interface 180. In comparison with the semiconductor device 1 shown in Fig. 2, the semiconductor device 1 of TYPE1 does not include a configurable amplifier, a synchronous detection compliant gain amplifier, an SC type low-pass filter, an SC type high-pass filter, a general-purpose amplifier, and includes only an instrumentation amplifier instead. As for the variable regulator 150, the temperature sensor 160, and the SPI interface 180, they are the same as those shown in Fig. 2.

The instrumentation amplifier 190, which accepts sensors used by the common measurement instruments, is an amplifying circuit capable of amplifying weak differential signals. The instrumentation circuit 190 is a circuit that is similar to that of the instrumentation amplifier supplied by the configurable amplifier 110 shown in Fig. 2. The circuitry of the instrumentation circuit 190 is fixed, and only the characteristics of the instrumentation circuit 190 can be modified.

Fig. 22 is a diagram showing the coupling relation among circuits in the AFE unit 100 of the semiconductor device 1 of TYPE1. The variable regulator 150, the temperature sensor 160, and the SPI interface 180 are the same as those shown in Fig. 3.

Because the circuitry of the instrumentation amplifier 190 is fixed, the instrumentation amplifier 190 does not include a switch (multiplexer) used for switching the circuitry. One input terminal of the instrumentation amplifier 190 is coupled to terminal AMP_IN1, the other is coupled to terminal AMP_IN2, and the output terminal of the instrumentation amplifier 190 is coupled to terminal AMP_OUT. In addition, it is conceivable that the instrumentation amplifier 190 includes switches for selecting from plural couplings to external terminals.

Description about the concrete circuitries of the circuits of the AFE unit 100 of the semiconductor device of TYPE1 will be omitted because they are the same as those of the semiconductor device of TYPE0 shown in Fig. 2. In other words, the circuitry of the instrumentation amplifier 190 is the same as that shown in Fig. 14, and, as shown in Fig. 14, the gain of the instrumentation amplifier 190 can be configured by modifying resistor values, and the operation point and offset of the instrumentation amplifier 190 can be changed by modifying the configuration of a DAC.

As described above, because the circuitry of the AFE unit 100 of the semiconductor device 1 of TYPE1 is fixed, only the characteristics of the AFE unit 100 can be configured to be modifiable. Therefore, only one type of semiconductor device such as the semiconductor device 1 of TYPE1 can be used for a specific sensor with various characteristics, which leads to various usages in specific application systems.

For example, as is the case with the instrumentation amplifier configured in the semiconductor device of TYPE0, the semiconductor device of TYPE1 can be used for application systems employing stress sensors, gyro sensors, shock sensors, or the like that output weak differential outputs.

Fig. 23 shows a circuit block diagram of the semiconductor device 1 of TYPE2. The semiconductor device 1 of TYPE0 shown in Fig. 2 is configured to be well-adapted to general-purpose systems, and includes the AFE circuit that can accept various types of sensors. On the other hand, the semiconductor device 1 of TYPE2 is configured to be well-adapted to motor control, and includes an AFE circuit that is necessary only for motor control.

As shown in Fig. 23, the semiconductor device 1 of TYPE2 includes an MCU unit 200 the circuitry of which is the same as that of the MCU unit shown in Fig. 2, and an AFE unit 100 that includes comparator-embedded high-speed instrumentation amplifiers 191, a temperature sensor 160, and an SPI interface 180. In comparison with the semiconductor device shown in Fig. 2, the semiconductor device 1 of TYPE2 does not include a configurable amplifier, a synchronous detection compliant gain amplifier, an SC type low-pass filter, an SC type high-pass filter, a general-purpose amplifier, a variable regulator, and includes only the comparator-embedded high-speed instrumentation amplifiers 191 instead. As for the temperature sensor 160, and the SPI interface 180, they are the same as those shown in Fig. 2.

The comparator-embedded high-speed instrumentation amplifiers (also referred to as the high-speed instrumentation amplifiers for short) 191 can be used for motor control, and are amplifying circuits capable of high-speedily amplifying weak differential signals, and further includes comparators for comparing output voltages. The AFE unit 100 includes plural high-speed instrumentation amplifiers (a multichannel high-speed instrumentation amplifier) 191 so as to make it possible to control a polyphase motor. In this case, it will be assumed that the AFE unit 100 includes four high-speed instrumentation amplifiers (a four-channel high-speed instrumentation amplifier). The circuitry of the high-speed instrumentation circuit 191 is fixed, and only the characteristics of the instrumentation circuit 191 can be modified.

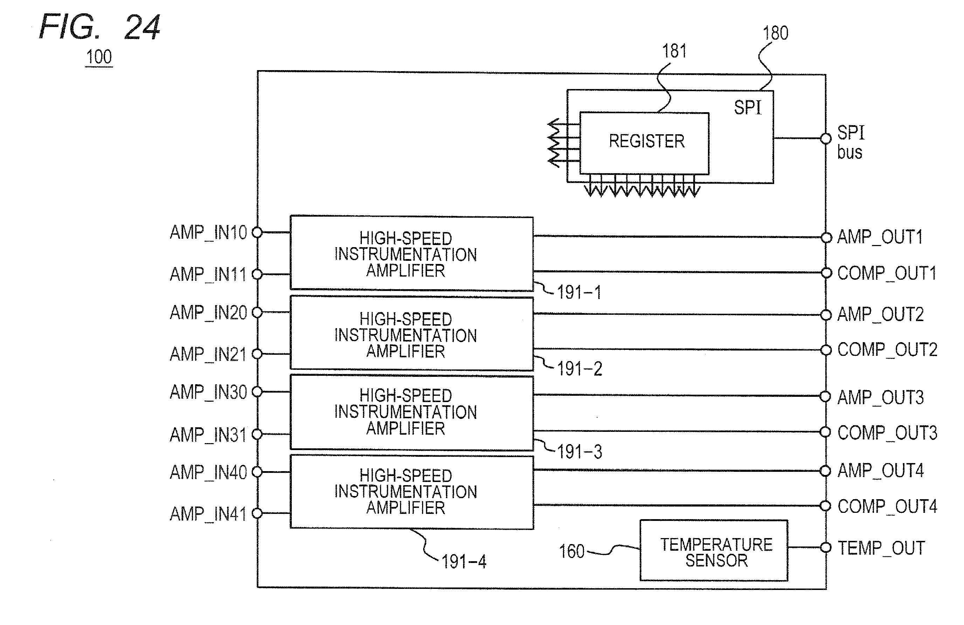

Fig. 24 is a diagram showing the coupling relation among circuits in the AFE unit 100 of the semiconductor device 1 of TYPE2. The temperature sensor 160 and the SPI interface 180 are the same as those shown in Fig. 3.

Because the circuitry of the high-speed instrumentation amplifier 191 is fixed, the instrumentation amplifier 191 does not include a switch (multiplexer) used for switching the circuitry. The circuitries of four high-speed instrumentation amplifiers 191-1 to 191-4 are respectively independent of each other.

In other words, one input terminal of each of the high-speed instrumentation amplifiers 191-1 to 191-4 is coupled to the corresponding terminal among terminals AMP_IN10, AMP_IN20, AMP_IN30, and AMP_IN40, the other input terminal of each of the high-speed instrumentation amplifiers is coupled to the corresponding terminal among terminals AMP_IN11, AMP_IN21, AMP_IN31, and AMP_IN41, the output terminal of each of the high-speed instrumentation amplifiers is coupled to the corresponding terminal among terminals AMP_OUT1, AMP_OUT2, AMP_OUT3, and AMP_OUT4, and the output terminal of each of the comparators is coupled to corresponding terminal among terminals COMP_OUT1, COMP_OUT2, COMP_OUT3, and COMP_OUT4. In addition, it is conceivable that the instrumentation amplifier 190 includes switches for selecting from plural couplings to external terminals.

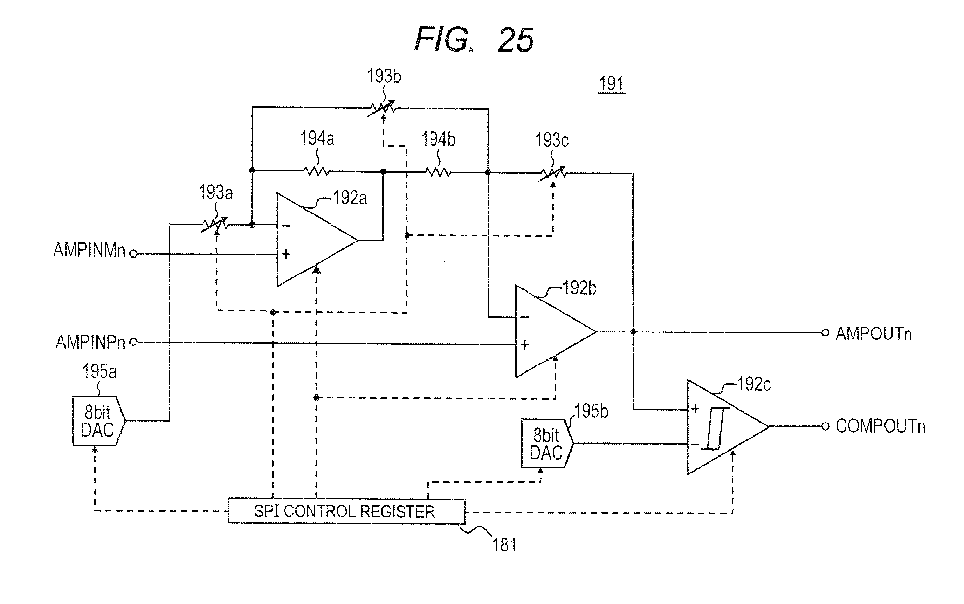

Fig. 25 is a diagram showing the concrete circuitry of the high-speed instrumentation amplifier 191. The high-speed instrumentation amplifier 191 is a comparator-embedded high-speed instrumentation amplifier well-adapted to motor control, and amplifies the output signal of a sensor used for the motor control and executes voltage comparison. As one of the modifications of the characteristics of the high-speed instrumentation amplifier 191, the gain can be configured to be variable. For example, the gain can be configured to be variable within 10 dB to 34 dB by 2 dB. In addition, the through rate of the high-speed instrumentation amplifier 191 can be configured to be variable, and the on-off operation of the power supply of the high-speed instrumentation amplifier 191 can be switched when the high-speed instrumentation amplifier 119 is in the power-off mode.

In addition, the high-speed instrumentation amplifier 191 embeds the comparator used for comparing the output of the high-speed instrumentation amplifier, and this comparator is configured so that the hysteresis voltage and the reference voltage of the comparator are variable.

As shown in Fig. 25, the high-speed instrumentation amplifier 191 includes operational amplifiers 192a and 192b that operate in unison as an instrumentation amplifier, an operational amplifier 192c that operates as a hysteresis comparator, and further includes variable resistors 193a to 193c that are coupled to the operational amplifiers 192a to 192c, fixed resistors 194a and 194b, and DACs 195a and 195b.

By modifying the resistor values of the variable resistors 193a to 193c and the configuration of the DAC 195a in accordance with configuration values of a register 181, the gain, the operation point, and the offset of the high-speed instrumentation amplifier 119 can be changed. In addition, in accordance with the configuration of the DAC 195b, the reference voltage of the comparator can be changed. In addition, in accordance with the configuration values of the register 181, the on-off operation of the power supply to the operational amplifiers 192a to 192c can be controlled.

In the high-speed instrumentation amplifier 119, when a differential signal is input via a pair of external input terminals AMPINMn and AMPINPn (corresponding to any of a pair of AMP_IN10 and AMP_IN11 to a pair of AMP_IN40 and AMP_IN41 in this case), the differential signal is speedily and noninvertingly amplified by the instrumentation amplifier including two operational amplifiers 192a and 192b, and the amplified signal is output to terminal AMPOUTn (corresponding to any of AMP_OUT1 to AMP_OUT4). In addition, the output signal output to terminal AMPOUTn is compared with the reference voltage by the hysteresis comparator including the operational amplifier 192c, and the resultant signal is output as a comparison signal. Here, the MCU unit 200 performs motor control in accordance with the signals output from terminals AMPOUTn and COMPOUTn.

As described above, because the circuitry of the AFE unit 100 of the semiconductor device 1 of TYPE2 is fixed, only the characteristics of the AFE unit 100 can be configured to be modifiable. Therefore, only one type of semiconductor device such as the semiconductor device 1 of TYPE2 can be used for a specific sensor with various characteristics, which leads to various usages in specific application systems. Particularly, the semiconductor device 1 of TYPE2 can be coupled to a drive circuit for a polyphase motor.

With the use of any of the above described semiconductor devices 1, the following advantageous effects can be brought about. First, the downsizing of the semiconductor device 1 and reducing power consumed by the semiconductor device 1 can be achieved. Because the circuits of the MCU unit and the AFE unit are included in the semiconductor device 1, the downsizing of the semiconductor device can be achieved compared with a device that includes plural analog circuit ICs mounted on mounting boards. In addition, toward the request for a low power consumption mode, the power supply of the AFE unit can be configured to be turned off, and the MCU unit can be configured to be put into a sleep mode, which leads to reducing the power consumed by the semiconductor device.

In addition, the development processes of an analog IC can be shortened. To put it concretely, it usually takes three to eight months to develop an analog IC well-adapted to a sensor because several processes, such as a circuit design, a mask design, mask manufacturing, and sample manufacturing, are needed. In the above described cases, because an analog circuit well-adapted to a sensor can be obtained only by modifying the configuration of the semiconductor device 1, the development of a semiconductor device including the desired analog circuit can be completed without development processes from circuit design to sample manufacturing. Therefore, the development of a sensor system can be completed in a short period, and the system can be brought to market quickly and timely.

In addition, one semiconductor device 1 can accept plural application systems. Because the circuitry of the semiconductor device 1 can be freely modified, the semiconductor device 1 can be coupled to various sensors such as a current type sensor and a voltage type sensor. As a result, because it is not necessary to develop a semiconductor device dedicated to each of the various sensors, a period needed for developing a semiconductor device well-adapted to a sensor can be shortened.

In addition, as described above, the semiconductor device 1 of TYPE1 is configured to be well-adapted to common measuring instruments, and includes only instrumentation amplifiers and the like necessary for common measuring instruments, and the semiconductor device 1 of TYPE2 is configured to be well-adapted to motor control, and includes only high-speed instrumentation amplifiers and the like necessary for motor control. Therefore, because both semiconductor device 1 of TYPE1 and semiconductor device 1 of TYPE2 do not include redundant circuits, their circuitries become simple, so that the downsizing of the semiconductor devices can be achieved and reducing the power consumed by the semiconductor devices can also be achieved.

In the above described semiconductor device 1, because it is necessary to determine the configuration and the characteristics of the AFE unit 100 in accordance with a sensor to be coupled to the semiconductor device 1, a simulation is executed on the operations of the sensor and the semiconductor device 1 during the design development of a sensor system that uses the sensor and the semiconductor device 1. A simulation executed during the development process of a sensor system including a sensor and a semiconductor device 1 will be described hereinafter. In this case, although the description will be made mainly using a semiconductor device including only an AFE unit 100 as a simulation object, a simulation can also be executed on a semiconductor device 1 including both the AFE unit 100 and an MCU unit 200.

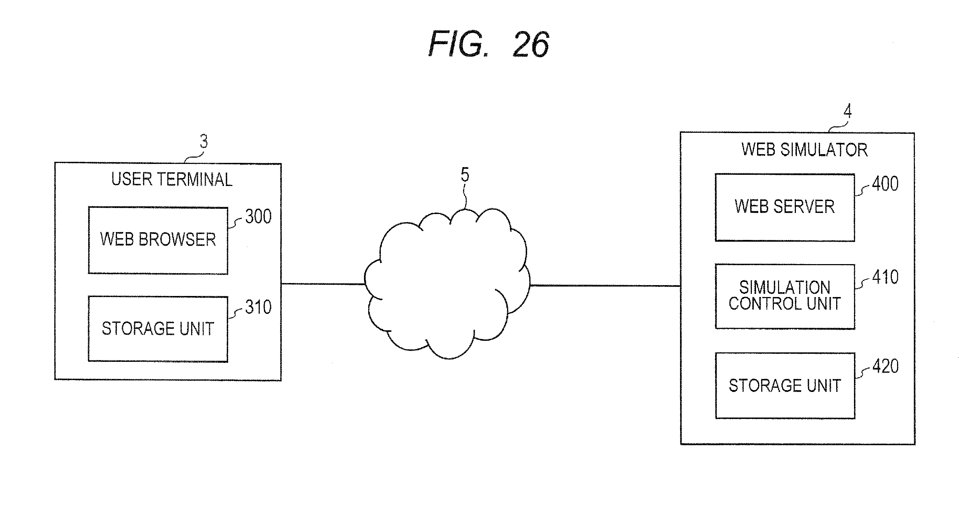

Fig. 26 is a diagram showing the configuration of a simulation system (design support system) for simulating the operation of a semiconductor device 1 according to this embodiment.

As shown in Fig. 26, this simulation system includes a user terminal 3 and a web simulator 4 both of which are coupled so as to communicate with each other via a network 5. The user terminal 3 mainly includes a web browser 300 and a storage unit 310. The web simulator 4 mainly includes a web server 400, a simulation control unit 410, and a storage unit 420.

The network 5 is, for example, the Internet, and is a network via which the user terminal 3 and the web simulator 4 can transmit web page information therebetween. The network 5 can be either a wired network or a wireless network.

The web browser 300 of the user terminal 3 displays a web page on a display device on the basis of the web-page information received from the web server 400. The web browser 300 is also a user interface that receives an operation sent from a user, and accesses the web server 400 in accordance with the user operation so as to cause the web simulator 4 to execute simulation.

The storage unit 310 of the user terminal 3 stores various data, programs, and the like that are used for materialize the functions of the user terminal 3. In addition, as described later, the storage unit 310 downloads and stores register information from the web simulator 4. The register information is set in registers 181 of semiconductor devices 1.

The web server 400 of the web simulator 4 is a server that provides web services of the web simulator 4 to the web browser 300. The web server 400 receives an access from the web browser 300, and sends web information to be displayed on the web browser 300 in accordance with the access.

The simulation control unit 410 of the web simulator 4 materializes a simulation function executed on sensors and the semiconductor devices 1. As described later, the web simulator 4 configures the circuitries of a sensor and a semiconductor device 1 that are simulation targets, and sets parameters necessary for a simulation, and executes the simulation.

The storage unit 420 of the web simulator 4 stores various data, programs, and the like that are used to materialize the functions of the web simulator 4. As described later, the storage unit 420 stores information about selectable sensors, information about bias circuits suitable for the sensors, information about analog circuits suitable for the sensors and the bias circuits, and the like.

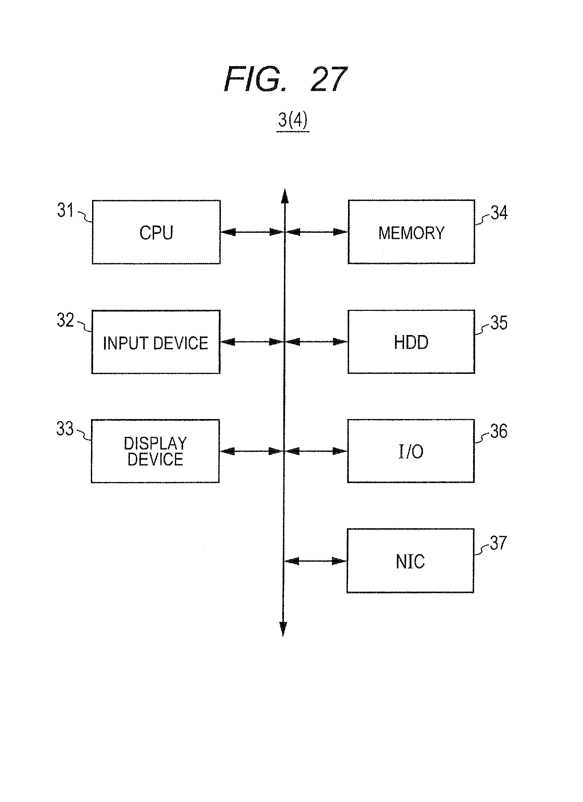

The user terminal 3 is a computer device such as a personal computer that operates as a client device, and the web simulator 4 is a computer device such as a workstation that operates as a server device. Fig. 27 is a diagram showing an example of a hardware configuration for materializing the user terminal 3 or the web simulator 4. In addition, the user terminal 3 or the web simulator 4 can be configured not only by a single computer but also by plural computers.

As shown in Fig. 27, the user terminal 3 or the web simulator 4 is a common computer device, and includes a central processing unit (CPU) 31 and a memory 34. The CPU 31 and the memory 34 are coupled to a hard disk device (HDD) 35 that works as an auxiliary storage device via a bus. The user terminal 3 includes, as user interface hardware, for example, a pointing device (a mouse, a joystick, or the like) used for a user to perform input operations, an input device 32 such as a keyboard, a display device 33 such as a CRT or a liquid crystal display for providing visual data such as GUIs to a user. It is conceivable that the web simulator 4 also includes user interface hardware as is the case with the user terminal 3.

The storage media such as the HDD 35 and the like can store a browser program and a simulation program that issue instructions to the CPU 31 and the like, and execute the functions of the user terminal 3 and the web simulator 4 in cooperation with an operating system. These programs are executed after they are loaded into the memory 34.

In addition, the user terminal 3 or the web simulator 4 includes an input/output (I/O) interface 36 and a NIC (Network Interface Card) 37 used for the user terminal 3 or the web simulator 4 to be coupled to external devices. For example, the user terminal 3 includes a USB used for the user terminal 3 to be coupled to the semiconductor devices 1 and the like as the input/output interface 36. The user terminal 3 and the web simulator 4 respectively include the Ethernet (registered trademark) cards as the NICs 37 for the user terminal 3 and the web simulator 4 to be coupled to the network 5.

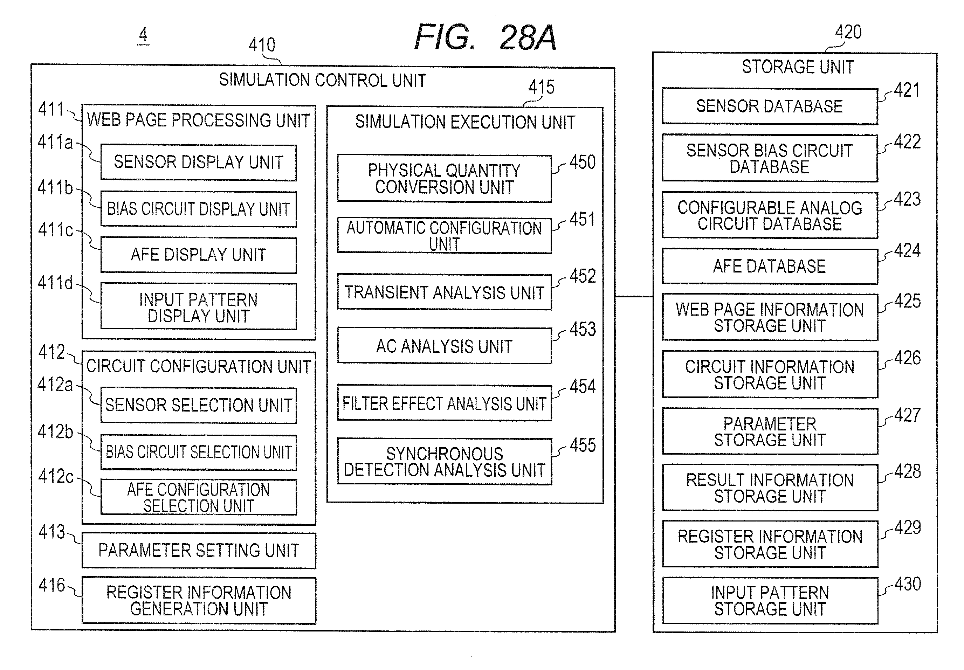

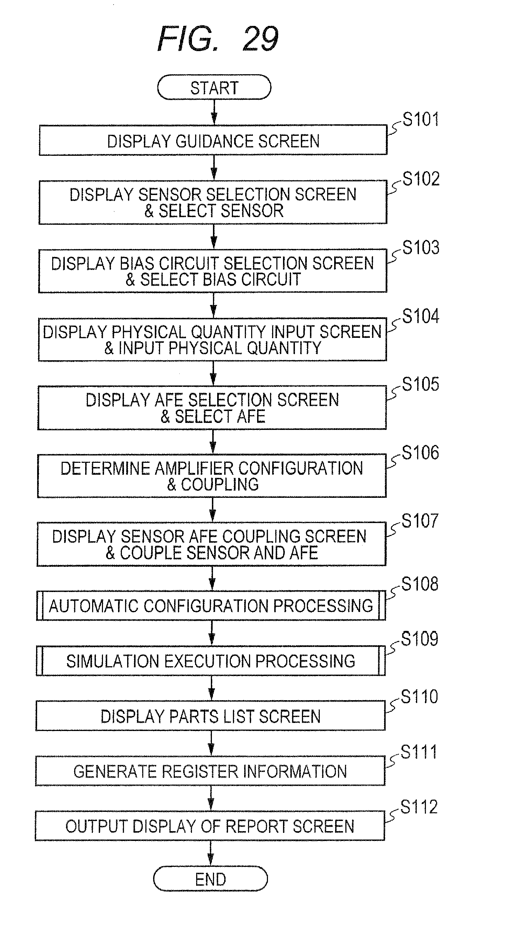

Fig. 28A is a diagram showing functional blocks of the simulation control unit 410 of the web simulator 4, and various data stored in the storage unit 420. Here, the configuration shown by Fig. 28A is an example, and any other configuration will do as long as it can materialize pieces of processing and screen displays shown by Fig. 29 and later.

The simulation control unit 410 materializes the functions of the units in Fig. 28A for a simulation through the corresponding simulation program being executed by the CPU 31. As shown in Fig. 28A, the simulation control unit 410 mainly includes a web page processing unit 411, a circuit configuration unit 412, a parameter setting unit 413, a simulation execution unit 415, and a register information generation unit 416. In addition, the simulation execution unit 415 includes a physical quantity conversion unit (a physical quantity-to-an electric characteristic conversion function) 450, an automatic configuration unit 451, a transient analysis unit 452, an AC analysis unit 453, a filter effect analysis unit 454, and a synchronous detection analysis unit 455.

The storage unit 420 is materialized by the HDD 35 and the memory 34. AS shown in Fig. 28A, the storage unit 420 includes a sensor database 421, a sensor bias circuit database 422, a configurable analog circuit database 423, an AFE database 424, a web page information storage unit 425, a circuit information storage unit 426, a parameter storage unit 427, a result information storage unit 428, a register information storage unit 429, and an input pattern storage unit 430.

The sensor database 421 is a database that stores data sheets of various sensors. The data sheet of a sensor includes information about the type of the sensor, the characteristics of the sensor, and the like. The sensors and their types and characteristics are stored in association with each other in the sensor database 421.

The sensor bias circuit database 422 is a database that stores bias circuits (bias methods) that can be used for various sensors. Information about the bias circuits includes information about elements included in the bias circuits, information about coupling relations among the elements, and information about the output terminals of the bias circuits. The sensor bias circuit database 422 stores individual sensors and the corresponding bias circuits in association with each other.

The configurable analog circuit database 423 is a database that is used for selecting optimal analog circuits for the combinations of sensors and the corresponding sensor bias circuits. Information about the configurable analog circuits includes information about the configuration and input terminals of the configurable amplifier 110 of the semiconductor devices 1. The configurable analog circuit database 423 stores the combinations of the sensors and the corresponding bias circuits, and the configurable amplifiers 110 in association with each other.

The AFE database 424 is a database that stores data sheets of the semiconductor devices 1. The data sheets especially include the circuitries and characteristics of the AFE units 100 for simulating the AFE units 100 of the semiconductor devices 1. The AFE database 424 stores the circuitries of the semiconductor devices 1 and the circuitries of the corresponding AFE units 100 in association with each other. For example, the AFE database 424 stores the data sheets of the above described semiconductor devices 1 of TYPE0 to TYPE2.

The web page information storage unit 425 stores web page information used for displaying various screens on the web browser 300 of the user terminal 3. The web page information is information used for displaying web pages (screens) that includes GUIs used when the semiconductor devices 1 are simulated.

The circuit information storage unit 426 stores circuit information about simulation target circuits. This circuit information includes information about sensors, bias circuits, circuit elements of the AFE units 100, and coupling relations among the elements. The parameter storage unit 427 stores parameters necessary for executing simulations as simulation conditions. These parameters include input information about physical quantities and the like, and circuit parameters and the like.

The result information storage unit 428 stores result information about the results of the simulations. This result information includes input and output waveforms of various circuits of the AFE units 100 obtained as the results of transient analysis simulations, AC analysis simulations, and synchronous detection analysis simulations. The register information storage unit 429 stores register information

(configuration information) that is configured in the registers 181 of the semiconductor devices 1. The input pattern storage unit 439 stores information about plural waveform patterns of signals input to sensors. The input pattern storage unit 439 stores later-described sine waves, square waves, triangular waves, and step responses as input patterns.

The web page processing unit (web page display unit) 411 displays web pages (screens) including GUIs on the web browser 300 by sending the web page information stored in the web page information storage unit 425 to the user terminal 3 via the web server 400. In addition, the web page processing unit (web page display unit) 411 receives input operations made to the GUIs by a user from the user terminal 3.

The web page processing unit 411 includes display units used for displaying various screens. To put it concretely, the web page processing unit 411 includes a sensor display unit 411a, a bias circuit display unit 411b, an AFE display unit 411c, and an input pattern display unit 411d. The sensor display unit 411a displays plural sensors corresponding to the type of a sensor selected by a user with reference to the sensor database 421. The bias circuit display unit 411b displays plural bias circuits corresponding to the selected sensor with reference to the sensor bias circuit database 422. The AFE display unit (semiconductor device display unit) 411c displays plural semiconductor devices 1 each of which includes a configurable amplifier 110 having a configured circuitry with reference to the AFE database 424. The input pattern display unit 411d displays plural waveform patterns stored in the input pattern storage unit 430.

The circuit configuration unit 412 generates circuit information on the basis of an input operation performed by a user on the web page (screen), and stores the information in the circuit information storage unit 426. The circuit configuration unit 412 generates the circuit information in accordance with the selection of a sensor, a bias circuit, and a semiconductor device 1. To put it concretely, the circuit configuration unit 412 includes a sensor selection unit 412a, a bias circuit selection unit 412b, and an AFE configuration selection unit 412c.

The sensor selection unit 412a generates circuit information on the basis of information about a sensor selected by the user operation from among plural sensors that are stored in the sensor database 421 and displayed on the sensor display unit 411a. The sensor circuit selection unit 412b generates circuit information on the basis of information about a bias circuit selected by the user operation from among plural bias circuits that is well-adapted to the selected sensor and displayed on the bias circuit display unit 411b. The AFE configuration selection unit (circuitry configuration unit) 412c generates circuit information by specifying the circuitry and coupling relation of the configurable amplifier 110 well-adapted to the selected sensor and bias circuit with reference to the configurable analog circuit database 423. In addition, the AFE configuration selection unit (semiconductor device selection) 412c generates circuit information on the basis of information about a semiconductor device 1 selected by the user operation from among plural semiconductor devices 1 included in the AFE database 424 and displayed on the AFE display unit 411c.

The parameter configuration unit 413 generates parameters used for executing a simulation on the basis of an input operation on the web page (screen) performed by the user, and stores the parameters in the parameter storage unit 427. The parameter configuration unit (input pattern selection unit) 413 generates information about the input pattern of a physical quantity to be input to the sensor, where the input pattern of the physical quantity is selected by the user operation from among plural waveform patterns that are shown by the input pattern display unit 411d.

The simulation execution unit 415 executes the simulation on the basis of the stored circuit information and parameters with reference to the circuit information storage unit 426 and the parameter storage unit 427.

The physical quantity conversion unit 450 converts a physical quantity that is represented by information input to the sensor into an electric signal output by the sensor. The physical quantity conversion unit 450 generates the output signal of the sensor corresponding to the physical quantity varying in a time-series order in accordance with the configured input pattern of the physical quantity with reference to the parameter storage unit 427.

The automatic configuration unit (circuit characteristic configuration unit) 451 automatically configures the circuit characteristics of the AFE unit 100, and causes the parameter storage unit 427 to store the configured parameters. The automatic configuration unit 451 automatically configures the suitable gain and offset of a configurable amplifier 110 for the configured circuitries of the sensor and the bias circuit, and the configured circuitry of the configurable amplifier 110 with reference to the circuit information storage unit 426. The automatic configuration unit 451 executes a simulation on the operation of the configurable amplifier 110, and adjusts the DAC voltage, gain, and the like of the configurable amplifier 110 so that the gain and offset of the configurable amplifier 110 become optimal.

The transient analysis unit 452 simulates the input and output characteristics of the AFE unit 100 for analyzing the transient characteristics, and causes the result information storage unit 428 to store the simulation results. The transient analysis unit 452 simulates the circuit operation of the AFE unit 100 that has the circuitry configured with individual parameters as simulation conditions with reference to the circuit information storage unit 426 and the parameter storage unit 427, and the transient analysis unit 452 generates waveforms that show the input and output characteristics of the AFE unit 100. The transient analysis unit 452 simulates the operation of the AFE unit 100 and generates the time-series output signals of the individual circuits of the AFE unit 100 with a sensor output signal, which is obtained through the physical quantity conversion unit 450 converting an input pattern of a physical quantity input in a time-series order, as an input signal to the AFE unit 100, and the transient analysis unit 452 generates time-series output signals for individual circuits of the AFE unit 100.

The AC analysis unit 453 simulates the frequency characteristics of the AFE unit 100 for analyzing the AC characteristics, and causes the result information storage unit 428 to store the simulation results. The AC analysis unit 453 simulates the circuit operation of the AFE unit 100 that has the circuitry configured with individual parameters as simulation conditions with reference to the circuit information storage unit 426 and the parameter storage unit 427, and the AC analysis unit 453 generates waveforms that show the frequency characteristics of the AFE unit 100. The AC analysis unit 453 generates an input pattern of a physical quantity for each frequency, simulates the operation of the AFE unit 100 with a sensor output signal, which is obtained by the physical quantity conversion unit 450 converting the input pattern of the physical quantity for each frequency, as an input signal to the AFE unit 100, and generates output signals for each frequency of individual circuits of the AFE unit 100.

The filter effect analysis unit 454 simulates the input and output characteristics of the AFE unit 100 that is located in a noisy environment for analyzing the filter effect, and causes the result information storage unit 428 to store the simulation results. The filter effect analysis unit 454 simulates the circuit operation of the AFE unit 100 that has the circuitry configured with individual parameters as simulation conditions with reference to the circuit information storage unit 426 and the parameter storage unit 427, and the filter effect analysis unit 454 generates waveforms that show the input and output characteristics of the AFE unit 100 located in the noisy environment. The filter effect analysis unit 454 adds a noise to an input pattern of a physical quantity input in a time-series order, and simulates the operation of the AFE unit 100 with a sensor output signal, which is obtained by the physical quantity conversion unit 450 converting the noise-added signal, as an input signal to the AFE unit 100, and the filter effect analysis unit 454 generates time-series output signals for individual circuits of the AFE unit 100.

The synchronous detection analysis unit 455 simulates the synchronous operation of the AFE unit 100 for analyzing the synchronous detection operation, and causes the result information storage unit 428 to store the simulation results. The synchronous detection analysis unit 455 simulates the circuit operation of the AFE unit 100 that has the circuitry configured with individual parameters as simulation conditions with reference to the circuit information storage unit 426 and the parameter storage unit 427, and the synchronous detection analysis unit 455 generates waveforms that show the synchronous detection operation. The synchronous detection analysis unit 455 simulates the operation of the AFE unit 100 and generates the time-series output signals of the individual circuits of the AFE unit 100 with an input pattern of a physical quantity input in a time-series order and a synchronous clock as shown in Fig. 16 as input signals to the AFE unit 100, and the synchronous detection analysis unit 455 generates time-series output signals for individual circuits of the AFE unit 100.

The resister information generation unit 416 generates register information configured in the register 181 of the semiconductor device 1, and causes the register information storage unit 429 to store the register information. The resister information generation unit 416 generates the register information in accordance with the circuitry and circuit characteristics of the AFE unit 100 that is configured as a simulation target with reference to the circuit information storage unit 426 and the parameter storage unit 427.

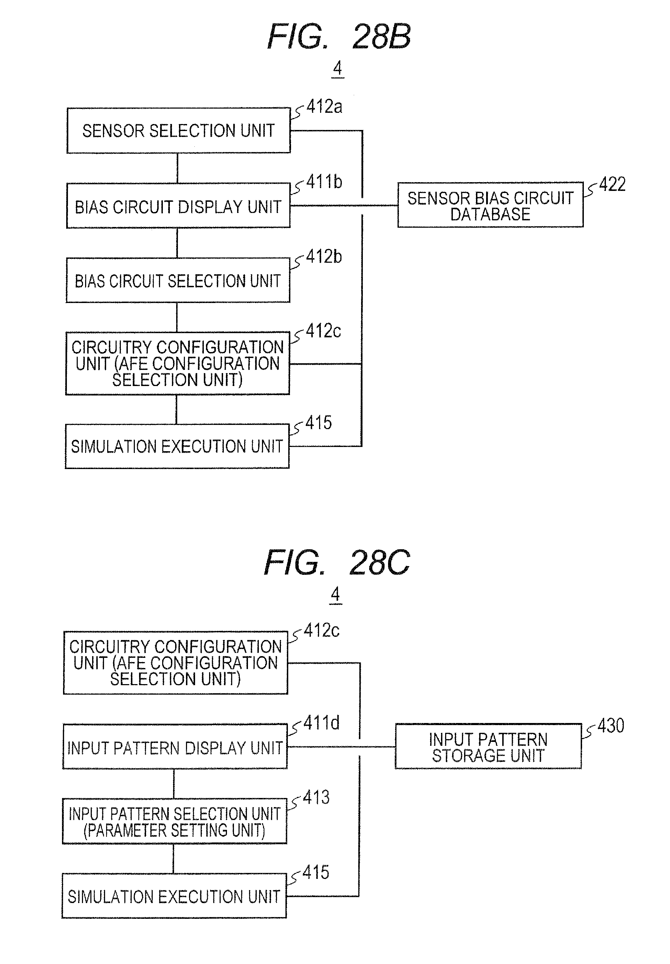

In addition, as shown in Fig. 28B or in Fig. 28C, a web simulator 4 can be configured with some blocks selected from among the blocks shown in Fig. 28A. For example, a web simulator 4 shown in Fig. 28B includes at least the sensor bias circuit database 422, the sensor selection unit 412a, the bias circuit display unit 411b, the bias circuit selection unit 412b, the circuitry configuration unit (AFE configuration selection unit) 412c, and the simulation execution unit 415 among the units shown in Fig. 28A.

To put it concretely, in Fig. 28B, the sensor selection unit 412a selects a sensor to be coupled to the semiconductor device 1. The sensor bias circuit database 422 stores the sensor and plural bias circuits that supply bias signals to the sensor in association with each other, and the bias circuit display unit 411b displays the plural bias circuits corresponding to the selected sensor with reference to the sensor bias circuit database 422. The bias circuit selection unit 412b selects a bias circuit to be coupled to the selected sensor in accordance with a user operation from among the displayed plural bias circuits. The circuitry configuration unit 412c configures the circuitry of the semiconductor device 1 to be coupled to the selected sensor and bias circuit. The simulation execution unit 415 executes a simulation on a combination of the selected sensor, the bias circuit, and the semiconductor device 1 that has the configured circuitry. In the case where the web simulator 4 is configured at least with the units shown in Fig. 28B, an optimal bias circuit can be selected from among plural bias circuits corresponding to a selected sensor, and a simulation can be effectively executed by the web simulator.

Alternatively, a web simulator 4, which includes, as shown in Fig. 28C, at least the input pattern storage unit 430, the circuitry configuration unit (AFE configuration selection unit) 412c, the input pattern display unit 411d, the input pattern selection unit (parameter setting unit) 413, and the simulation execution unit 415 among the units shown in Fig. 28A, is also conceivable.

To put it concretely, in Fig. 28C, the circuitry configuration unit 412c configures the circuitry of the semiconductor device 1 in accordance with a sensor to be coupled to the semiconductor device 1. The input pattern storage unit 430 stores plural waveform patterns input to the sensor, and the input pattern display unit 411d displays the plural waveform patterns stored in the input pattern storage unit 430. The input pattern selection unit 413 selects a waveform pattern to be input to the sensor from among the displayed plural waveform patterns in accordance with a user operation. The simulation execution unit 415 executes a simulation on a combination of the sensor and the analog front end circuit that has the configured circuitry with the selected wave pattern as an input condition. In the case where the web simulator 4 is configured at least with the units shown in Fig. 28C, the desired waveform pattern can be selected from among waveform patterns input to the sensor, and the simulation can be effectively executed by the web simulator.

Next, a simulation method in which a simulation is executed in a simulation system according to this embodiment will be described with reference to Fig. 29 to Fig. 37. In this simulation method, because various pieces of processing are performed mainly by web simulator 4 shown in Fig. 26 to Fig. 28C, the processing performed by the web simulator 4 will be described hereinafter.

A flowchart in Fig. 29 shows an entire flow of the simulation processing according to this embodiment. In this simulation processing, first, the web page processing unit 411 causes the user terminal 3 to display a guidance screen (at step S101). When a user specifies the URL of the web simulator 4 at the web browser 300 of the user terminal 3, the web browser 300 accesses the web server 400, and a simulation program is launched at the web simulator 4. Subsequently, the web page processing unit 411 transmits web page information about the guidance screen that is a launch page to the user terminal 3, and causes the web browser 300 to display the guidance screen.

Next, the web page processing unit 411 causes the user terminal 3 to display a sensor selection screen, and the user selects a sensor (at step S102). If the user executes an operation to desire to select a sensor on the guidance screen at step S101, the web page processing unit 411 transmits web page information about the sensor selection screen used for selecting a sensor to the user terminal 3, and causes the web browser 300 to display the sensor selection screen. When the user specifies narrowing-down conditions (search conditions or filtering conditions) for sensor types and the like, the web page processing unit 411 extracts sensors fit to the narrowing-down conditions from the sensor database 421, and display the list of the extracted sensors on the sensor selection screen. If the user selects a sensor to be used from the list of the sensors displayed on the sensor selection screen, the circuit configuration unit 412 (the sensor selection unit 412a) causes the circuit information storage unit 426 to store the selected sensor as a simulation target circuit.

Next, the web page processing unit 411 causes the user terminal 3 to display a bias circuit selection screen, and the user selects a bias circuit (at step S103). If the user executes an operation to desire to configure a bias circuit on the sensor selection screen at step S102, the web page processing unit 411 transmits web information about the bias circuit selection screen to the user terminal 3, and causes the web browser 300 to display the bias circuit selection screen. The web page processing unit 411 extracts plural bias circuits fit to the sensor selected at step S102 with reference to the sensor bias circuit database 422, and displays the extracted bias circuits on the bias circuit selection screen. If the user selects a sensor to be used from among the plural bias circuits displayed on the bias circuit selection screen, the circuit configuration unit 412 (the bias circuit selection unit 412b) causes the circuit information storage unit 426 to store the selected bias circuit as a simulation target circuit.

Next, the web page processing unit 411 causes the user terminal 3 to display a physical quantity input screen, and the user inputs a physical quantity (at step S104). If the user executes an operation to desire to input a physical quantity to the sensor on the sensor selection screen at step S102 or on the bias circuit selection screen at step S103, the web page processing unit 411 transmits web information about the physical quantity input screen, on which the user inputs a physical quantity, to the user terminal 3, and causes the web browser 300 to display the physical quantity input screen. The web page processing unit 411 displays plural input patterns (input waveforms) used for inputting a physical quantity, which is to be input to the sensor, in a time-series order, and the user selects an input pattern to be used for the simulation. In addition, the web page processing unit 411 displays the acceptable input range of the physical quantity corresponding to the selected sensor on the physical quantity input screen with reference to the sensor database 421, and the user specifies the desired input range of the physical quantity within the acceptable input range. On the physical quantity input screen, if the user inputs the input pattern and the desired input range of the physical quantity to be input to the sensor, the parameter setting unit 413 sets the input parameters in the parameter storage unit 427.

Next, the web page processing unit 411 causes the user terminal 3 to display the AFE selection screen, and the user selects an AFE (a semiconductor device) (at step S105). On the guidance screen at step S101, on the sensor selection screen at step S102, or on the like, if the user executes an operation to desire to select a semiconductor device (an AFE unit 100), the web page processing unit 411 transmits web page information about the AFE selection screen, on which the user selects a semiconductor device 1, to the user terminal 3, and causes the web browser 300 to display the AFE selection screen.

The web page processing unit 411 extracts a semiconductor device 1 including a configurable amplifier 110 whose circuitry is fit to the selected sensor and bias circuit with reference to the AFE database 424. In this case, the web page processing unit 411 determines the circuitries of configurable amplifiers 110 well-adapted to the selected sensor and bias circuit with reference to the configurable analog circuit database 423, and extracts a semiconductor devices 1 including the configurable amplifiers 110 having the determined circuitries. In addition, when the user specifies narrowing-down conditions for the circuitries of the semiconductor devices 1 and the like (search conditions or filtering conditions), the web page processing unit 411 extracts semiconductor devices 1 fit to the narrowing-down conditions from the AFE database 424, and displays the list of the extracted semiconductor devices 1 on the AFE selection screen. If the user selects a semiconductor device 1 (an AFE unit 100) to be used from the list of the semiconductor devices 1 displayed on the AFE selection screen, the circuit configuration unit 412 (the AFE configuration selection unit 412c) causes the circuit information storage unit 426 to store the selected AFE unit 100 of the semiconductor device 1 as a simulation target circuit.

Next, the circuit configuration unit 412 determines the circuitry and coupling relation of the configurable amplifier 110 (at step S106). When the sensor and the bias circuit are selected at the steps S102 and S103, and the semiconductor device 1 is selected at step S105, the circuit configuration unit 412 determines a circuitry of the configurable amplifier 110 fit to the selected sensor and bias circuit with reference to the configurable analog circuit database 423, and further determines a coupling relation (coupling terminals) from among the sensor and bias circuit, and the configurable amplifier 110. The circuit configuration 412 (the AFE configuration selection unit 412c) causes the circuit information storage unit 426 to store the determined circuitry and coupling relation of the configurable amplifier 110.

Next, the web page processing unit 411 causes the user terminal 3 to display a sensor AFE coupling screen, and the user couples the sensor and the AFE (the semiconductor device 1) (at step S107). On the AFE selection screen at step S105, if the user executes an operation to desire to couple the sensor and the semiconductor device 1, the web page processing unit 411 transmits web information about the sensor AFE coupling screen, on which the user couples the sensor and the semiconductor device 1, to the user terminal 3, and causes the web browser 300 to display the sensor AFE coupling screen. The web page processing unit 411 displays the output terminals of the selected sensor and bias circuit, and the input terminals of the selected semiconductor device 1 (the AFE unit 100), so that the user can select a coupling relation from among the sensor, the bias circuit, and the semiconductor device 1. In addition, as a default coupling relation, the coupling relation determined at step S106 is displayed, so that the sensor and bias circuit, and the semiconductor device 1 can be coupled to each other with the use of this default coupling relation. On the sensor AFE coupling screen, if the user selects the coupling relation between the sensor and the semiconductor device 1, the circuit configuration unit 412 causes the circuit information storage unit 426 to store the selected coupling relation as a coupling relation from among simulation target circuits.

Next, the automatic configuration unit 451 performs automatic configuration processing (at step S108). At steps S102 to S107, the circuitries of the sensor and bias circuit and the circuitry of the configurable amplifier 110 are determined, and the coupling relation among the sensor and bias circuit and the configurable amplifier 110 are determined, the automatic configuration unit 451 performs automatic configuration processing in order to automatically configure default values of the configurable amplifier 110. The detail of this automatic configuration processing will be described later. The automatic configuration unit 451 causes the parameter storage unit 427 to store the DAC output, gain and the like of the configurable amplifier 110 configured by the automatic configuration processing.

Next, the simulation execution unit 415 performs simulation execution processing (at step S109). At steps S102 to S108, the circuitries of the sensor and bias circuit, and the circuitry of the semiconductor device 1 (the AFE unit 100) are determined, and the coupling relation among the sensor and bias circuit and the semiconductor device 1 (the AFE unit 100) are also determined, the simulation execution unit 415 executes simulations for a transient analysis, an AC analysis, a filter effect analysis, a synchronous detection analysis, and the like. The details of these pieces of simulation execution processing will be described later. The simulation execution unit 415 causes the result information storage unit 428 to store the simulation results obtained through these pieces of simulation execution processing.

Next, the web page processing unit 411 causes the user terminal 3 to display a parts list screen (at step S110). On the guidance screen at step S101 or on a simulation screen (described later) at step S109, if the user executes an operation to desire for the parts list (BOM: Bills of Materials) to be displayed, the web page processing unit 411 transmits web information about the parts list screen used for displaying the parts list to the user terminal 3, and causes the web browser 300 to display the parts list screen. The web page processing unit 411 displays a parts list including the sensor and the semiconductor device 1 that are selected as simulation targets on the parts list screen with reference to the circuit information storage unit 426. The displayed parts list is configured to have links with parts purchase sites, therefore, if the user selects a part on the parts list screen, the corresponding parts purchase site is accessed, and the user can purchase the part.

Next, the register information generation unit 416 generates register information (at step S111). At steps S102 to S109, the circuitry and parameters (circuit characteristics) of the semiconductor device 1 (the AFE unit 100) is determined, the register information generation unit 416 generates register information to be configured in the register 181 of the semiconductor device 1. The register information generation unit 416 generates the register information with reference to the circuit information storage unit 426 and the parameter storage unit 427 on the basis of the circuitry and parameters of the semiconductor device 1, and causes the register information storage unit 429 to store the generated register information. Because the register information is displayed on a report screen, the register information has only to be generated at step S111 by the time when the report screen is displayed.

Next, the web page processing unit 411 causes the user terminal 3 to display the report screen (at step S112). On the guidance screen at step S101, on the simulation screen at step S109, or on the like, if the user executes an operation to desire for the simulation results to be output, the web page processing unit 411 transmits web information about the report screen including the simulation results to the user terminal 3, and causes the web browser 300 to display the report screen. The web page processing unit 411 displays the simulation results on the report screen with reference to the result information storage unit 428. In addition, the web page processing unit 411 displays the sensor and bias circuit that are simulation targets, the circuitry of the semiconductor device 1, the coupling relation, and the parameters with reference to the circuit information storage unit 426, the parameter storage unit 427, the register information storage unit 429. Further, the web page processing unit 411 displays the register information of the semiconductor device 1. In addition, on the report screen, the register information can be downloaded to the user terminal 3 in accordance with an operation performed by the user.

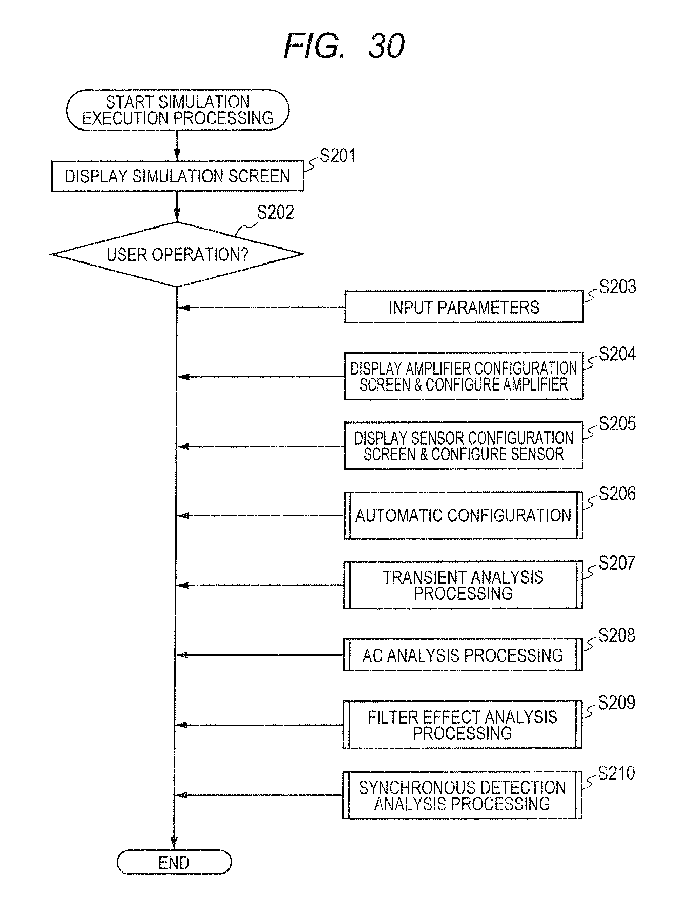

Fig. 30 is a diagram showing the simulation execution processing according to this embodiment. In other words, this processing is equivalent to the processing shown at step S109 in Fig. 29. First, the web page processing unit 411 causes the user terminal 3 to display the simulation screen (at step S201). At step S109 in Fig. 29, if the simulation execution processing is started, the web page processing unit 411 transmits web information about the simulation screen used for the simulation execution to the user terminal 3, and causes the web browser 300 to display the simulation screen.

In accordance with a user operation on the simulation screen displayed at step S201 (at step S201), the following processing steps S203 to S210 are performed. These pieces of processing are repeatedly performed as long as the simulation screen is displayed.

On the simulation screen, if the user executes an operation to desire to input parameters, the web page processing unit 411 causes the user terminal 3 to display a screen on which the parameters are input, and the user inputs parameters necessary for the simulation (at step S203). On the simulation screen, if the user clicks a parameter input button used for inputting parameters or the like, the web page processing unit 411 transmits web page information about a parameter input screen to the user terminal 3, and causes the web browser 300 to display the parameter input screen. The web page processing unit 411 displays parameters already set in the parameter storage unit 427 and default values on the parameter input screen. On the parameter input screen, if the user determines parameters by inputting them, the parameter setting unit 413 causes the parameter storage unit 427 to store the parameters.

On the simulation screen, if the user executes an operation to desire to configure the configurable amplifier 110, the web page processing unit 411 causes the user terminal 3 to display an amplifier configuration screen, and the user configures the configurable amplifier 110 (at step S204). On the simulation screen, if the user clicks an amplifier icon or the like, the web page processing unit 411 transmits web page information about the amplifier configuration screen for configuring the detail of the configurable amplifier 110 to the user terminal 3, and causes the web browser 300 to display the amplifier configuration screen. The web page processing unit 411 displays the circuitry of the amplifier already configured in the circuit information storage unit 426 on the amplifier configuration screen. On the amplifier configuration screen, if the user configures and determines the circuitry of the configurable amplifier 110, the circuit configuration unit 412 causes the circuit information storage unit 426 to store the circuit information of the configurable amplifier 110.

On the simulation screen, if the user executes an operation to desire to configure the sensor, the web page processing unit 411 causes the user terminal 3 to display an sensor configuration screen, and the user configures the sensor (at step S205). On the simulation screen, if the user clicks an sensor configuration button or the like, the web page processing unit 411 transmits web page information about the sensor configuration screen to the user terminal 3, and causes the web browser 300 to display the sensor configuration screen. The web page processing unit 411 displays the information about the sensor already configured in the circuit information storage unit 426 on the sensor configuration screen. On the sensor configuration screen, if the user determines and configures the information about the sensor, the circuit configuration unit 412 causes the circuit information storage unit 426 to store the circuit information of the sensor.

On the simulation screen, if the user executes an operation for an automatic configuration (at step S206), automatic configuration processing is performed, if the user executes an operation for a transient analysis, the transient analysis processing is performed (at step S207), if the user executes an operation for an AC analysis, the AC analysis processing is performed (at step S208), if the user executes an operation for a filter effect analysis, the filter effect analysis processing is performed (at step S209), and if the user executes an operation for a synchronous detection analysis, the synchronous detection analysis processing is performed (at step S210). Hereinafter, the above-mentioned pieces of processing will be described.

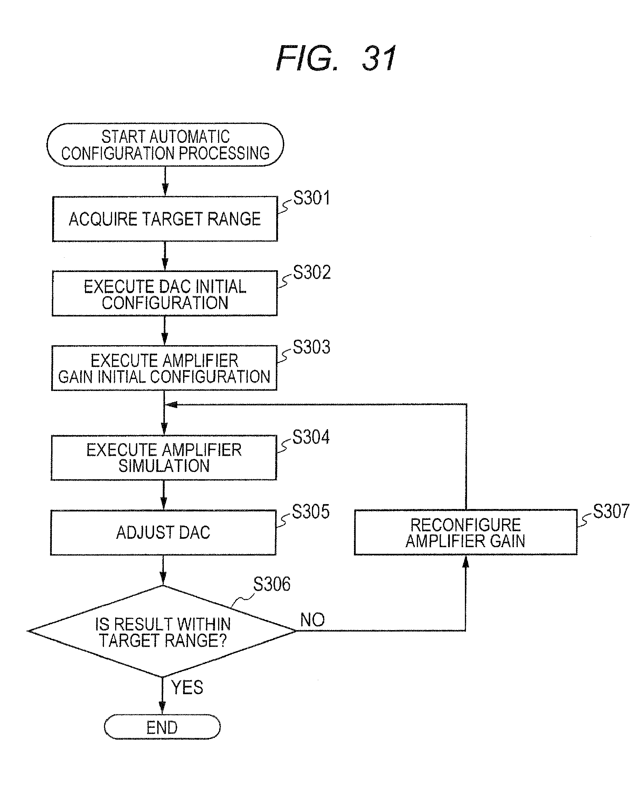

Fig. 31 is a flowchart showing automatic configuration processing according to this embodiment, and is equivalent to the processing shown at step S108 in Fig. 29 or at step S206 in Fig. 30. For example, if the user clicks an automatic configuration button, the automatic configuration processing is started.

First, the automatic configuration unit 451 acquires the target range of the configurable amplifier 110 on which the automatic configuration is to be executed (at step S301). The automatic configuration unit 451 acquires the target range (the dynamic range) within which the output level of the configurable amplifier 110 of the semiconductor device 1 is allowed to exist with reference to the AFE database 424.

Next, the automatic configuration unit 451 initializes a DAC coupled to the input of the configurable amplifier 110 (at step S302), and successively initializes the gain of the configurable amplifier 110 (at step S303). The automatic configuration unit 451 initializes the output voltage of the DAC so that the level of the input signal to the configurable amplifier 110 becomes a center value (medium value). In addition, the automatic configuration unit 451 initializes the gain of the configurable amplifier 110 so that the gain becomes an arbitrary value.

Next, the automatic configuration unit 451 executes a simulation on the configurable amplifier 110 (at step S304). The automatic configuration unit 451 simulates the operation of the configurable amplifier 110 with the output signal of the sensor, the output voltage of the DAC, the gain of the configurable amplifier 110 configured as simulation conditions. For example, the automatic configuration unit 451 calculates the output signal of the configurable amplifier 110 in the case where the maximum value, the minimum value, or the center value of the sensor is input to the configurable amplifier 110.

Next, the automatic configuration unit 451 adjusts the output voltage of the DAC (at step S305). To put it concretely, the automatic configuration unit 451 adjusts the output voltage of the DAC so that the center value of the output voltage of the configurable amplifier 110 may become the center value of the power supply voltage. In other words, the automatic configuration unit 451 compares the center value of the output voltage of the configurable amplifier 110 with the center value of the power supply voltage, and increases or decreases the output voltage of the DAC on the basis of the comparison result.

Next, the automatic configuration unit 451 judges whether the simulation results are within the target range of the configurable amplifier 110 or not (at step S306). The automatic configuration unit 451 compares the maximum value with the minimum value of the output signal of the configurable amplifier 110 obtained by the simulation with the target range. When the input signal is the minimum, the automatic configuration unit 451 compares the output signal of the configurable amplifier 110 with the minimum value of the target range, and if the simulation result is smaller than the minimum value of the target range, the automatic configuration unit 451 judges that the simulation result is out of the target range. If the simulation result is larger than the minimum value of the target range, the automatic configuration unit 451 judges that the simulation result is within the target range. Next, when the input signal is the maximum, the automatic configuration unit 451 compares the output signal of the configurable amplifier 110 with the maximum value of the target range, and if the simulation result is larger than the maximum value of the target range, the automatic configuration unit 451 judges that the simulation result is out of the target range. If the simulation result is smaller than the maximum value of the target range, the automatic configuration unit 451 judges that the simulation result is within the target range.

In the case where the simulation results are out of the target range of the configurable amplifier 110, the automatic configuration unit 451 reconfigures the gain of the amplifier (at step S307). To put it concretely, if the minimum value of the output signal of the configurable amplifier 110 is smaller than the minimum value of the target range, the automatic configuration unit 451 increases the gain of the amplifier, and if the maximum value of the output signal of the configurable amplifier 110 is larger than the maximum value of the target range, the automatic configuration unit 451 decreases the gain of the amplifier. Successively, the automatic configuration unit 451 repeats the simulation of the configurable amplifier 110 (at step S304), the adjustment of the DAC (at step S305), and the judgment whether the simulation results are within the target range or not (at step S306).

In the case where the simulation results are within the target range of the configurable amplifier 110, because the adequate gain and offset is configured, the automatic configuration unit 451 finishes the automatic configuration processing. The gain of the configurable amplifier 110 and the configuration information about the DAC are stored in the parameter storage unit 427.

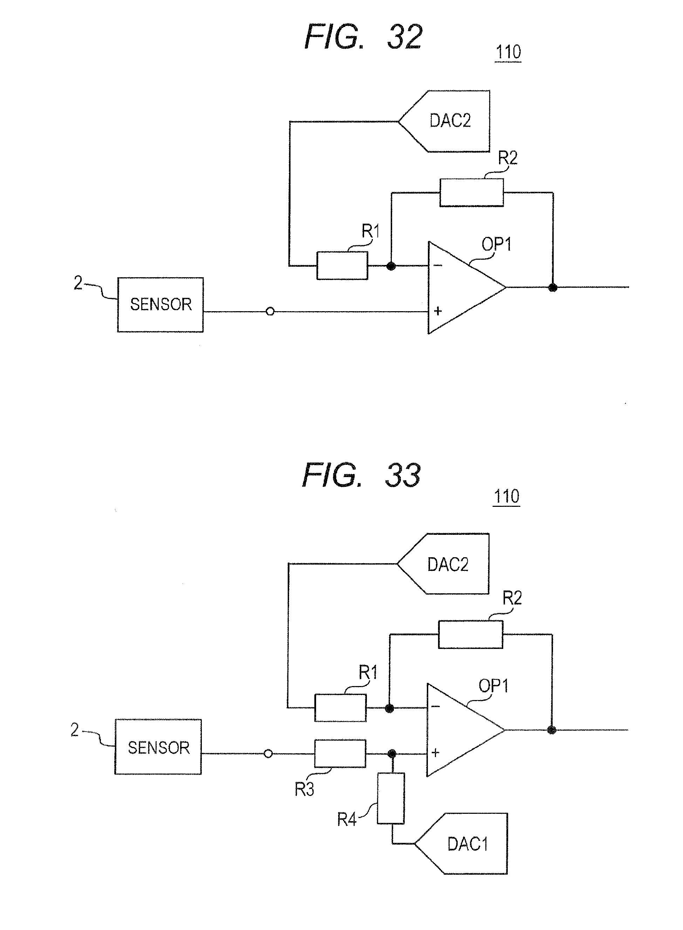

Concrete examples of the automatic configuration processing will be described with reference to Fig. 32 and Fig. 33. Fig. 32 is an example of a configurable amplifier 110 configured as a noninverting amplifier with the use of one DAC, and the configurable amplifier 110 has the same circuitry as the circuitry shown in Fig. 13. In other words, the configurable amplifier 110 shown in Fig. 32 has a circuitry in which the inverting input terminal of an operational amplifier OP1 is coupled to a DAC2 via a resistor R1, the output terminal of the operational amplifier OP1 is coupled to the inverting terminal via a resistor R2 in a feedback coupling, and the noninverting input terminal of the operational amplifier OP1 is coupled to a sensor 2.

In the case where the configurable amplifier 110 shown in Fig. 32 is automatically configured, the output voltage of the DAC2 is configured to be the center value of the output voltage (Vin±x) of the sensor first (at step S302), and the gain of the operational amplifier OP1 is configured to be an arbitrary value (at step S303).

Next, while simulating the operation of the operational amplifier OP1, the automatic configuration unit 451 adjusts the output voltage of the DAC2 so that the output voltage of the operational amplifier OP1 may become the center value of Vcc (Vcc/2) (at steps S304 and S305).

Next, it will be assumed that the target range of the configurable amplifier 110 is Vcc/2±0.8 V to Vcc/2±1 V, and it is judged whether the output voltage of the operational amplifier OP1 is within the target range or not (at step S306). If the output voltage of the operational amplifier OP1 is within the target range, the automatic configuration unit 451 finishes the automatic configuration processing. If the output voltage of the operational amplifier OP1 is out of the target range, the automatic configuration unit 451 repeats the reconfiguration of the gain of the operational amplifier OP1 (at step S307) and the adjustment of the DAC (at step S305) until the output voltage of the operational amplifier OP1 falls within the target range.

Fig. 33 is an example of a configurable amplifier 110 configured as a differential amplifier with the use of two DACs, and the configurable amplifier 110 has the same circuitry as the circuitry shown in Fig. 10. In other words, the configurable amplifier 110 shown in Fig. 33 has a circuitry in which the inverting input terminal of an operational amplifier OP1 is coupled to a DAC2 via a resistor R1, the output terminal of the operational amplifier OP1 is coupled to the inverting terminal via a resister R2 in a feedback coupling, and the noninverting input terminal of the operational amplifier OP1 is coupled to a DAC1 via a resister R4 while the noninverting input terminal of the operational amplifier OP1 is coupled to a sensor 2 via a resister R3.

In the case where the configurable amplifier 110 shown in Fig. 33 is automatically configured, the output voltage of the DAC1 is configured to be the center value (Vcc/2 = 2.5 V) of VCC, and the output voltage of the DAC2 is configured to be the center value of the output voltage (Vin±x) of the sensor (at step S302). Successively, the gain of the operational amplifier OP1 is configured to be an arbitrary value (at step S303).

Next, while simulating the operation of the operational amplifier OP1, the automatic configuration unit 451 adjusts the output voltage of the DAC1 so that the output voltage of the operational amplifier OP1 may become the center value of Vcc (Vcc/2) (at steps S304 and S305).

Next, it will be assumed that the target range of the configurable amplifier 110 is, for example, Vcc/2±0.8 V to Vcc/2±1 V, and it is judged whether the output voltage of the operational amplifier OP1 is within the target range or not (at step S306). If the output voltage of the operational amplifier OP1 is within the target range, the automatic configuration unit 451 finishes the automatic configuration processing. If the output voltage of the operational amplifier OP1 is out of the target range, the automatic configuration unit 451 repeats the reconfiguration of the gain of the operational amplifier OP1 (at step S307) and the adjustment of the DAC (at step S305) until the output voltage of the operational amplifier OP1 falls within the target range.

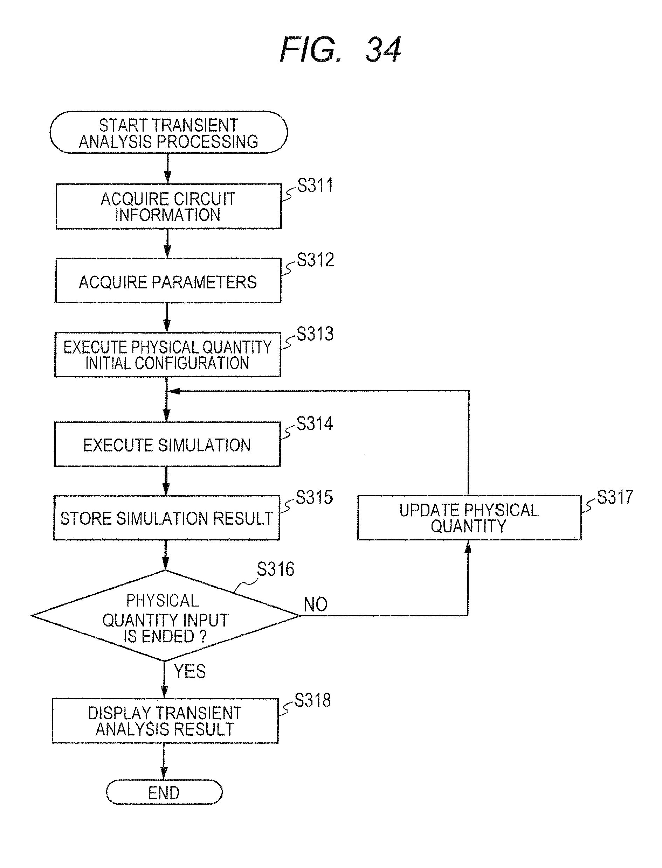

Fig. 34 is a flowchart showing the transient analysis processing according to this embodiment, and is equivalent to the processing shown at step S207 in Fig. 30. For example, if the user clicks a transient analysis button on the simulation screen, the transient analysis processing is started.

First, the transient analysis unit 452 acquires the circuit information of a circuit on which the simulation is to be executed (at step S311). The transient analysis unit 452 acquires a sensor and a bias circuit, a circuitry and a coupling relation of a semiconductor device 1 (an AFE unit 100) with reference to the circuit information storage unit 426.

Next, the transient analysis unit 452 acquires parameters for executing the simulation (at step S312). The transient analysis unit 452 acquires the input pattern of a physical quantity to be input to the sensor and the parameters of the circuit to be simulated with reference to the parameter storage unit 427.

Next, the transient analysis unit 452 initializes the physical quantity input to the sensor (at step S313). The transient analysis unit 452 configures the physical quantity that is initially input to the sensor with reference to the input patterns of the physical quantity to be input to the sensor. Because the physical quantity is input in a time-series order, the time information is also initialized.

Next, the transient analysis unit 452 executes the simulation on the semiconductor device 1 (the AFE unit 100) (at step S314). The physical quantity conversion unit 450 calculates the output signal of the sensor corresponding to the input physical quantity, and the transient analysis unit 452 simulates the operation of the semiconductor device 1 with the use of this output signal of the sensor, the gain of an amplifier, and the like as simulation conditions.

Next, the transient analysis unit 452 stores simulation results (at step S315). The transient analysis unit 452 causes the result information storage unit 428 to store the output signals of the individual circuits of the semiconductor device 1 in association with the current time information as the simulation results.

Next, the transient analysis unit 452 judges whether the input of the input pattern of the physical quantity is ended or not (at step S316). The transient analysis unit 452 judges whether the input of the input pattern of the physical quantity is ended or not by comparing the current time information with the maximum time at which the input of the input pattern of the physical quantity is ended.

If the input of the input pattern of the physical quantity is not ended, the transient analysis unit 452 updates the input physical quantity (at step S317). The transient analysis unit 452 moves the time information to the next time, and configures the physical quantity corresponding to the time with the use of the input pattern. With the use of the updated physical quantity, the transient analysis unit 452 executes the simulation (at step S314), stores the results (at step S315), and repeats these pieces of processing until the input of the input pattern of the physical quantity is ended.

When the input of the input pattern of the physical quantity is ended, the transient analysis unit 452 displays the simulation results (at step S318), and ends the transient analysis processing. To put it concretely, with reference to the result information storage unit 428, the transient analysis unit 452 displays signal waveforms obtained by plotting the stored simulation results in a time-series order on the simulation screen.

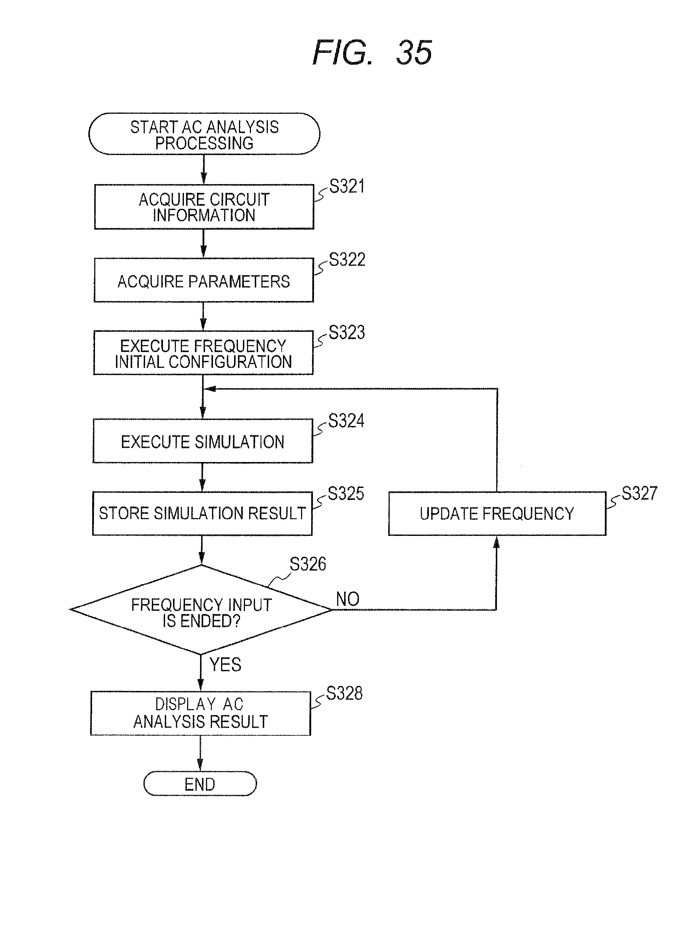

Fig. 35 is a flowchart showing the AC analysis processing according to this embodiment, and is equivalent to the processing shown at step S208 in Fig. 30. For example, if the user clicks an AC analysis button on the simulation screen, the AC analysis processing is started.

First, the AC analysis unit 453 acquires the circuit information of a circuit on which the simulation is to be executed (at step S321). The AC analysis unit 453 acquires a sensor and a bias circuit, the circuitry and the coupling relation of a semiconductor device 1 (an AFE unit 100) with reference to the circuit information storage unit 426.

Next, the AC analysis unit 453 acquires parameters for executing the simulation (at step S322). The AC analysis unit 453 acquires the input pattern of a physical quantity to be input to the sensor and the parameters of the circuit to be simulated with reference to the parameter storage unit 427.

Next, the AC analysis unit 453 configures the value of the physical quantity input to the sensor. Successively, the AC analysis unit 453 initializes a frequency used for the AC analysis (at step S323). To put it concretely, the AC analysis unit 453 sets the minimum value or the maximum value of frequency band used for the AC analysis as the initial value of the frequency for the AC analysis.

Next, the AC analysis unit 453 executes the simulation on the semiconductor device 1 (the AFE unit 100) (at step S324). The physical quantity conversion unit 450 calculates the output signal of the sensor corresponding to the input physical quantity, and the AC analysis unit 453 simulates the operation of the semiconductor device 1 with the use of this output signal of the sensor, the gain of an amplifier, and the like as simulation conditions.

Next, the AC analysis unit 453 stores simulation results (at step S325). To put it concretely, the AC analysis unit 453 causes the result information storage unit 428 to store the output signals of the individual circuits of the semiconductor device 1 in association with the current time information as the simulation results.

Next, the AC analysis unit 453 judges whether the input of the frequencies of the AC analysis is ended or not (at step S326). The AC analysis unit 453 judges whether the input of the frequencies of the AC analysis is ended or not by comparing information about the current frequency with information of the maximum value or the minimum value of the frequency band used for the AC analysis.

If the input of the frequencies of the AC analysis is not ended, the AC analysis unit 453 updates the frequency used for the AC analysis (at step S327). The AC analysis unit 453 updates the frequency information with the new frequency, and executes the simulation with the use of the updated frequency (at step S324), stores the results (at step S325), and repeats these pieces of processing until the input of the input frequencies of the AC analysis is ended.

When the input of the frequencies of the AC analysis is ended, the AC analysis unit 453 displays the simulation results (at step S328), and ends the AC analysis processing. To put it concretely, with reference to the result information storage unit 428, the AC analysis unit 453 displays the signal waveforms obtained by plotting the stored simulation results in a frequency-series order on the simulation screen.

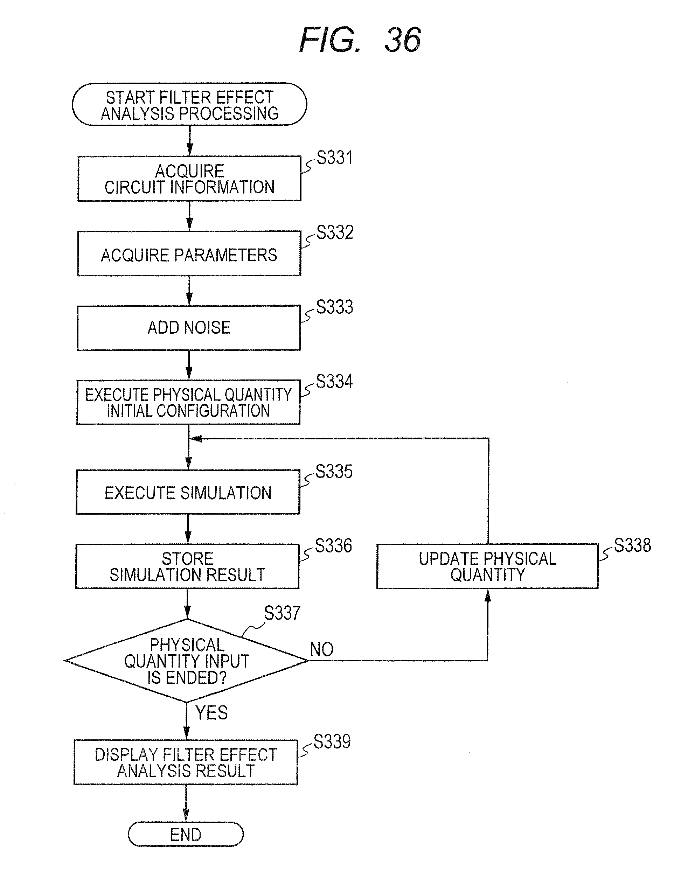

Fig. 36 is a flowchart showing the filter effect analysis processing according to this embodiment, and is equivalent to the processing shown at step S209 in Fig. 30. For example, if the user clicks a filter effect analysis button on the simulation screen, the filter effect analysis processing is started.

First, the filter effect analysis unit 454 acquires the circuit information of a circuit on which the simulation is to be executed (at step S331). The filter effect analysis unit 454 acquires a sensor and a bias circuit, the circuitry and the coupling relation of a semiconductor device 1 (a AFE unit 100) with reference to the circuit information storage unit 426.

Next, the filter effect analysis unit 454 acquires parameters for executing the simulation (at step S332). The filter effect analysis unit 454 acquires the input pattern of a physical quantity to be input to the sensor and the parameters of the circuit to be simulated with reference to the parameter storage unit 427.

Next, the filter effect analysis unit 454 adds a noise to the input pattern of the physical quantity (at step S333). To put it concretely, the filter effect analysis unit 454 generates a noise pattern, and adds the noise to the input pattern of the physical quantity to be input to the sensor.

Next, the filter effect analysis unit 454 initializes the physical quantity input to the sensor (at step S334). The filter effect analysis unit 454 configures the physical quantity that is initially input to the sensor with reference to the input pattern of the noise-added physical quantity. Because the physical quantity is input in a time-series order, the time information is also initialized.

Next, the filter effect analysis unit 454 executes the simulation on the semiconductor device 1 (the AFE unit 100) (at step S335). The physical quantity conversion unit 450 calculates the output signal of the sensor corresponding to the input physical quantity, and the filter effect analysis unit 454 simulates the operation of the semiconductor device 1 with the use of this output signal of the sensor, the gain of an amplifier, and the like as simulation conditions.

Next, the filter effect analysis unit 454 stores the simulation results (at step S336). The filter effect analysis unit 454 causes the result information storage unit 428 to store the output signals of the individual circuits of the semiconductor device 1 in association with the current time information as the simulation results.

Next, the filter effect analysis unit 454 judges whether the input of the input pattern of the physical quantity is ended or not (at step S337). The filter effect analysis unit 454 judges whether the input of the input pattern of the physical quantity is ended or not by comparing the current time information with the maximum time at which the input of the input pattern of the noise-added physical quantity is ended.

If the input of the input pattern of the physical quantity is not ended, the filter effect analysis unit 454 updates the physical quantity (at step S338). The filter effect analysis unit 454 moves the time information to the next time, and configures the physical quantity corresponding to the time with the use of the noise-added input pattern. With the use of the updated physical quantity, the transient analysis unit 452 executes the simulation (at step S335), stores the results (at step S336), and repeats these pieces of processing until the input of the input pattern of the physical quantity is ended.

When the input of the input pattern of the physical quantity is ended, the filter effect analysis unit 454 displays the simulation results (at step S339), and ends the filter effect analysis processing. To put it concretely, with reference to the result information storage unit 428, the filter effect analysis unit 454 displays signal waveforms obtained by plotting the stored simulation results in a time-series order on the simulation screen.

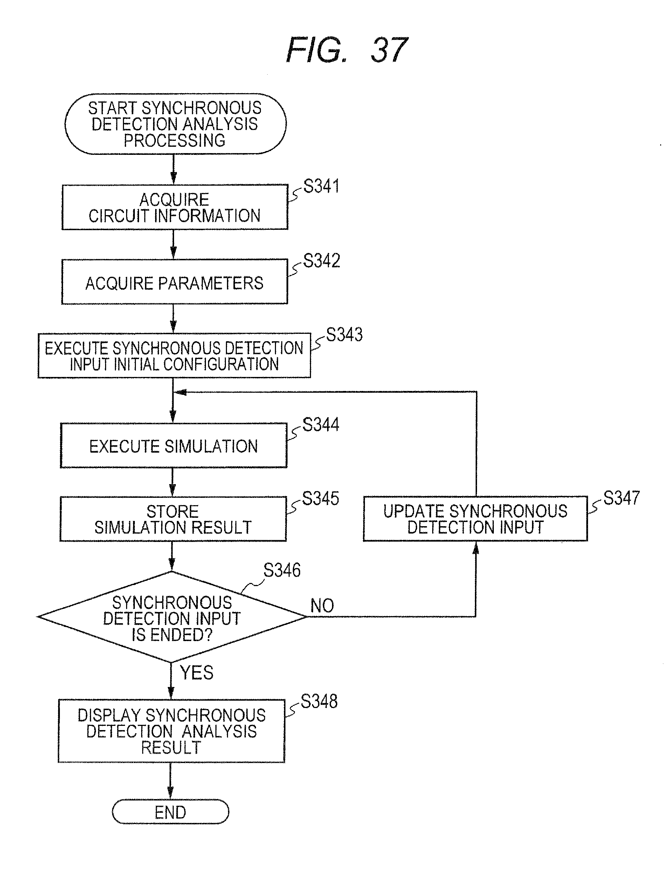

Fig. 37 is a flowchart showing the synchronous detection analysis processing according to this embodiment, and is equivalent to the processing shown at step S210 in Fig. 30. For example, if the user clicks a synchronous detection analysis button on the simulation screen, the synchronous detection analysis processing is started.

First, the synchronous detection analysis unit 455 acquires the circuit information of a circuit on which the simulation is to be executed (at step S341). The synchronous detection analysis unit 455 acquires a sensor and a bias circuit, the circuitry and the coupling relation of a semiconductor device 1 (the AFE unit 100) with reference to the circuit information storage unit 426.

Next, the synchronous detection analysis unit 455 acquires parameters for executing the simulation (at step S342). The synchronous detection analysis unit 455 acquires the input pattern of a physical quantity to be input to the sensor and the parameters of the circuit to be simulated with reference to the parameter storage unit 427.

Next, the synchronous detection analysis unit 455 initializes an input synchronous detection pattern (at step S343). The synchronous detection analysis unit 455 configures the physical quantity that is initially input to the sensor with reference to the input patterns of the physical quantity input to the sensor. In addition, the synchronous detection analysis unit 455 initializes synchronous clock CLK_SYNCH that is input for the synchronous detection as a synchronous detection pattern.

Next, the synchronous detection analysis unit 455 executes the simulation on the semiconductor device 1 (the AFE unit 100) (at step S344). The physical quantity conversion unit 450 calculates the output signal of the sensor corresponding to the input physical quantity, and the synchronous detection analysis unit 455 simulates the operation of the semiconductor device 1 with the use of this output signal of the sensor, the gain of an amplifier, and the like as simulation conditions.

Next, the synchronous detection analysis unit 455 stores the simulation results (at step S345). The synchronous detection analysis unit 455 causes the result information storage unit 428 to store the output signals of the individual circuits of the semiconductor device 1 in association with the current time information as the simulation results.

Next, the synchronous detection analysis unit 455 judges whether the input of the input pattern of the physical quantity or the input of the synchronous detection pattern is ended or not (at step S346). The synchronous detection analysis unit 455 judges whether the input of the input pattern of the physical quantity or the input of the synchronous detection pattern is ended or not by comparing the current time information with the maximum time at which the input of the input pattern of the physical quantity or the input of the synchronous detection pattern is ended.

If the input of the input pattern of the physical quantity or the input of the synchronous detection pattern is not ended, the synchronous detection analysis unit 455 updates the input physical quantity and the synchronous detection input (at step S347). The synchronous detection analysis unit 455 moves the time information to the next time, configures the physical quantity corresponding to the time with the use of the input pattern, and configures the synchronous clock corresponding to the time with the use of the synchronous detection pattern. With the use of the updated physical quantity and the updated synchronous clock, the synchronous detection analysis unit 455 executes the simulation (at step S344), stores the results (at step S345), and repeats these pieces of processing until the input of the input pattern of the physical quantity or the input of the synchronous detection pattern is ended.

When the input of the input pattern of the physical quantity or the input of the synchronous detection pattern is ended, the synchronous detection analysis unit 455 displays the simulation results (at step S348), and ends the synchronous detection analysis processing. To put it concretely, with reference to the result information storage unit 428, the synchronous detection analysis unit 455 displays signal waveforms obtained by plotting the stored simulation results in a time-series order on the simulation screen.

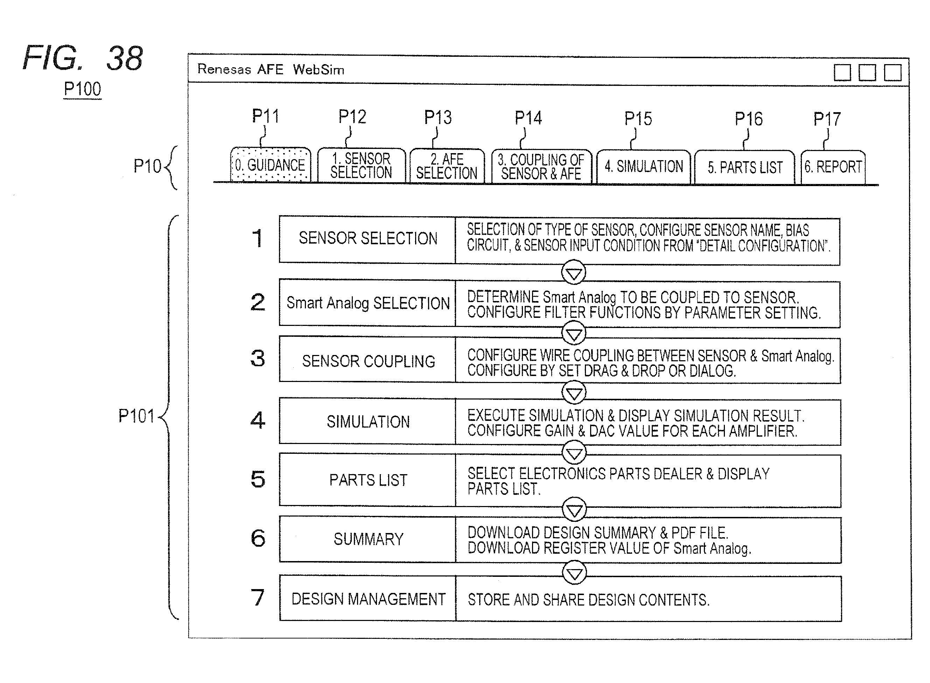

Next, display examples of the screens (web pages), which are displayed by the user terminal 3 at individual pieces of processing shown in Fig. 29 to Fig. 37, will be described with reference to Fig. 38 to Fig. 64, in which the web simulator 4 causes the user terminal 3 to display these screens (web pages). The individual screens mentioned above are displayed as user interfaces for the individual pieces of simulation processing shown in Fig. 29 to Fig. 37, and the display of these screens are materialized thanks to web page information that is sent to the user terminal 3 mainly by the web page processing unit 411 of the web simulator 4 and the like and used for displaying these screens.

Fig. 38 is a display example of the guidance screen shown at step S101 in Fig. 29. As shown in Fig. 38, a web simulator screen P100 is displayed in the entirety of the window of the web browser 300, and various screens used for pieces of processing necessary for the simulation are displayed inside the web simulator screen P100.

The web simulator screen P100 includes a tab area P10, which is displayed in common among individual screens, in its upper part. Tabs P11 to P17 used for selecting any screen to be displayed from among the individual screens are displayed in the tab area P10. Because the tab area P10 is displayed in common among the individual screens, a user can switch from any screen to his/her desired screen.

For example, if "Guidance" tab P11 is clicked, the guidance screen is displayed; if "Sensor Selection" tab P12 is clicked, the sensor selection screen is displayed; if "AFE Selection" tab P13 is clicked, the AFE selection screen is displayed; if "Sensor AFE Coupling" tab P14 is clicked, the sensor AFE coupling screen is displayed; if "Simulation" tab P15 is clicked, the simulation screen is displayed; if "Parts List" tab P16 is clicked, the parts list screen is displayed; and if "Report" tab P17 is clicked, the report screen is displayed.

When the web simulator is launched or when "Guidance" tab P11 is selected, a guidance screen P101 is displayed nearly on the center of the web simulator screen P100 as shown in Fig. 38.

On the guidance screen P101, the flow of the usage of the web simulator is displayed in a flowchart format so that a user can understand how to use the web simulator in one glance. For example, the flowchart of the guidance display is corresponding to the operation of the web simulator described in Fig. 29, and it is also corresponding to the individual screens displayed by the tabs P11 to P17.

The caption about each step of the flowchart shown on the guidance screen P101 includes an icon (not shown) and the description of the outline of the step so that a user can easily understand the content of the step. For example, at "Sensor Selection" of step 1, the type of a sensor is selected, and a sensor name, a bias circuit, and a sensor input condition are configured using "Detail Configuration". At "Smart Analog Selection" of step 2, a Smart Analog (a semiconductor device 1) to be coupled to the sensor is determined, and the semiconductor device 1 can be selected with the use of a filtering function that is provided with already-configured parameters. At "Sensor Coupling" of step 3, the wire coupling between the sensor and the Smart Analog (the semiconductor device 1) can be configured through a drag/drop or a dialog operation. At "Simulation" of step 4, the simulation is executed, the simulation results are displayed, and the gain and the DAC value for each amplifier can be configured. At "Parts List" of step 5, electronics parts dealers are selected, and parts lists are displayed. At "Report" of step 6, a design summary and a PDF file can be downloaded, and the register value of the Smart Analog (the semiconductor device 1) can also be downloaded. At "Design Management" of step 7, the design contents of the Smart Analog (the semiconductor device 1) can be stored and shared.

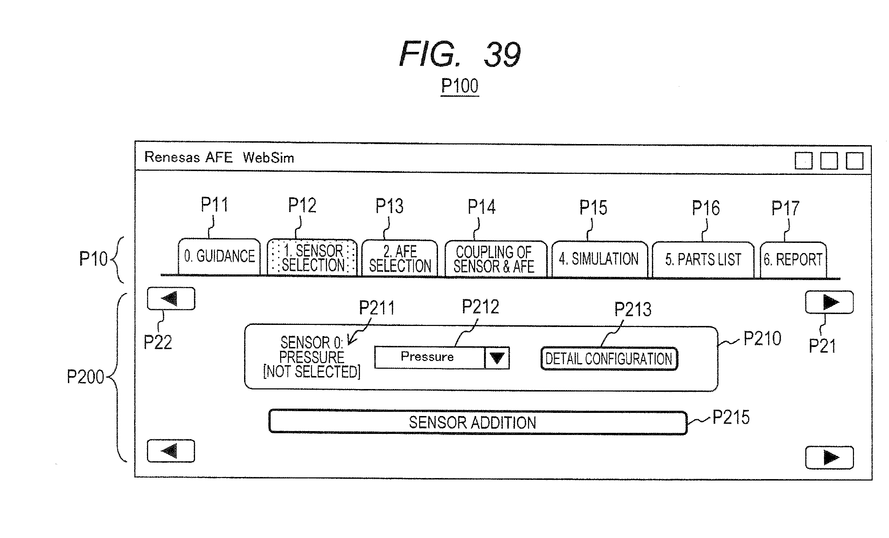

Fig. 39 is a diagram showing a display example of the sensor selection screen shown at step S102 in Fig. 29. When "Sensor Selection" tab P12 is selected, the sensor selection screen P200 is displayed nearly on the center of the web simulator screen P100 as shown in Fig. 39.

Each of the sensor selection screen P200 (in Fig. 39) and other screens to be described later, which are displayed on the web simulator screen P100, includes two Go buttons P21 on its upper right edge and on its lower right edge and two Back buttons P22 on its upper left edge and on its lower left edges in a similar way. When one of the two Go buttons P21 is clicked, the next screen is displayed, and one of the Back buttons P22 is clicked, the previous screen is displayed. For example, if one of the Go buttons P21 is clicked on the sensor selection screen P200, the AFE selection screen is displayed, and if one of the Back buttons P22 is clicked on the sensor selection screen P200, the guidance screen is displayed.

As shown in Fig. 39, the current sensor-selection state in which sensors are currently selected is displayed on the sensor selection screen P200. On the sensor selection screen P200, a sensor frame P210 is displayed for each sensor, and the sensor frame P210 shows the selection state of the sensor. In the sensor name display area P211 of the sensor selection frame P210, the sensor type and sensor name of a currently selected sensor are displayed. In Fig. 39, as no sensor has been selected yet, "Not Selected" is displayed as a sensor name.

A sensor type pull-down menu P212 of the sensor selection frame P210 displays plural sensor types in a pull-down format, and a user can select a type of sensor (a kind of sensor) from the pull-down list. "Detail Configuration" button P213 is a button used for displaying a sensor detail screen on which the detail of a sensor can be configured. The detail of a sensor of the type selected from the pull-down menu P212 is configured in detail on the sensor detail screen.

"Sensor Addition" button P215 is displayed under the sensor selection frame P210. "Sensor Addition" button P215 is a button for adding and selecting a sensor. Every time "Sensor Addition" button P215 is pushed, a new sensor selection frame P210 is displayed.

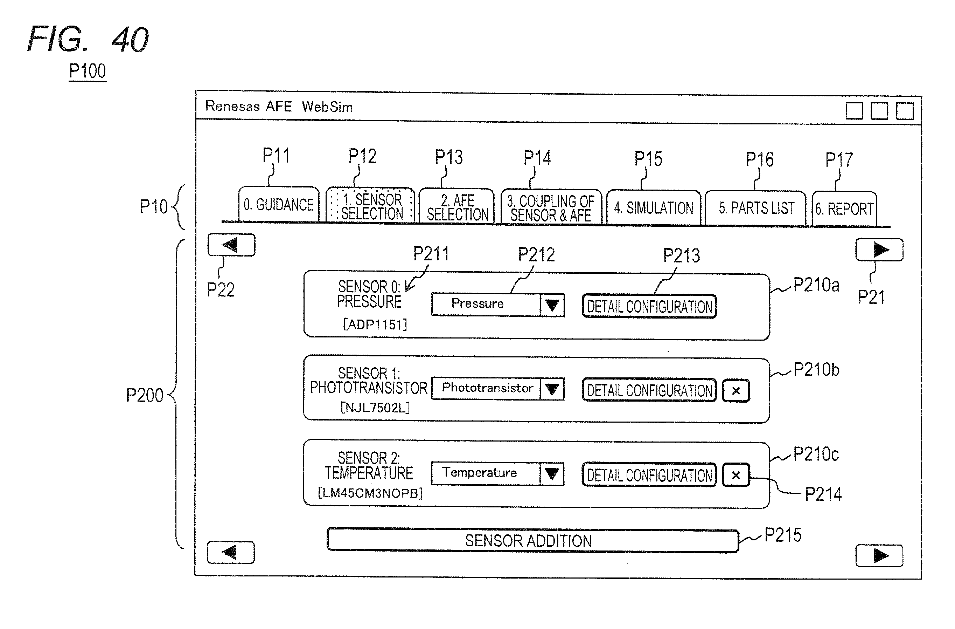

Fig. 40 is an example of a sensor selection screen P200 on which three sensors are selected and three sensor selection frames P210a to P210c are displayed. The sensor selection frame P210a is a sensor selection frame for a sensor 0, and a pressure sensor having a part number "ADP1151" is selected. The sensor selection frame P210b is a sensor selection frame for a sensor 1, and a phototransistor having a part number "NJL7502L" is selected. The sensor selection frame P210c is a sensor selection frame for a sensor 2, and a temperature sensor having a part number "LM45CM3NOPB" is selected.

Delete buttons P214 used for deleting the selection of the corresponding sensors are respectively displayed in the sensor selection frames P210b and P210c. When a delete button P214 is clicked, the selection of the corresponding sensor is released, and the corresponding sensor selection frame P210 is deleted.

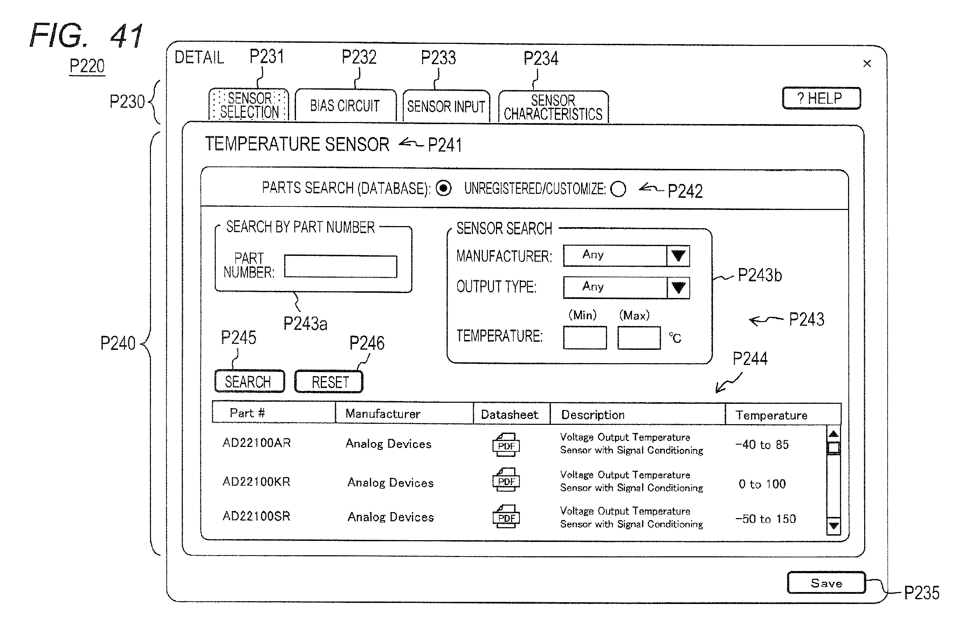

Fig. 41 is a diagram showing a display example of a sensor detail screen P220 and a sensor detail selection screen P240 that are displayed for configuring the detail of a sensor transferring from the sensor selection screen P200 in Fig. 39. In this example, because a sensor is selected on both screens in Fig. 39 and Fig. 41, both screens can be referred to as sensor selection screens.

As shown in Fig. 41, the sensor detail screen P220 is a pop-up screen independent of the web simulator screen P100. The sensor detail screen P220 is displayed in a pop-up manner when "Detail Configuration" button P213 is clicked on the sensor selection screen P200 in Fig. 39.

The sensor detail screen P220 includes a tab display area P230, which is also displayed in other screens in the same manner, in its upper part. Tabs P231 to P234 used for displaying the corresponding screens are displayed in the tab display area P230. To put it concretely, when "Sensor Selection" tab P231 is clicked, the sensor detail selection screen is displayed, when "Bias Circuit" tab P232 is clicked, the bias circuit selection screen is displayed, when "Sensor Input" tab P233 is clicked, the physical quantity input screen is displayed, and when "Sensor Characteristics" tab P234 is clicked, a sensor characteristics configuration screen is displayed.

"Save" button P235 is displayed in the lower left corner of the sensor detail screen P220 that is displayed in common on each of the above four screens. By clicking "Save" button P235, the contents configured on each of the above four screens displayed on the sensor detail screen P220 are stored in the web simulator 4. In other words, circuit information and parameters are stored in the circuit information storage unit 426 and the parameter storage unit 427.

When "Detail Configuration" button P213 is clicked on the sensor selection screen P200 or "Sensor Selection" tab P231 is selected, the sensor detail selection screen P240 is displayed on the sensor detail screen P220 as shown in Fig. 41.

The sensor type selected from the sensor type pull-down menu P212 on the sensor selection screen P200 is displayed in a sensor type display area P241 on the upper part of the sensor detail selection screen P240. In Fig. 41, a temperature sensor is displayed as a selected sensor.

Sensor selection method radio buttons P242 are displayed under the sensor type display area P241. With the use of the sensor selection method radio buttons P242, either "Parts Search" in which a sensor is searched from among sensors registered in the sensor database 421, or "Unregistered/Customize" in which a sensor that is not registered in the sensor database 421 is customized (configured to have arbitrary characteristics) is selected as a sensor selection method.

When "Parts Search" is selected using one of the sensor selection method radio buttons P242, a sensor narrowing-down condition field P243 and a sensor list P244 are displayed under the sensor selection method radio buttons P242. In the sensor narrowing-down condition field P243, "Search by Part Number" area P243a and "Sensor Search" area P243b are displayed.

In "Search by Part Number" area P243a, the part number of a sensor which a user wants to search is input to "Part Number" input box. In "Sensor Search" area P243b, pull-down menus and boxes, using which narrowing-down conditions can be specified in accordance with the sensor type, are displayed. In Fig. 41, because the sensor type is a temperature sensor, a "Manufacture" pull-down menu, "Output Type" pull-down menu, and two "Temperature" input boxes are displayed.

In order to specify the sensors of a specific manufacturer as search targets, the name of the manufacture can be specified in "Manufacturer" pull-down menu. In addition, in order to specify the sensors of all manufacturers as search targets, "Any" can be specified. In order to specify sensors with a specific output type as search targets, a current output type or a voltage output type can be specified in "Output Type" pull-down menu. In addition, in order to specify the sensors with all output types as search targets, "Any" can be specified. In order to search sensors on the basis of the characteristics of the temperature sensors, the minimum value and the maximum value of temperature that can be detected by the temperature sensors are input to "Temperature" input boxes.

"Search" button P245 and "Reset" button P246 are displayed between the narrowing-down condition field P243 and the sensor list P244. When the "Search" button P245 is clicked, a search of the sensor database is performed on the basis of the condition configured in the narrowing-down condition field P243, and the search result is displayed on the sensor list P244. If "Reset" button P246 is clicked, the narrowing-down conditions (search conditions) configured in the narrowing-down condition field P243 is reset, and the screen becomes in the initial state where nothing is configured for the sensor search.

On the sensor list P244, the list of sensors that meet the condition configured in the narrowing-down condition field P243 is displayed. In the case where a part number is specified in "Search by Part Number" area P243a, a sensor whose type is a temperature sensor and whose part number corresponds to the configured part number is displayed from among sensors stored in the sensor database 421. In the case where conditions about a manufacturer, an output type, a temperature is specified in "Sensor Search" area P243b, a sensor whose type is a temperature sensor, and that meets the conditions about the manufacturer, the output type, and the temperature is displayed from among sensors stored in the sensor database 421.

On the sensor list P244, plural pieces of information about individual sensors are displayed in plural columns in accordance with the sensor types. In Fig. 41, because the sensors are temperature sensors, there are five columns: Part#; Manufacturer; Datasheet; Description; and Temperature in which the part number, the manufacturer, the data sheets, the description, and the temperature characteristics for each sensor are respectively displayed. In Datasheet column, a PDF icon is displayed, and when the PDF icon is clicked, a PDF file including data sheets is displayed. An output type such as a voltage output type, a current output type, and the like are displayed in Description column, and the minimum value and the maximum value of the detected temperature are displayed in Temperature column.

Because the sensor list P244 is displayed by specifying a sensor type and narrowing-down conditions, a desired sensor can be selected by a simple operation. The user selects a sensor to be used from the sensor list P244 on the basis of the displayed information.

If a sensor is selected from the sensor list P244 as shown at step S102 in Fig. 29, the circuit information of the sensor is stored in the circuit information storage unit 426.

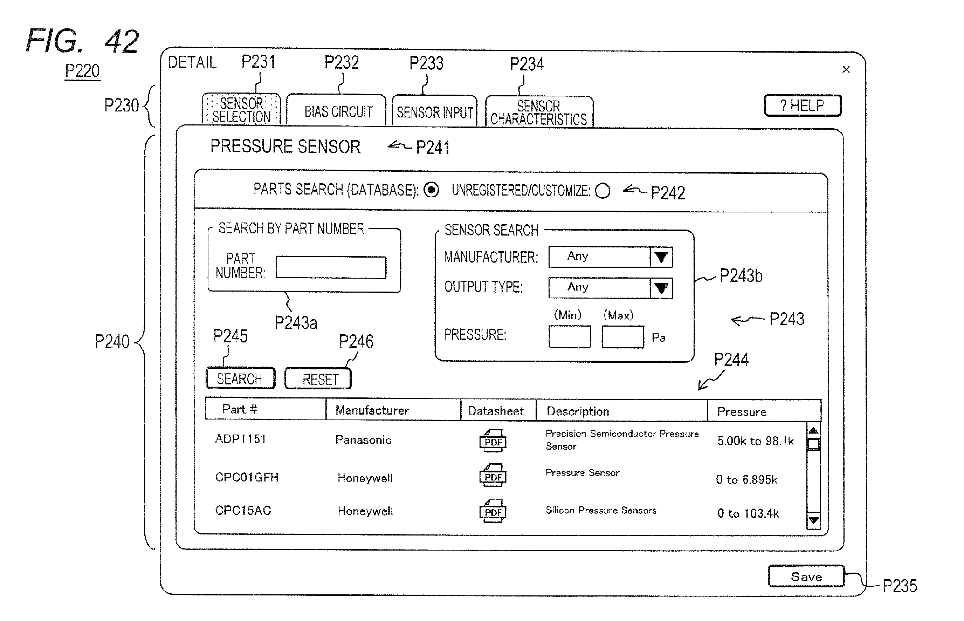

Fig. 42 is a diagram showing a display example of a sensor detail selection screen P240 in the case where a pressure sensor is selected as a sensor type. A pressure sensor is displayed in the sensor type display area P241, and narrowing-down conditions (search conditions) corresponding to the pressure sensor are displayed in "Sensor Search" area P243b. In Fig. 42, "Manufacture" pull-down menu, "Output Type" pull-down menu, and "Pressure" input boxes are displayed. In order to search sensors on the basis of the characteristics of the pressure sensors, the minimum value and the maximum value of pressure that can be detected by the pressure sensors are input to "Pressure" input boxes.

The sensor list P244 is a list corresponding to pressure sensor, and includes five columns: Part#; Manufacturer; Datasheet; Description; and Pressure in which the part number, the manufacturer, the data sheets, the description, and the pressure characteristics for each sensor are respectively displayed. A type of sensor such as a high precision sensor, a silicon sensor, and the like are displayed in Description column, and the minimum value and the maximum value of the detected pressure are displayed in Pressure column.

In addition, on the sensor detail selection screens P240 for other sensors, displays and searches are performed in accordance with sensor types in a similar way to shown in Fig. 41 and Fig. 42. For example, in the case where a sensor type is a phototransistor, a dark current ID, a peak sensitivity wave length λp, a detection range, and the like are displayed as display columns of narrowing-down conditions (search conditions) and sensor lists, and a search for the desired phototransistor can be performed.

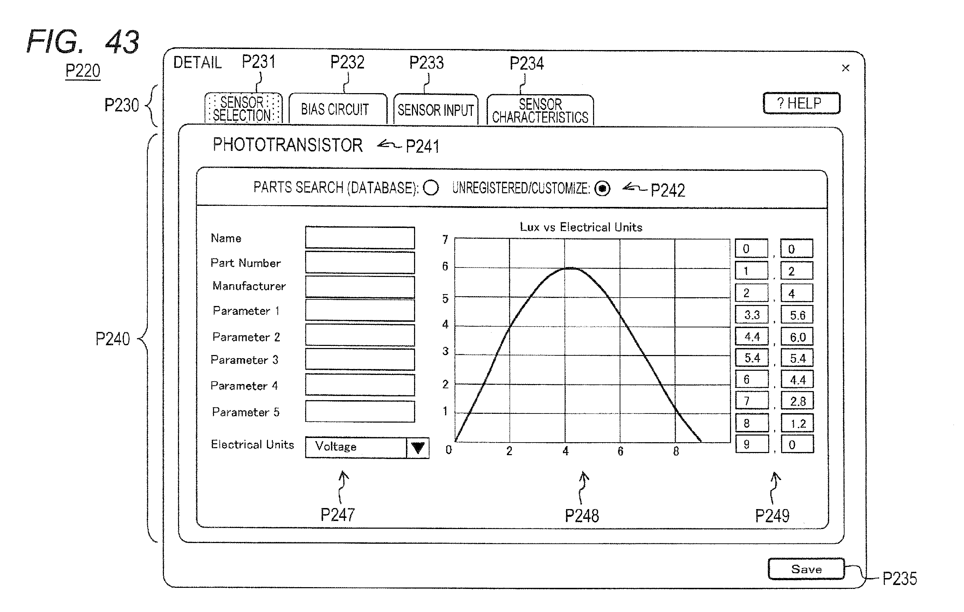

Fig. 43 is a diagram showing a display example of a sensor detail selection screen P240 in the case where "Unregistered/Customize" is selected using the other of the sensor selection method radio buttons P242. In this case, a parameter input area P247, a characteristic graph P248, and a characteristic plot input area P249 are displayed under the sensor selection method radio buttons P242.

The parameter input area P247, the characteristic graph P248, and the characteristic plot input area P249 are displayed so that the characteristics corresponding to the selected sensor type may be configured. The registered name, the part number, and various parameters are set in the parameter input area P247. With the use of the characteristic graph P248 and the characteristic plot input area P249, the characteristics of the sensor are configured. In the characteristic graph P248, the characteristics of the sensor are configured by plotting graphs corresponding respective characteristics by clicking and dragging operations. In the characteristic plot input area P249, the characteristics of the sensor are configured by inputting numerical values instead of plotting the graphs corresponding respective characteristics. In addition, the number of plotting points of the characteristic graphs can arbitrarily be incremented with the use of a plotting point number addition button (not shown).

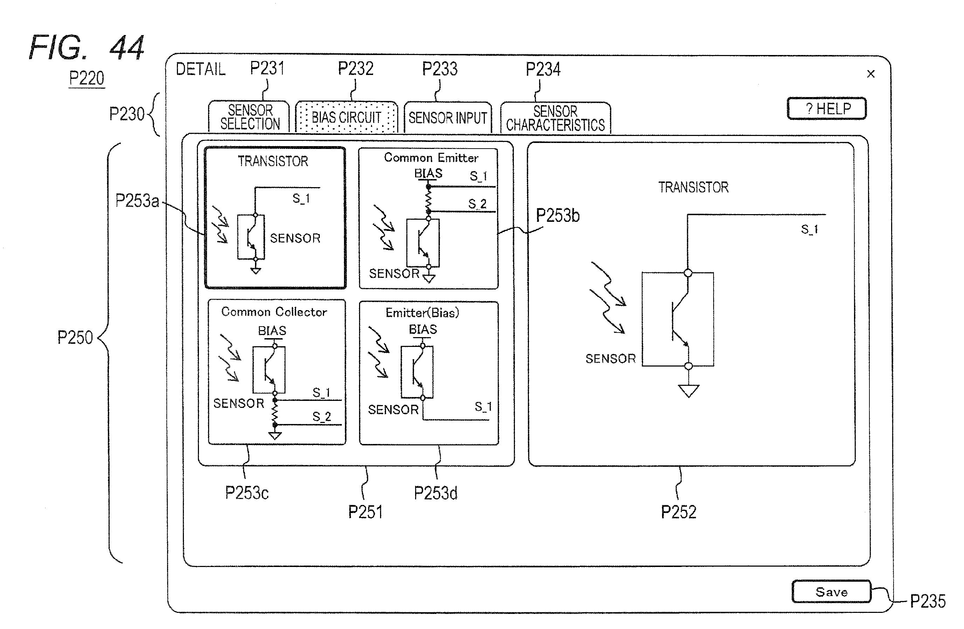

Fig. 44 is a diagram showing a display example of the bias circuit selection screen displayed at step S103 in Fig. 29. When "Bias Circuit" tab P232 is selected on the sensor detail screen P220 in Fig. 41, the bias circuit selection screen P250 is displayed as shown in Fig. 44. Bias circuits fit to the selected sensor are displayed on the bias circuit selection screen P250 as described at step S103. With the use of the displayed bias circuits fit to the sensor, an optimal bias circuit can be selected by a simple operation.

A schematic circuit list P251 and a selected circuit P252 are displayed on the bias circuit selection screen P250. The circuit images of all bias circuits well-adapted to the sensor are displayed on the schematic circuit list P251, and the circuit image of the bias circuit, which is selected by the user on the schematic circuit list P251, is displayed on the selected circuit P252.

Fig. 44 is a display example of the bias circuit selection screen P250 in the case where a phototransistor is selected as a sensor, and bias circuits P253a to P253d are displayed on the schematic circuit list P251 as bias circuits well-adapted to the phototransistor. In this case, the user selects the bias circuit P253a, and a circuit image that is the same as the bias circuit P253a is displayed on the selected circuit P252. As described at step S103 in Fig. 29, the circuit information of the selected bias circuit is stored in the circuit information storage unit 426.

Displaying plural bias circuits well-adapted to the sensor on the bias circuit selection screen P250 enables the user to select an optimal bias circuit in accordance with the intended use and the usage environment of the sensor. As some examples, the characteristics of bias circuits that are selectable in Fig. 44 will be described. The bias circuits P253b and P253c are bias circuits that are suitable for converting the current output of the current output type sensor into a voltage output and passing the output voltage to the next stage while the bias circuits P253a and P253d are bias circuits that are suitable for passing the current output of the current output type sensor as it is to the next stage.

The bias circuit P253c is a bias circuit that supplies a bias to a current output type sensor in the common-collector configuration. In the bias circuit P253c, the bias power supply is supplied to the collector of the phototransistor, and the emitter of the phototransistor is grounded via a resistor. Both ends of a resistor coupled to the emitter are the output terminals of the sensor, and are coupled to the input terminals of the semiconductor device 1. Because the bias circuit P253c is used for a sensor to which a bias is supplied from an external power supply and from which a voltage corresponding to an input illuminance is brought out, it is preferable that the configuration of the configurable amplifier 110 coupled to this sensor is that of a noninverting amplifier. Therefore, if the bias circuit P253c is selected, the configuration of the configurable amplifier 110 is automatically configured to be the configuration of a noninverting amplifier, and the bias circuit P253c is configured to be coupled to the noninverting amplifier. The smaller an illuminance is, the lower voltage signal the bias circuit P253c outputs, therefore the bias circuit P253c is best suited for applications that deal with a small illuminance.

The bias circuit P253b is a bias circuit that supplies a bias to a current output type sensor in the common-emitter configuration. In the bias circuit P253b, the emitter of the phototransistor is grounded, and the collector is coupled to the bias power supply via a resistor. Both ends of a resistor coupled to the collector are the output terminals of the sensor, and are coupled to the input terminals of the semiconductor device 1. Because the bias circuit P253b is used for a sensor to which a bias is supplied from an external power supply and from which a voltage corresponding to an input illuminance is brought out, it is preferable that the configuration of the configurable amplifier 110 coupled to this sensor is that of a noninverting amplifier. Therefore, if the bias circuit P253b is selected, the configuration of the configurable amplifier 110 is automatically configured to be the configuration of a noninverting amplifier, and the bias circuit P253b is configured to be coupled to the noninverting amplifier. The larger an illuminance is, the lower voltage signal the bias circuit P253b outputs, therefore the bias circuit P253b is best suited for applications that deal with a large illuminance.

The bias circuit P253a is a bias circuit that supplies a bias to the collector of a current output type sensor. In the bias circuit P253a, the collector of the phototransistor is a sensor output terminal, and is coupled to the input terminal of the semiconductor device 1. The emitter of the phototransistor is grounded. Because the bias circuit P253a does not supply a bias from the outside, and brings out a current corresponding to an input illuminance, it is preferable that the configuration of the configurable amplifier 110 coupled to this sensor is that of an IV amplifier. Therefore, if the bias circuit P253a is selected, the configuration of the configurable amplifier 110 is automatically configured to be the configuration of an IV amplifier, and the bias circuit P253a is configured to be coupled to the IV amplifier. The output voltage of the configurable amplifier 110 coupled to this bias circuit P253a is nearly the same as the reference voltage of the operational amplifier when an illuminance is low, and as the illuminance increases, the output voltage of the operational amplifier increases. Therefore, the bias circuit P253a is best suited for applications that deal with a small illuminance.

The bias circuit P253d is a bias circuit that supplies a bias to the emitter of a current output type sensor. In the bias circuit P253d, a bias power supply is supplied to the collector of the phototransistor, and the emitter is a sensor output terminal, and is coupled to the input terminal of the semiconductor device 1. Because the bias circuit P253d does not supply a bias from the outside, and brings out a current corresponding to an input illuminance, it is preferable that the configuration of the configurable amplifier 110 coupled to this sensor is that of an IV amplifier. Therefore, if the bias circuit P253d is selected, the configuration of the configurable amplifier 110 is automatically configured to be the configuration of an IV amplifier, and the bias circuit P253d is configured to be coupled to the IV amplifier. The output voltage of the configurable amplifier 110 coupled to this bias circuit P253d is nearly the same as the reference voltage of the operational amplifier when an illuminance is low, and as the illuminance increases, the output voltage of the operational amplifier decreases. Therefore, the bias circuit P253d is best suited for applications that deal with a large illuminance.

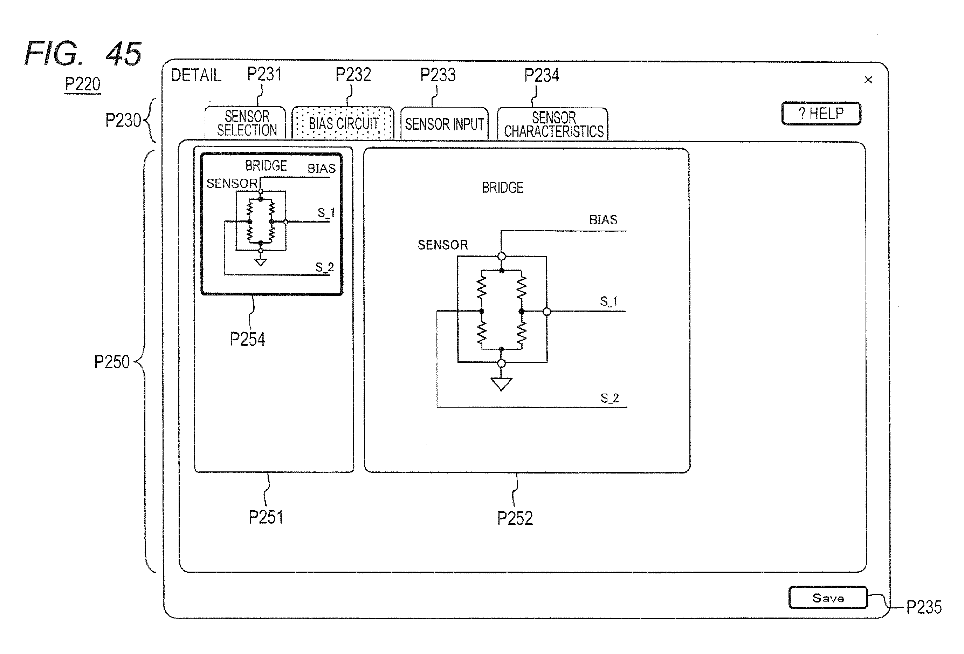

Fig. 45 is a diagram showing another example of the bias circuit selection screen P250 shown in Fig. 44. Fig. 45 is a display example of the bias circuit selection screen P250 in the case where a Wheatstone bridge type pressure sensor is selected as a sensor, and one bias circuit P254 is displayed on the schematic circuit list P251 as a bias circuit well-adapted to the pressure sensor. Because only one bias circuit P254 is displayed on the schematic circuit list P251, this bias circuit P254 is displayed on the selected circuit P252.

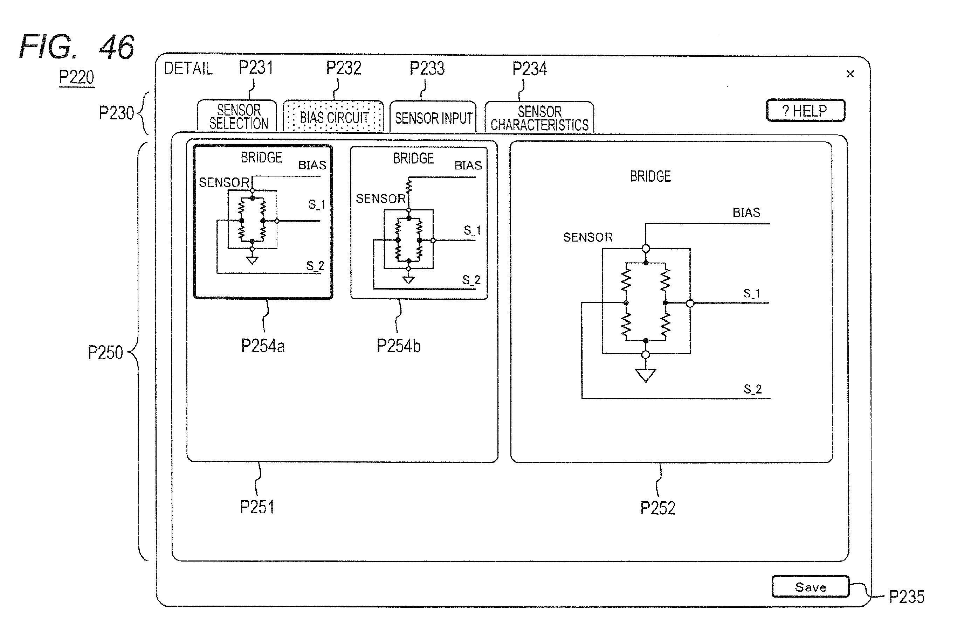

It is also conceivable that, in addition to the bias circuit P254 in Fig. 45, another bias circuit can be displayed on the schematic circuit list P251 as shown in Fig. 46 so that one of the two bias circuits may be selected. In the example shown in Fig. 46, the schematic circuit list P251, on which bias circuits P254a and P254b are displayed as Wheaststone bridge type pressure sensors, and the selected circuit P252, in which the selected bias circuit P254a is displayed, are displayed on the bias circuit selection screen P250.

The bias circuit P254a is a circuit that directly supplies a bias power supply to a voltage output type pressure sensor. In the bias circuit P254a, the upper edge of a Wheatstone bridge, which is a kind of pressure sensor, is supplied with the bias power supply, the lower edge is grounded, and the right edge and the left edge, which are output terminals of the sensor, are coupled to the input terminals of the semiconductor device 1. Because the bias circuit P254a is used for a sensor to which a bias is supplied from an external power supply and from which a voltage corresponding to a pressure is brought out, it is preferable that the configuration of the configurable amplifier 110 coupled to this sensor is that of an instrumentation amplifier. Therefore, if the bias circuit P254a is selected, the configuration of the configurable amplifier 110 is automatically configured to be the configuration of an instrumentation amplifier, and the bias circuit P254a is configured to be coupled to the instrumentation amplifier.

The bias circuit P254b is a circuit that supplies a bias power supply to a voltage output type pressure sensor via a resistor. In the bias circuit P254b, the upper edge of a Wheatstone bridge, which is a kind of pressure sensor, is supplied with the bias power supply via the resistor, the lower edge is grounded, and the right edge and the left edge, which are output terminals of the sensor, are coupled to the input terminals of the semiconductor device 1. Because the bias circuit P254b is used for a sensor to which a bias is supplied from an external power supply and from which a voltage corresponding to a pressure is brought out, it is preferable that the configurable amplifier 110 coupled to this sensor is an instrumentation amplifier. Therefore, if the bias circuit P254b is selected, the configuration of the configurable amplifier 110 is automatically configured to be that of an instrumentation amplifier, and the bias circuit P254b is configured to be coupled to the instrumentation amplifier.

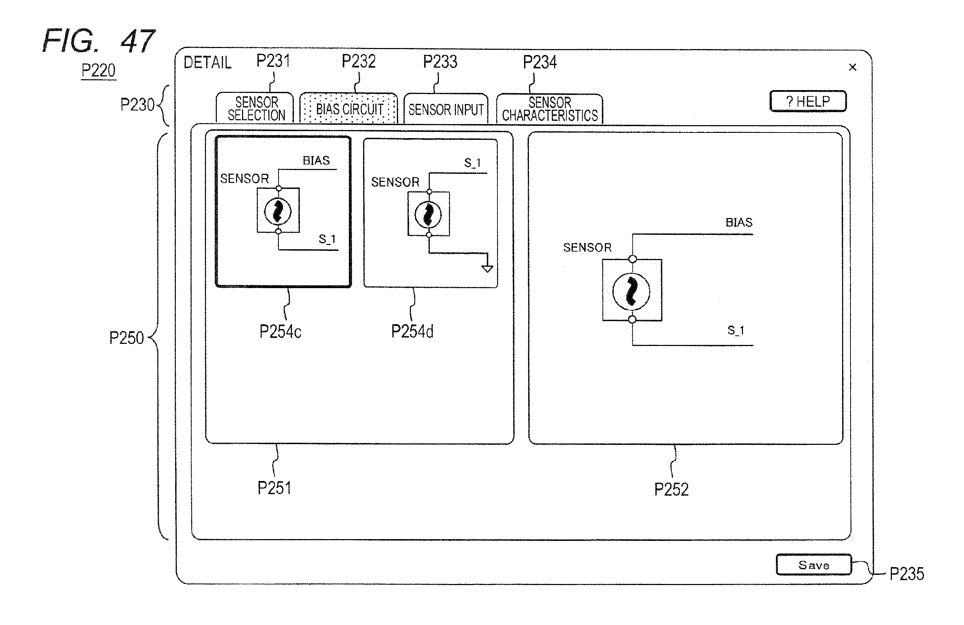

Fig. 47 is a diagram showing another example of the bias circuit selection screen P250 shown in Fig. 44. Fig. 47 is a display example of the bias circuit selection screen P250 in the case where a current transducer type pressure sensor is selected as a sensor, and bias circuits P254c and P254d are displayed on the schematic circuit list P251 as bias circuits well-adapted to the pressure sensor. The selected bias circuit P254c is displayed on the selected circuit P252.

The bias circuit P254c is a circuit that brings out a current as a detection signal from a current output type pressure sensor. In the bias circuit P254c, one edge of the pressure sensor is supplied with a bias power supply, and the other edge is a sensor output terminal, and is coupled to the input terminal of the semiconductor device 1. Because the bias circuit P254c does not supply a bias from the outside, and brings out an output signal as a current, it is preferable that the configuration of the configurable amplifier 110 coupled to this sensor is that of an IV amplifier. Therefore, if the bias circuit P254c is selected, the configuration of the configurable amplifier 110 is automatically configured to be the configuration of an IV amplifier, and the bias circuit P254c is configured to be coupled to the IV amplifier.

The bias circuit P254d is a circuit that draws a current as a detection signal into a current output type pressure sensor. In the bias circuit P254d, one edge of the pressure sensor is a sensor output terminal, and is coupled to the input terminal of the semiconductor device 1, and the other edge is grounded. Because the bias circuit P254d does not supply a bias from the outside, and brings out an output signal as a current, it is preferable that the configuration of the configurable amplifier 110 coupled to this sensor is that of an IV amplifier. Therefore, if the bias circuit P254d is selected, the configuration of the configurable amplifier 110 is automatically configured to be the configuration of an IV amplifier, and the bias circuit P254d is configured to be coupled to the IV amplifier.

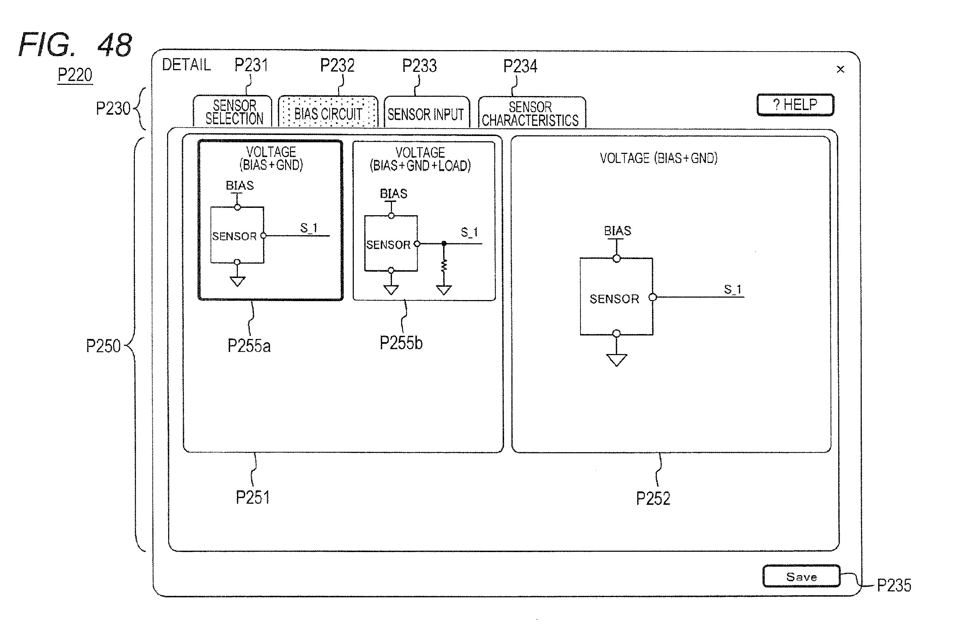

Fig. 48 is a diagram showing another example of the bias circuit selection screen P250 shown in Fig. 44. Fig. 48 is a display example of the bias circuit selection screen P250 in the case where a temperature sensor is selected as a sensor, and bias circuits P255a and P255b are displayed on the schematic circuit list P251 as bias circuits well-adapted to the temperature sensor. The selected bias circuit P255a is displayed on the selected circuit P252.

The bias circuit P255a is a circuit that supplies a bias power supply to a temperature sensor of voltage output type, and directly outputs an output signal. In the bias circuit P255a, one edge of the temperature sensor is supplied with a bias power supply, the other edge is grounded, and the output terminal of the temperature sensor is coupled only to the input terminal of the semiconductor device 1. For example, because the bias circuit P255a is used for a sensor to which a bias is supplied from an external power supply and from which a voltage corresponding to a temperature is brought out, it is preferable that the configuration of the configurable amplifier 110 coupled to this sensor is that of a noninverting amplifier. Therefore, if the bias circuit P255a is selected, the configuration of the configurable amplifier 110 is automatically configured to be the configuration of a noninverting amplifier, and the bias circuit P255a is configured to be coupled to the noninverting amplifier.

The bias circuit P255b is a circuit that supplies a bias power supply to a temperature sensor of voltage output type, and outputs an output signal via a ground resistor. In the bias circuit P255b, a bias power supply is supplied to one edge of the temperature sensor, the other edge is grounded, and the output terminal of the temperature sensor is coupled to the input terminal of the semiconductor device 1 and to the ground resistor as well. For example, because the bias circuit P255b is used for a sensor to which a bias is supplied from an external power supply and from which a voltage corresponding to a temperature is brought out, it is preferable that the configuration of the configurable amplifier 110 coupled to this sensor is that of a noninverting amplifier. Therefore, if the bias circuit P255b is selected, the configuration of the configurable amplifier 110 is automatically configured to be the configuration of a noninverting amplifier, and the bias circuit P255b is configured to be coupled to the noninverting amplifier. In addition, the bias circuit P255b is also used for a temperature sensor of current output type in a way that the current output of the sensor is converted into a voltage with the use of the ground resistor.

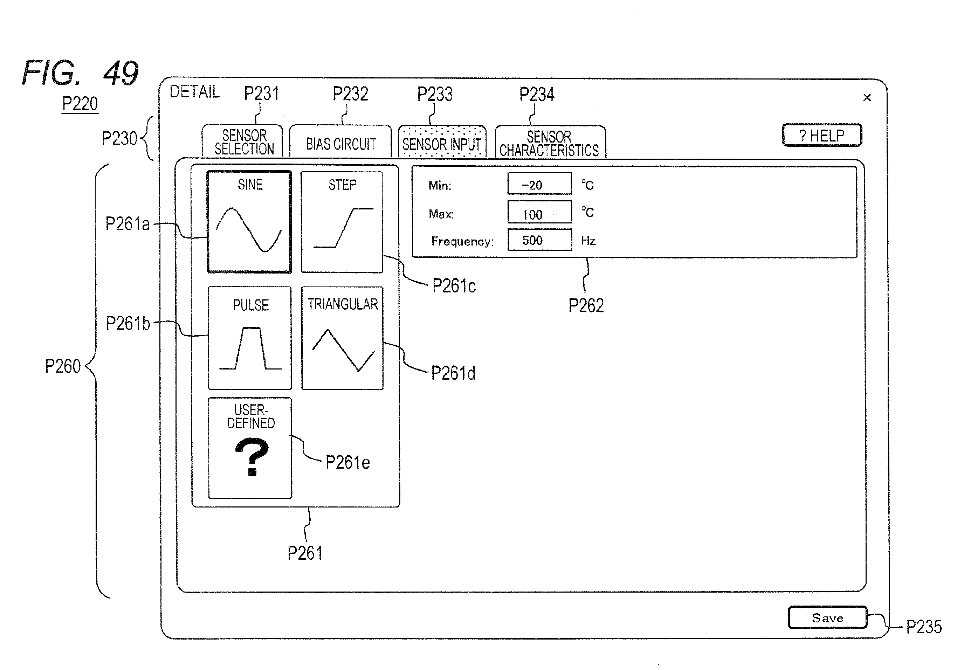

Fig. 49 is a diagram showing a display example of the physical quantity input screen shown at step S103 in Fig. 29. In the case where "Sensor Input" tab P233 is selected on the sensor detail screen P220 in Fig. 41 or in Fig. 44, a physical quantity input screen P260 is displayed on the sensor detail screen P220 as shown in Fig. 49.

An input pattern list P261 and an input parameter area P262 are displayed on the physical quantity input screen P260. Selectable patterns are displayed on the input pattern list P261 as the input patterns of physical quantities to be input to the sensor, and parameters used for configuring the selected input pattern in detail is displayed in the input parameter area P262. As described at step S104 in Fig. 29, the configured input pattern and parameters are stored in the parameter storage unit 427.

On the input pattern list P261, any of predefined input patterns P261a to P261d and "User-Defined" pattern P261e that is an input pattern a user arbitrarily defines can be selected. The predefined input patterns that can be selected are a sine wave, that is, "Sine" pattern P261a; a square wave, that is, "Pulse" pattern P261b; a step response wave, that is, "Step" pattern P261c; and a triangular wave, that is, "Triangular" pattern P261d.

In the input parameter area P262, a pattern selected on the input pattern list P261 and the parameters corresponding to the sensor selected on the sensor selection screen in Fig. 41 and the like are displayed. In an example shown in Fig. 49, a temperature sensor is selected as a sensor, and the sine wave, that is, "Sine" pattern P261a is selected as an input pattern. Because the input pattern is a sine wave, input boxes for the minimum value, the maximum value and a frequency are displayed in the input parameter area P262. Because the sensor is a temperature sensor, a unit of the minimum value and the maximum value is "°C".

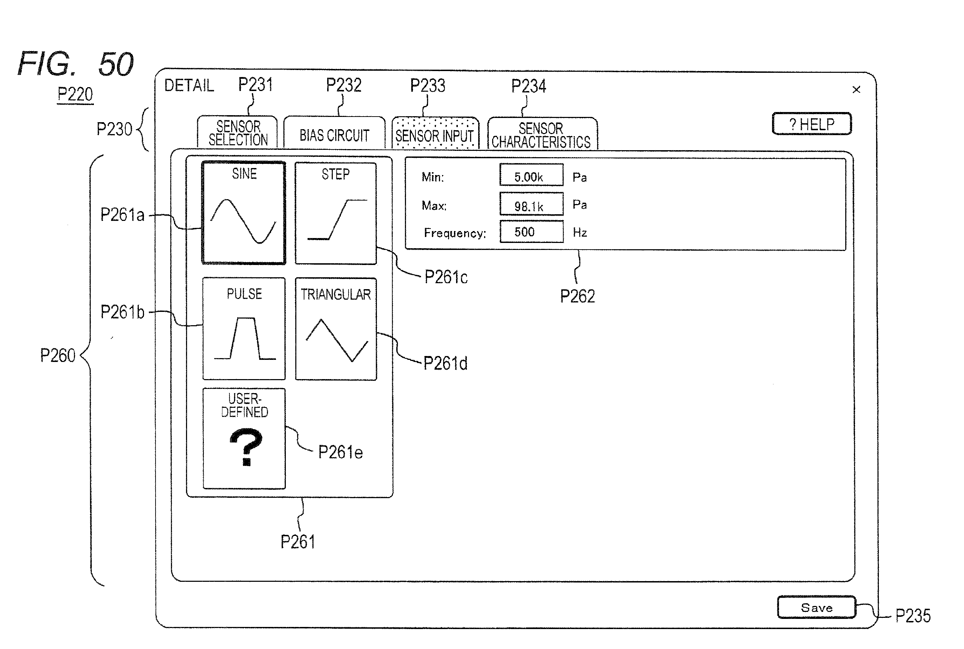

Fig. 50 is a diagram showing another example of the physical quantity input screen P260 shown in Fig. 49. In Fig. 50, a pressure sensor is selected as a sensor, and the sine wave, that is, "Sine" pattern P261a is selected as an input pattern. Because the input pattern is a sine wave, input boxes for the minimum value, the maximum value and a frequency are displayed in the input parameter area P262. Because the sensor is a pressure sensor, a unit of the minimum value and the maximum value is "Pa".

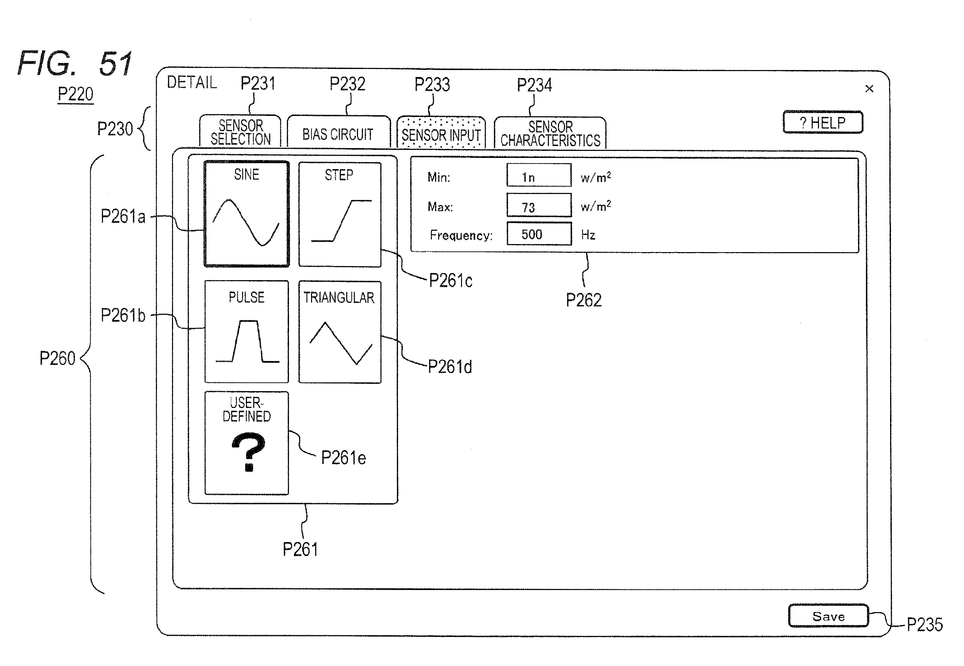

Fig. 51 is a diagram showing another example of the physical quantity input screen P260 shown in Fig. 49. In Fig. 51, a phototransistor is selected as a sensor, and the sine wave, that is, "Sine" pattern P261a is selected as an input pattern. Because the input pattern is a sine wave, input boxes for the minimum value, the maximum value and a frequency are displayed in the input parameter area P262. Because the sensor is a phototransistor, a unit of the minimum value and the maximum value is "W/m²".

In addition, because input parameters corresponding to the selected input pattern can be configured in the input parameter area P262, the pattern of each input waveform can be correctly specified. For example, if the input pattern is a sine wave, the minimum value, the maximum value, and a frequency are configured as described above. If the input pattern is a square wave, the minimum value, the maximum value, a rise speed, and a fall speed are configured. If the input pattern is a square wave, the minimum value, the maximum value, and a frequency are configured. If the input pattern is a step response, the minimum value, the maximum value, and a rise timing, and a rise speed are configured. In addition, default values can be displayed for the minimum value and the maximum value of the input parameters of selected sensor in accordance with the characteristics of the sensor. In other words, the minimum value and the maximum value that the sensor can detect are obtained with reference to the sensor database 421, and they are displayed. Therefore, a user does not need to check the characteristics of the sensor, and this can prevent the user from erroneously specifying the minimum value and the maximum value beyond the allowable input range for the characteristic of the sensor.

Plural input waveforms are displayed on the physical quantity input screen P260, and physical quantities to be input to a sensor can be selected from among predefined input waveforms, with the result that various characteristics of analog circuits can be easily analyzed. As some examples, the characteristics of the input waveforms that can be selectable in Fig. 51 will be described below.

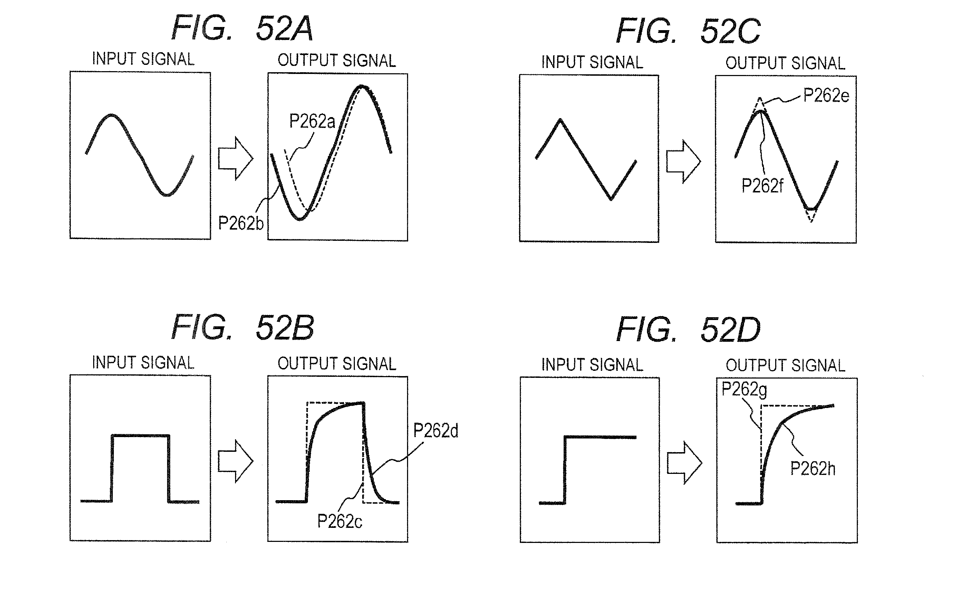

Fig. 52A is a diagram showing an input signal and an output signal used when an analog circuit (a semiconductor device 1) is simulated with the use of a sine wave input pattern. In the case where the input signal is a sine wave, by comparing an in-phase signal P262a having the same phase as that of the input signal with the output signal P262b resulting from the simulation, it becomes possible to optimally perform a rough check on the simulation results such as the presence or absence of distortion, the phase difference, and the like. In addition, it is also possible to check whether the waveform of the output signal is clipped or not. By displaying the above two waveforms superimposedly on the display screen of the simulation results as shown in Fig. 52A, the user can check the characteristics of the analog circuit in one glance.

In other words, with the use of a sine wave input pattern, the user can easily check the characteristic value at that frequency, which enables the user to appropriately configure the circuitry and characteristics of a configurable amplifier 110 in accordance with the checked result.

In addition, it is also possible that the simulation execution unit 415 detects the phase difference and the like using the simulation results, and automatically configures the circuitry and characteristics of the configurable amplifier 110 in accordance with the detected result. The simulation execution unit 415 executes a simulation on the configurable amplifier 110 into which the sine wave input pattern is input, and configures the number of coupling stages of the configurable amplifier 110 in accordance with the frequency characteristics shown by the simulation results. In the case where an appropriate amplifying function cannot be achieved at a necessary frequency, the simulation execution unit 415 configures the configurable amplifier 110 to be a multistage amplifier. For example, there is a case where, even if a 30 dB amplifying function is required at a sine wave frequency 100 kHz from a one-stage configurable amplifier 110, the one-stage configurable amplifier 110 cannot achieve that amplifying function. In this case, for example, by configuring the configurable amplifier 110 to be a two-stage amplifier, that is, by coupling amplifier AMP1 with its gain of 15 dB and amplifier AMP2 with its gain 15 dB, the desired frequency characteristic can be achieved.

Fig. 52B is a diagram showing an input signal and an output signal used when the analog circuit (the semiconductor device 1) is simulated with the use of a square wave input pattern. In the case where the input signal is a square wave, by comparing an in-phase signal P262c having the same phase as that of the input signal with the output signal P262d resulting from the simulation, it becomes possible to optimally check the response characteristic. By displaying the above two waveforms superimposedly on the display screen of the simulation results as shown in Fig. 52B, the user can check the response characteristic of the analog circuit in one glance.

In other words, with the use of a square wave input pattern, the user can easily check the response characteristic, which enables the user to appropriately configure the circuitry and characteristics of the configurable amplifier 110 in accordance with the checked result.

In addition, it is also possible that the simulation execution unit 415 detects the distortion, the delay of the signal and the like using the simulation results, and automatically configures the circuitry and characteristics of the configurable amplifier 110 in accordance with the detected result. The simulation execution unit 415 executes a simulation on the configurable amplifier 110 into which the square wave input pattern is input, and configures the operation mode of the configurable amplifier 110 in accordance with the response characteristic shown by the simulation results. In the case where the response characteristic is inadequate and the rise characteristic is distorted, the simulation execution unit 415 modifies the operation mode of the configurable amplifier 110. Because the operation mode and the power consumption are in a trade-off relation, it is necessary to select an optimal operation mode after checking the response characteristic with the use of the square wave. For example, if the configurable amplifier 110 is configured to be in a low-speed mode and a desired response characteristic is not attained, the desired response characteristic can be attained by configuring the operation mode of the configurable amplifier 110 to be a middle-speed mode or a high-speed mode.

Fig. 52C is a diagram showing an input signal and an output signal used when the analog circuit (the semiconductor device 1) is simulated with the use of a triangular wave input pattern. In the case where the input signal is a triangular wave, by comparing an in-phase signal P262e having the same phase as that of the input signal with the output signal P262f resulting from the simulation, it becomes possible to optimally check the presence or absence of the output signal clipped by the power supply. By displaying the above two waveforms superimposedly on the display screen of the simulation results as shown in Fig. 52C, the user can check the clipped state in one glance.

In other words, with the use of a triangular wave input pattern, the user can easily check whether the offset and gain of the amplifier is adequate or not. In addition, the user can easily check the clipped state of the output signal, which enables the user to appropriately configure the circuitry and characteristics of the configurable amplifier 110 in accordance with the checked result.

In addition, it is also possible that the simulation execution unit 415 detects the maximum value and minimum value of the clopped signal using the simulation result, and automatically configures the circuitry and characteristics of the configurable amplifier 110 in accordance with the detected result. The simulation execution unit 415 executes a simulation on the configurable amplifier 110 into which the triangular wave input pattern is input, and configures the offset and gain of the configurable amplifier 110 in accordance with the clipped state shown by the simulation results. In the case where either of the upper part or the lower part of the waveform of the output signal is clipped, the simulation execution unit 415 modifies the offset value of the configurable amplifier 110, with the result that the output signal within the desired range can be obtained. In the case where both upper part and lower part of the waveform of the output signal are clipped, the gain of the configurable amplifier 110 is too large; therefore, the output signal within the desired range can be obtained by lowering the gain of the amplifier.

Fig. 52D is a diagram showing an input signal and an output signal used when the analog circuit (the semiconductor device 1) is simulated with the use of a step response wave input pattern. In the case where the input signal is a step response wave, by comparing an in-phase signal P262g having the same phase as that of the input signal with the output signal P262h resulting from the simulation, it becomes possible to optimally check the response characteristic. By displaying the above two waveforms superimposedly on the display screen of the simulation results as shown in Fig. 52D, the user can check the response characteristic in one glance.

In other words, with the use of a step response wave input pattern, the user can easily check the response characteristic without the need for taking the pulse width into consideration although it is not possible to check both a rise speed and a fall speed at the same time. In addition, a response just after the power supply is turned on can be checked with the use of a step response wave. In addition, with the use of a step response wave input pattern, the user can easily check the response characteristic, which enables the user to appropriately configure the circuitry and characteristics of the configurable amplifier 110 in accordance with the checked result. In addition, it is also possible that the simulation execution unit 415 detects the distortion, the delay of the signal and the like using the simulation results, and automatically configures the circuitry and characteristics of the configurable amplifier 110 in accordance with the detected result.

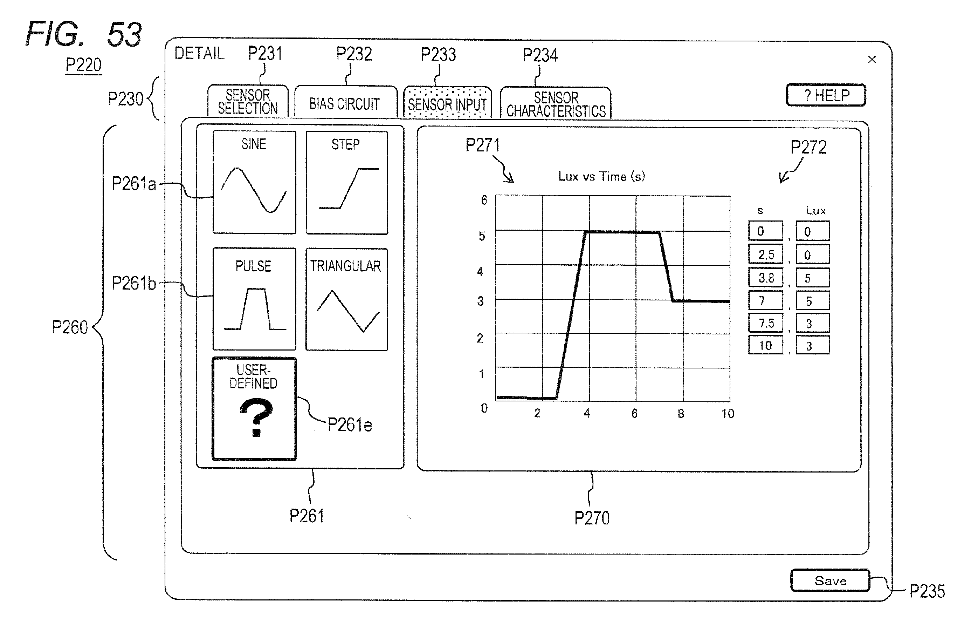

Fig. 53 is a diagram showing a display example of the physical quantity input screen P260 shown in Fig. 49 in which "User-Defined" pattern P261e is selected. When "User-Defined" pattern P261e is selected, the user definition input area P270 is displayed on the physical quantity input screen P260 instead of the input parameter area P262 n Fig. 40 as shown in Fig. 53.

An input pattern graph P271 and a plot input area P272, both of which are corresponding to the selected sensor, are displayed in the user definition input area P270. On the input pattern graph P271, an input pattern is created by designating the plotting points of a graph by clicking or dragging operations. In the plot input area P272, an input pattern is created by designating the plotting points of a graph by inputting numerical values. In addition, the number of plotting points of the input pattern graph can arbitrarily be incremented with the use of a plotting point number addition button (not shown).

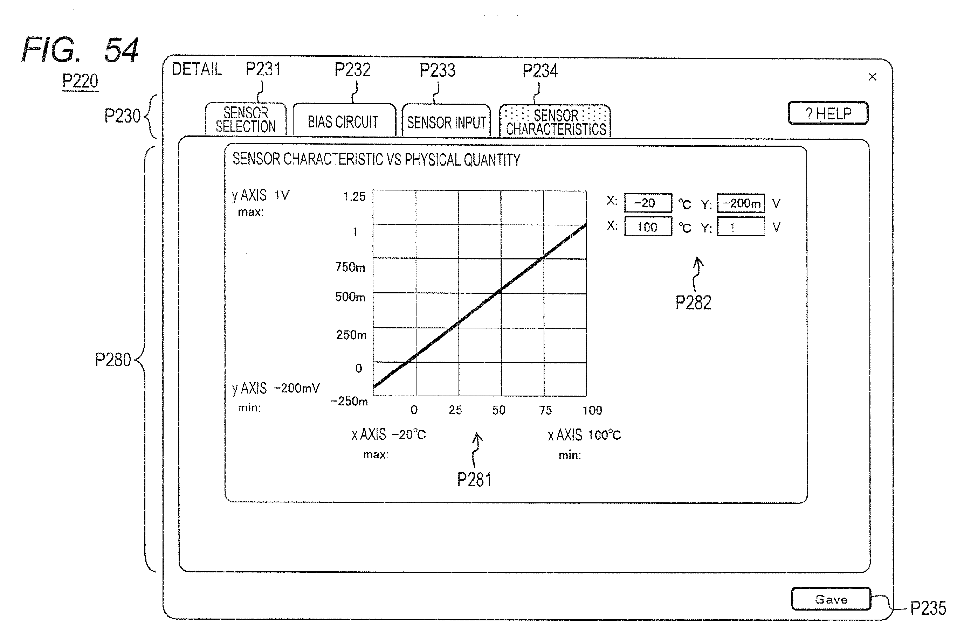

Fig. 54 is a diagram showing a display example of a sensor characteristics screen P280 that is displayed when "Sensor Characteristics" tab P234 is selected on the sensor detail screen P220 shown in Fig. 41, Fig. 44, Fig. 49, or the like. A characteristic graph P281 and a characteristic range P282 are displayed on the sensor characteristics screen P280. The characteristics of the sensor selected in Fig. 41 and the like are displayed on the characteristic graph P281 and in the characteristic range P282. On the basis of the data sheet of the selected sensor, the input and output characteristics of the sensor vs. a physical quantity is displayed on the characteristic graph P281, and the operational range of the sensor is displayed in the characteristic range P282.

An example shown in Fig. 54 is a display example of the sensor characteristics screen P280 in the case where a temperature sensor is selected as a sensor. On the characteristic graph P281, the x axis represents the detected temperature of the sensor, the y axis represents the output voltage of the sensor, and the characteristic of the output voltage vs. the detected temperature is displayed. The temperature range and the output voltage range that are the same as those shown by the graph on the characteristic graph P281 are displayed in the characteristic range P282.

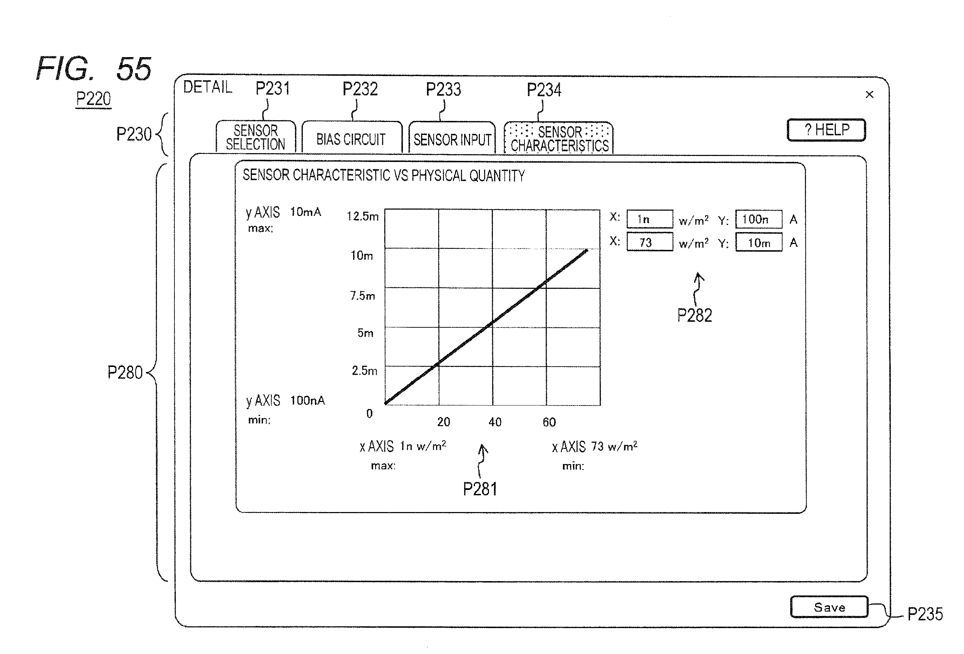

Fig. 55 is another example of the sensor characteristics screen P280 shown in Fig. 54. Fig. 55 is a diagram showing a display example of the sensor characteristics screen in the case where a phototransistor is selected as a sensor. On the characteristic graph P281, the x axis represents the detected illuminance, the y axis represents the output current, and the characteristic of the output current vs. the detected illuminance is displayed. The illuminance range and the output current range that are the same as those shown by the graph on the characteristic graph P281 are displayed in the characteristic range P282.

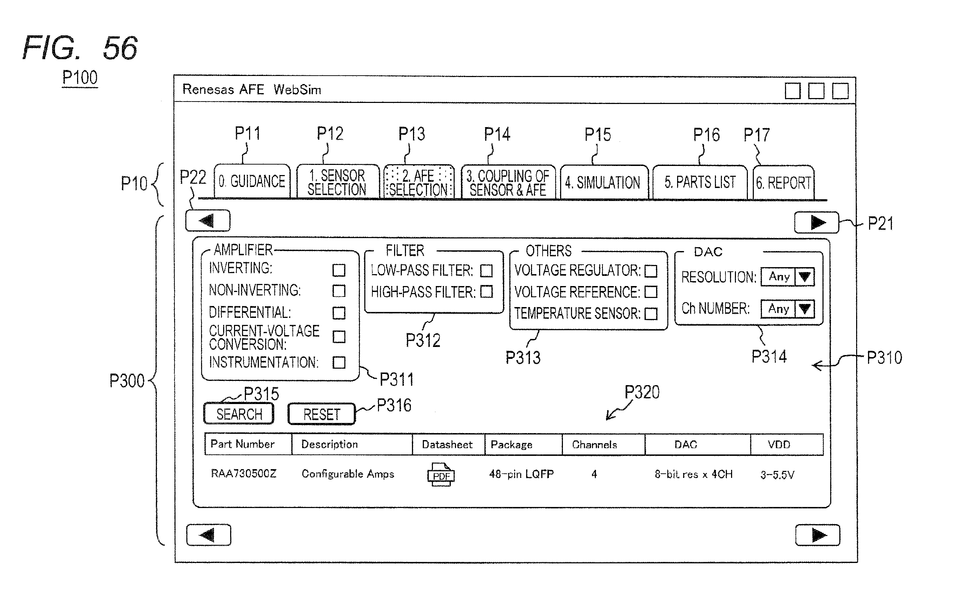

Fig. 56 is a display example of the AFE selection screen shown at the step S105 in Fig. 29. When "AFE Selection" tab P13 is selected on the web simulator screen P100 in Fig. 38, Fig. 39, or the like, the AFE selection screen P300 is displayed as shown in Fig. 56.

An AFE narrowing-down condition P310 is displayed on the upper part of the AFE selection screen P300, and a AFE list P320 is displayed on the lower part. On the AFE narrowing-down condition P310, conditions used for further narrowing-down the semiconductor devices 1, which are specified by the selected sensor and the bias circuit, is displayed.

In Fig. 56, the AFE narrowing-down condition P310 includes "Amplifier" area P311; "Filter" area P312; "Others" area P313; "DAC" area P314. "Amplifier" area P311 includes "Inverting" check box used for making an inverting amplifier a search condition; "Noninverting" check box used for making a noninverting amplifier a search condition; "Differential" check box used for making a differential amplifier a search condition; "IV" check box used for making a IV amplifier a search condition; and "Instrumentation" check box used for making an instrumentation amplifier a search condition. In "Amplifier" area P311, a check box corresponding to a search condition is checked by being clicked in order to search a semiconductor device 1 on the basis of the circuitry of the configurable amplifier 110 of the semiconductor device 1.

"Filter" area P312 includes "Low-pass Filter" check box used for making a low-pass filter a search condition, and "High-pass Filter" check box used for making a high-pass filter a search condition. In the "Filter" area P312, a check box corresponding to a search condition is checked by being clicked in order to search a semiconductor device 1 on the basis of the circuitry of the filter of the semiconductor device 1.

"Others" area P313 includes "Voltage Regulator" check box used for making a voltage regulator (a variable regulator 150) a search condition; "Voltage Reference" check box used for making a voltage reference a search condition; and "Temperature Sensor" check box used for making a temperature reference a search condition. In the "Others" area P313, a check box corresponding to a search condition is checked by being clicked in order to search a semiconductor device 1 on the basis of the circuitry of the voltage regulator or the like.

"DAC" area P314 includes "Resolution" pull-down menu and "Ch Number" pull-down menu of the DAC. At "Resolution" pull-down menu, a specified bit number for making a semiconductor device 1 with the specified bit number resolution a search target is designated, or "Any" for making a semiconductor device 1 with any bit number resolution a search target is designated. At "Channel Number" pull-down menu, a specified channel number for making a semiconductor device 1 with the specified channel number a search target is designated, or "Any" for making a semiconductor device 1 with any channel number a search target is designated.

"Search" button P315 and "Reset" button P316 are displayed between the narrowing-down condition P310 and the AFE list P320. When the "Search" button P315 is clicked, a search of the AFE database is performed on the basis of the condition configured in the narrowing-down condition P310, and the search result is displayed on the AFE list P320. If "Reset" button P316 is clicked, the narrowing-down conditions (search conditions) configured in the narrowing-down condition P310 are reset, and the screen becomes in the initial state where nothing is configured for the AFE search.

On the AFE list P244, the list of semiconductor devices 1 that are well-adapted to the selected sensor and bias circuit and also meet the condition configured in the narrowing-down condition P310 is displayed. As described at step S106 in Fig. 29, if a sensor and a bias circuit are selected in Fig. 41, Fig. 49, or the like, semiconductor devices 1 that can be coupled to the sensor are determined. Semiconductor devices 1 that can be coupled to the sensor, and also meet the configured narrowing-down condition are displayed from among semiconductor devices 1 stored in the AFE database 424.

On the AFE list P320, plural pieces of information about individual semiconductor devices 1 are displayed in plural columns. In Fig. 56, there are seven columns: Part Number; Description; Datasheet; Package; Channels; DAC; and VDD in which the part number, the description, the data sheet, the package type, the channel number, the DAC configuration, and the power voltage for each semiconductor device 1 are respectively displayed. In Datasheet column, a PDF icon is displayed, and when the PDF icon is clicked, a PDF file including data sheets is displayed.

Because the semiconductor devices 1, which are well-adapted to the sensor and bias circuit, and also meet the narrowing-down condition, are displayed on the AFE list P320, a desired semiconductor device 1 can be selected by a simple operation. The user selects an AFE to be used from the AFE list P320 on the basis of the displayed information. If an AFE is selected from the AFE list P320 as shown at step S105 in Fig. 29, the circuit information of the corresponding semiconductor device 1 is stored in the circuit information storage unit 426.

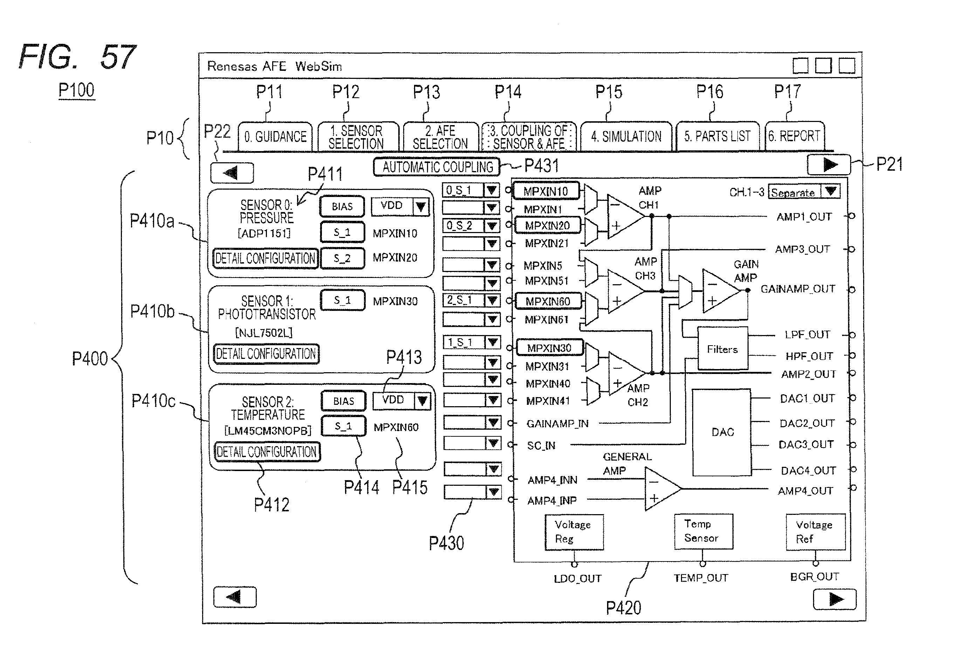

Fig. 57 is a diagram showing a display example of the sensor AFE coupling screen displayed at step S107 in Fig. 29. When "Sensor AFE Coupling" tab P14 is selected on the web simulator screen P100 in Fig. 38, Fig. 39, Fig. 56, or the like, the sensor AFE coupling screen P400 is displayed as shown in Fig. 57.

Sensor selection frames P410a to P410c showing the configuration states of a sensor and a bias circuit for each sensor are displayed on the left side of the sensor AFE coupling screen P400. The sensor selection frames P410a to P410c are corresponding to the sensor selection frame P210 shown in Fig. 39 and the sensor selection frames P210a to P210c shown in Fig. 40, and includes information about bias circuits in addition to what are displayed in the sensor selection frames P210, and P210a to P210c. In Fig. 57, as is the case with the sensor selection frame P210 in Fig. 40, a sensor selection frame P410a in which a pressure sensor is selected, a sensor selection frame P410b in which a phototransistor is selected, and a sensor selection frame P410c in which a temperature sensor is selected are displayed.

To put it concretely, in the sensor selection frames P410a to P410c, as is the case with the sensor selection frames P210a to P210c in Fig. 40, sensor name display areas P411 including the sensor types and the part numbers of selected sensors are displayed and "Detail Configuration" buttons P412 are also displayed.

In addition, bias pull-down menus P413 used for configuring biases are displayed in the sensor selection frames P410a to P410c. For example, in the bias pull-down menus P413, lists of bias supply methods corresponding to the selected bias circuits are displayed, so that the supply methods of VDD and GND can be selected. In addition, in the sensor selection frames P410a to P410c, output signal displays P414, in each of which an output signal corresponding to a selected bias circuit is displayed, and an input terminal display P415, in each of which an input terminal of the semiconductor device 1 is displayed, are displayed in conjunction with the coupling relations.

In the sensor AFE coupling screen P400, a semiconductor device image P420 that shows the image of the circuitry of the semiconductor device 1 is displayed to the right side of the sensor selection frames P410a to P410c, and input terminal pull-down menus P430 are respectively displayed in the positions corresponding to the input terminals of the semiconductor device image P420.

The semiconductor device image P420 shows the coupling relations between the I/O terminals of the semiconductor device 1 and individual circuits inside the semiconductor device 1. The semiconductor device image P420 is displayed in accordance with the coupling relations of the actual semiconductor device 1 as described in Fig. 3.

The input terminal pull-down menus P430 displays output signals of sensors and bias circuits to be coupled to respective input terminals. By clicking an input terminal pull-down menu P430, the output signal of a sensor corresponding to the input terminal can be selected. In addition, by dragging an icon of the output signal display P414 of a sensor to an input terminal pull-down menu P430 corresponding to an input terminal, the coupling relation between the output signal of the sensor and the input terminal can be established. As described at step S107 in Fig. 29, when the coupling relation between a sensor and the semiconductor device 1 is selected with the use of the input terminal pull-down menu P430, the circuit information about the selected coupling relation is stored in the circuit information storage unit 426.

In addition, as described at step S106 in Fig. 29, when a sensor and a bias circuit are selected, the circuitry and coupling relation of the configurable amplifier 110 are determined. In the sensor AFE coupling screen P400 in Fig. 57, the coupling relation determined at step S106 is displayed by default.

In addition, over the input terminal pull-down menu P430, "Automatic Coupling" button P431 used for automatically coupling sensors to the semiconductor device 1 is displayed. By clicking "Automatic Coupling" button P431 after modifying the configuration of a sensor using "Detail Configuration" button P412 of any of the sensor selection frames P410a to P410c, the sensor and the semiconductor device 1 are newly and automatically coupled in accordance with the modified configuration of the sensor.

The coupling relation of the example shown in Fig. 57 will be described below. A sensor 0 shown in the sensor selection frame P410a has two outputs depending on the selection way of the pressure sensor and the corresponding bias circuit, and these two outputs and an amplifier of the configurable amplifier 110 are automatically coupled. To put it concretely, the output signal (the output terminal) S_1 of the sensor 0 is coupled to input terminal MPXIN10 of the semiconductor device 1, and _the output signal (output terminal) S_2 of the sensor 0 is coupled to input terminal MPXIN20 of the semiconductor device 1. In the semiconductor device 1, MPXIN10 and MPXIN20 are respectively coupled to the inverting input terminal and the noninverting input terminal of AMP CH1 (amplifier AMP1 of the configurable amplifier 110). In other words, the output signal S_1 and S_2 of the sensor 0 are amplified by AMP CH1 of the semiconductor device 1, and output from output terminal AMP1_OUT.

A sensor 1 shown in the sensor selection frame P410b has one output depending on the selection way of the phototransistor and the corresponding bias circuit, and this one output and an amplifier of the configurable amplifier 110 are automatically coupled. To put it concretely, the output signal (the output terminal) S_1 of the sensor 1 is coupled to input terminal MPXIN30 of the semiconductor device 1. In the semiconductor device 1, MPXIN30 is coupled to the inverting input terminal of AMP CH2 (amplifier AMP2 of the configurable amplifier 110). In other words, the output signal S_1 of the sensor 1 is amplified by AMP CH2 of the semiconductor device 1, and output from output terminal AMP2_OUT.

A sensor 2 shown in the sensor selection frame P410c has one output depending on the selection way of the temperature sensor and the corresponding bias circuit, and this one output and an amplifier of the configurable amplifier 110 are automatically coupled. To put it concretely, the output signal (the output terminal) S_1 of the sensor 2 is coupled to input terminal MPXIN60 of the semiconductor device 1. In the semiconductor device 1, MPXIN60 is coupled to the noninverting input terminal of AMP CH3 (amplifier AMP3 of the configurable amplifier 110). In other words, the output signal S_1 of the sensor 2 is amplified by AMP CH3 of the semiconductor device 1, and output from output terminal AMP3_OUT.

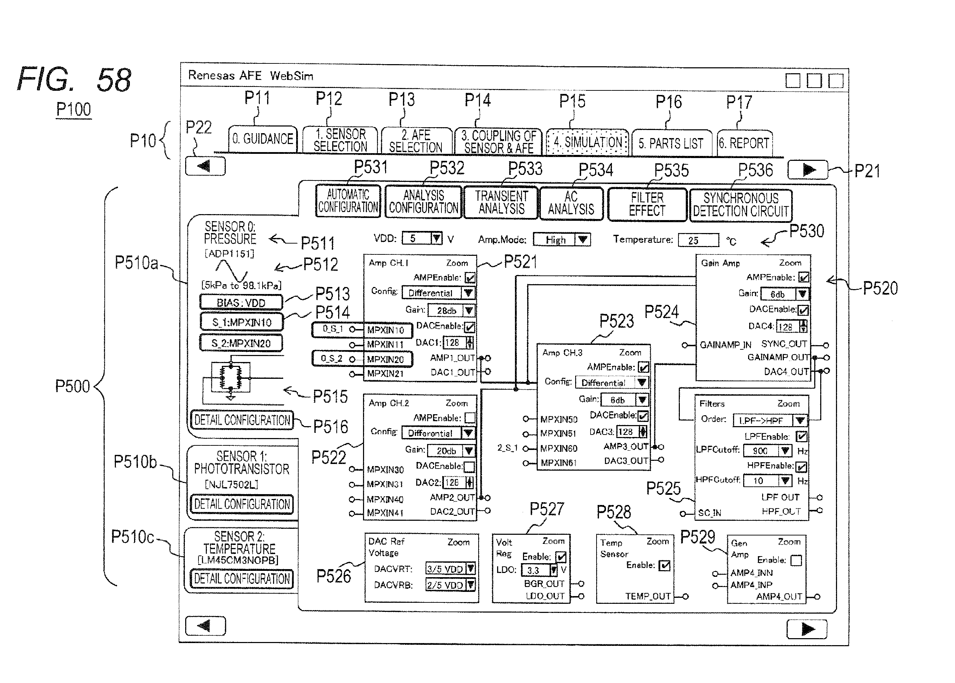

Fig. 58 is a diagram showing a display example of the simulation screen displayed at step S201 in Fig. 30. When "Simulation" tab P15 is selected on the web simulator screen P100 in Fig. 38, Fig. 39, Fig. 56, Fig. 57, or the like, a simulation screen P500 is displayed as shown in Fig. 58. The simulation screen P500 includes displays used for various configurations for executing simulations and displays in which the results of the simulations are displayed. Fig. 58 is a diagram showing the state of the simulation screen P500 before any simulation is executed.

Sensor selection frames P510a to P510c, each of which includes the configuration states of a sensor, a bias circuit, and an input pattern for each sensor, are displayed on the left side of the simulation screen P500. The sensor selection frames P510a to P510c are corresponding to the sensor selection frames P410a to P410c shown in Fig. 57, and includes information about input patterns in addition to what are displayed in the sensor selection frames P410a to P410c. In Fig. 58, as is the case with the sensor selection frame in Fig. 57, a sensor selection frame P510a in which a pressure sensor is selected, a sensor selection frame P510b in which a phototransistor is selected, and a sensor selection frame P510c in which a temperature sensor is selected are displayed.

To put it concretely, in the sensor selection frames P510a to P510c, as is the case with the sensor selection frames P410a to P410c in Fig. 57, sensor name display areas P511 including the sensor types and the part numbers of selected sensors, bias supply methods P513, the coupling relations between output signals and input terminals P514, and "Detail Configuration" buttons P516 are displayed. In addition, input waveform images P512 that show the input pattern images of the configured physical quantities and bias circuit images P515 that show circuit images of the configured bias circuits are displayed in the sensor selection frames P510a to 510c.

In the simulation screen P500, semiconductor device configuration areas P520, in each of which each circuit of the semiconductor device 1 is configured, are displayed to the right sides of the sensor selection frames P510a to P510c. Circuit blocks corresponding to the circuitry of the semiconductor device 1 are displayed in the semiconductor device configuration area P520.

Amplifier blocks P521 to P523 respectively display configuration menus used for configuring amplifiers AMP1 CH1 to AMP3 CH3 of the configurable amplifier 110 of the semiconductor device 1. In each of the amplifier blocks P521 to P523, the corresponding amplifier is turned on-off by checking "AMP Enable" check box; the circuitry of the amplifier is configured with the use of "Config" pull-down menu; the gain of the amplifier is configured with the use of "Gain" pull-down menu; the on-off operation of the corresponding DAC is set with the use of "DAC Enable" check box; and the output voltage of the DAC is configured with the use of "DAC" pull-down menu.

For example, if "Differential" is selected at "Config" pull-down menu, the amplifier is configured to be a differential amplifier; if "Inverting" is selected at "Config" pull-down menu, the amplifier is configured to be an inverting amplifier; if "Noninverting" is selected at "Config" pull-down menu, the amplifier is configured to be a noninverting amplifier; and if "I/V" is selected at "Config" pull-down menu, the amplifier is configured to be an I/V amplifier. In addition, as described in Fig. 31, the gain and offset of the amplifier are automatically configured on the basis of the selected amplifier and bias circuit. In the amplifier blocks P521 to P523, gains and DAC output voltages that are automatically configured through automatic configuration processing are displayed by default.

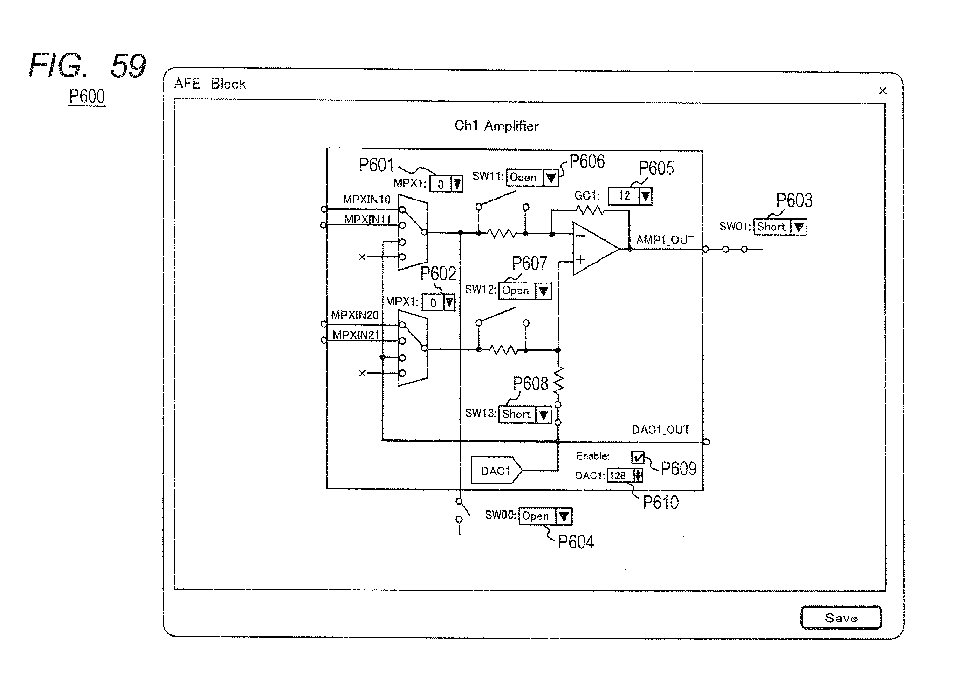

In addition, by clicking "Zoom" in each of the amplifier blocks P521 to P523, various configurations can be made with reference to the block diagram of the corresponding amplifier. To put it concretely, an amplifier configuration screen P600 is displayed in a pop-up manner as shown in Fig. 59. On the amplifier configuration screen P600, a circuit image that is the same as an actual amplifier of the semiconductor device 1 is displayed. For example, the circuitry of the amplifier shown in Fig. 8 is displayed on the amplifier configuration screen P600.

On the amplifier configuration screen P600, the coupling destinations of the inputs and outputs of the amplifier are configured with the use of pull-down menus P601 to P604; the gain of the amplifier is configured with the use of a pull-down menu P605; the presence or absence of input resistances and the coupling of a DAC to the amplifier are respectively configured with the use of pull-down menus P606 to P608; and the on-off operation of the DAC and the output voltage of the DAC are respectively configured with the use of a check box P609 and a pull-down menu P610.

A gain amplifier block P524 in Fig. 58 shows a configuration menu used for configuring the gain amplifier 120 of the semiconductor device 1. In the gain amplifier block P524, as is the case with any of the amplifier blocks P521 to P523, the amplifier is configured. In the gain amplifier block P524, the amplifier is turned on-off by checking "AMP Enable" check box; the gain of the amplifier is configured with the use of "Gain" pull-down menu; the on-off operation of the DAC is configured by checking "DAC Enable" check box; and the output voltage of the DAC is configured with the use of "DAC" pull-down menu.

A Filter block P525 shows a configuration menu used for configuring the low-pass filter 130 and the high-pass filter 140 of the semiconductor device 1. In the filter block P525, an order in which the low-pass filter and the high-pass filter are located in the filter circuit is configured with the use of "Order" pull-down menu; the on-off operation of the low-pass filter is configured by checking "LPF Enable" check box; the cut-off frequency of the low-pass filter is configured with the use of "LPF Cutoff" pull-down menu; the on-off operation of the high-pass filter is configured by checking "HPF Enable" check box; and the cut-off frequency of the high-pass filter is configured with the use of "HPF Cutoff" pull-down menu.

For example, if "LPF" is selected at "Order" pull-down menu, the circuitry of the filter circuit is configured so that signals pass only the low-pass filter; if "HPF" is selected at "Order" pull-down menu, the circuitry of the filter circuit is configured so that signals pass only the high-pass filter; if "LPF→HPF" is selected at "Order" pull-down menu, the circuitry of the filter circuit is configured so that signals pass the low-pass filter and the high-pass filter in this order; and if "HPF→LPF" is selected at "Order" pull-down menu, the circuitry of the filter circuit is configured so that signals pass the high-pass filter and the low-pass filter in this order.

A DAC block P526 shows a configuration menu used for configuring the reference voltages of DACs that are coupled to the amplifiers. In the DAC block P526, the upper limit of the configured voltage of a DAC is configured with the use of "DACVRT" pull-down menu, and the lower limit of the configured voltage of the DAC is configured with the use of "DACVRB" pull-down menu.

A variable regulator block P527 shows a configuration menu used for configuring the variable regulator 150 of the semiconductor device 1. In the variable regulator block P527, the on-off operation of the variable regulator is configured by clicking "Enable" check box, and the output voltage of the variable regulator is configured with the use of "LDO" pull-down menu.

A temperature sensor block P528 shows a configuration menu used for configuring the temperature sensor 160 of the semiconductor device 1. In the temperature sensor block P528, the on-off operation of the temperature sensor is configured by clicking "Enable" check box. A general-purpose amplifier block P529 shows a configuring menu used for configuring the general-purpose amplifier 170 of the semiconductor device 1. In the general-purpose amplifier block P529, the on-off operation of the general-purpose amplifier is configured by clicking "Enable" check box.

In the upper part of the semiconductor configuration area P520, a common configuration area P530 that is used in common for various circuits is displayed. In the common configuration area P530, the power supply voltage can be configured with the use of "VDD" pull-down menu; the amplifier mode can be configured with the use of "Amp Mode" pull-down menu; and the temperature of the semiconductor device 1 can be configured with the use of "Temperature" input box. In "Amp Mode" pull-down menu, the amplifier operation mode becomes a high-speed mode by selecting "High", and the amplifier operation mode becomes a low-speed mode by selecting "Low".

Over the common configuration area P530, there are buttons P531 to P536 used for executing simulation. "Auto Configuration" button P531 is a button used for executing the automatic configuration processing shown in Fig. 31. In the case where the configuration of sensors are modified with the use of "Detail Configuration" buttons P516 of the sensor selection frames P510a to 510c, the gains and offsets of the corresponding amplifiers are adjusted on the basis of the circuitries of the sensors whose configurations are modified by clicking "Auto Configuration" button P531, and the gains of the amplifiers and the output voltages of the corresponding DACs are automatically configured.

"Analysis Configuration" button P532 is used for inputting simulation parameters in step S203 in Fig. 30. For example, when "Analysis Configuration" button P532 is clicked, a list of configurable parameters is displayed in a pop-up manner, and any of the parameters can be set. As described at step S203 in Fig. 30, the set parameter can be stored in the parameter storage unit 427.

"Transient Analysis" button P533 is used for performing transient analysis processing described in Fig. 34. When "Transient Analysis" button P533 is clicked, the operation of the semiconductor device 1, to which a physical quantity is input in a time-series order, is simulated with the configured circuit information and parameters as simulation conditions as described in Fig. 34, and the simulation results are displayed on the simulation screen P500.

"AC Analysis" button P534 is used for performing AC analysis processing described in Fig. 35. When "AC Analysis" button P534 is clicked, the operation of the semiconductor device 1, to which a physical quantity is input for each frequency, is simulated with the configured circuit information and parameters as simulation conditions as described in Fig. 35, and the simulation results are displayed on the simulation screen P500.

"Filter Effect" button P535 is used for performing filter effect analysis processing described in Fig. 36. When "Filter Effect" button P535 is clicked, the operation of the semiconductor device 1, to which a noise-added physical quantity is input, is simulated with the configured circuit information and parameters as simulation conditions as described in Fig. 36, and the simulation results are displayed on the simulation screen P500.

"Synchronous Detection Circuit" button P536 is used for performing synchronous detection analysis processing described in Fig. 37. When "Synchronous Detection Circuit" button P536 is clicked, the operation of the semiconductor device 1, to which a physical quantity and a synchronous signal are input, is simulated with the configured circuit information and parameters as simulation conditions as described in Fig. 37, and the simulation results are displayed on the simulation screen P500.

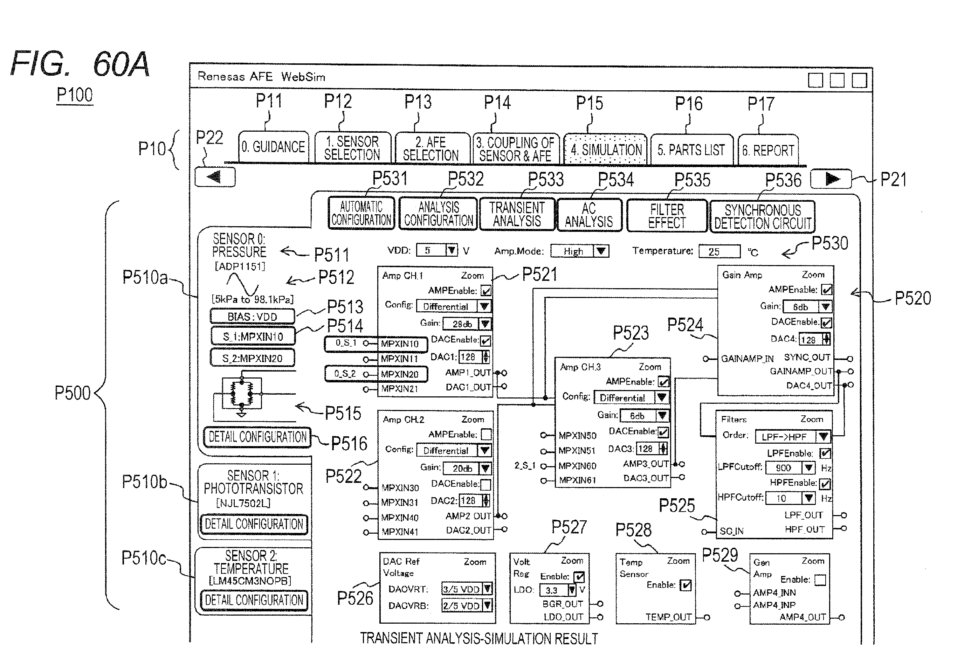

Fig. 60A to Fig. 60C are display examples that show the simulation screen P500 in which transient analysis results are additionally displayed. Here, Fig. 60A to Fig. 60C are parts of the simulation screen P500 that are to be displayed continuously in this order. In other words, the entirety of the simulation screen P500 is divided into three parts for convenience of display.

After the transient analysis is executed by clicking "Transient Analysis" button P533, a transient analysis result display area P700 is displayed under the semiconductor device configuration area P520 on the simulation screen P500 as shown in Fig. 60A to Fig. 60C.

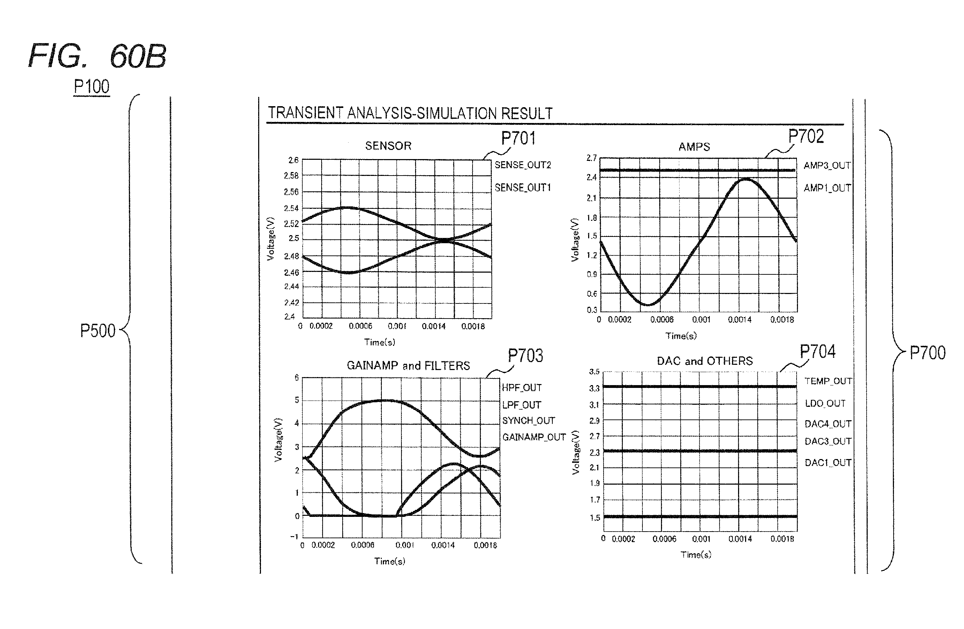

In the transient analysis result display area P700, plural signal waves of simulation results are displayed in a lot on each of result graphs P701 to P705. The result graph P701 displays the wave forms of the output signals of sensors in a lot. The output signals SENSE_OUT1 and SENSE_OUT2 (the output signals S_1 and S_2 of the sensor 0) are displayed in the result graph P701 in Fig. 60B.

The result graph P702 displays the wave forms of the output signals of amplifiers in a lot. AMP3_OUT and AMP1_OUT (the output signals of AMP CH3 and AMP CH1) are displayed in the result graph P702 in Fig. 60B.

The result graph P703 displays the wave forms of the output signals of the gain amplifier and the filters in a lot. HPF_OUT (the output signal of the high-pass filter), LPF_OUT (the output signal of the low-pass filter), SYNCH_OUT (the output signal of the synchronous detection circuit), and GAINAMP_OUT (the output signal of the gain amplifier) are displayed in the result graph P703 in Fig. 60B.

The result graph P704 displays the wave forms of the output signals of the DAC and others in a lot. TEMP_OUT (the output signal of the temperature sensor), LDO_OUT (the output signal of the power regulator), and DAC4_OUT, DAC3_OUT, DAC1_OUT (the output signals of the DAC4, DAC3, and DAC1) are displayed in the result graph P704 in Fig. 60B.

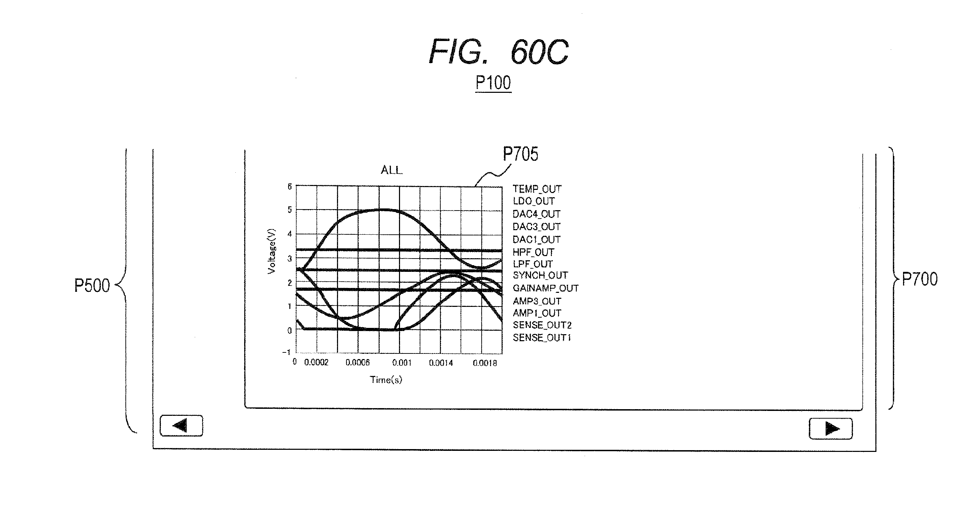

The result graph P705 displays the wave forms of all the output signals in a lot. TEMP_OUT; LDO_OUT; DAC4_OUT, DAC3_OUT, DAC1_OUT, HPF_OUT, LPF_OUT, SYNCH_OUT, GAINAMP_OUT, AMP3_OUT, AMP1_OUT, SENCE_OUT2, and SENCE_OUT1, which are all displayed in any of the result graphs P701 to P704, are displayed in the result graph P705 in Fig. 60C.

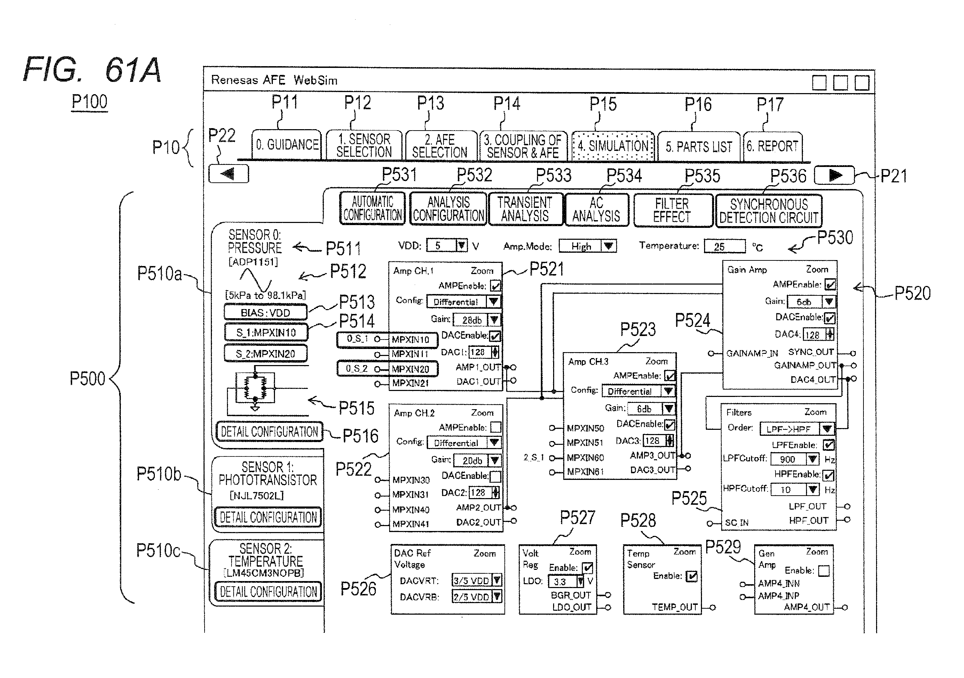

Fig. 61A to Fig. 61D are display examples that show the simulation screen P500 shown in Fig. 60A to Fig. 60C in which additional transient analysis results are additionally displayed. Here, Fig. 61A to Fig. 61D are parts of the simulation screen P500 that are to be displayed continuously in this order. In other words, the entirety of the simulation screen P500 is divided into four parts for convenience of display.

If the transient analysis is executed by additionally clicking "Transient Analysis" button P533 on the simulation screen P500 in Fig. 60A to Fig. 60C, a transient analysis result display area P710 is displayed under the transient analysis result display area P700 on the simulation screen P500 as shown in Fig. 61A to Fig. 61D.

In the transient analysis result display area P710, plural signal waves of simulation results are displayed in a lot on each of result graphs P711 to P715 as is the case with the transient analysis result display area P700.

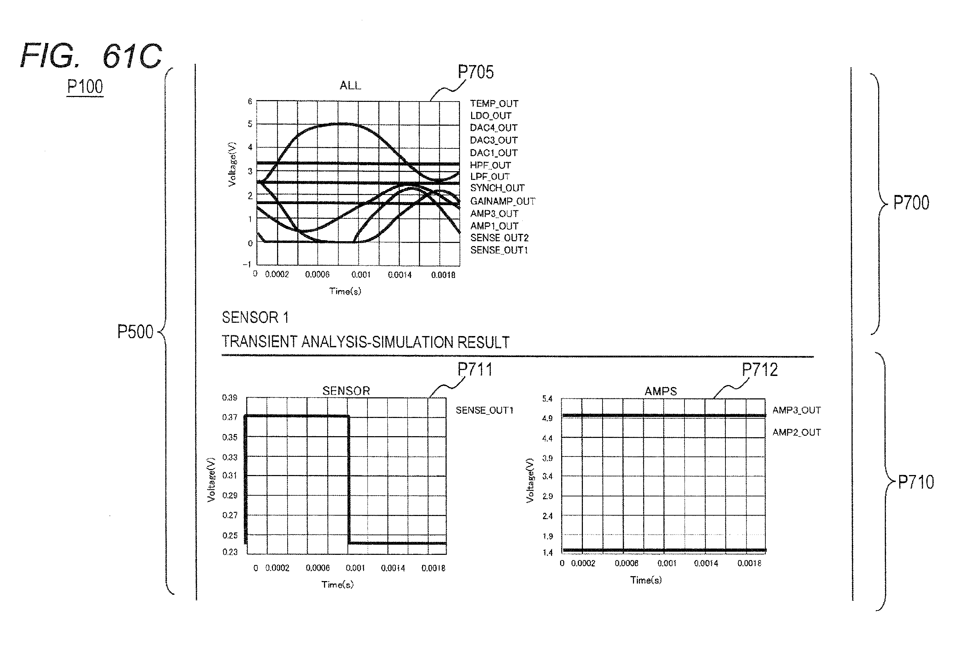

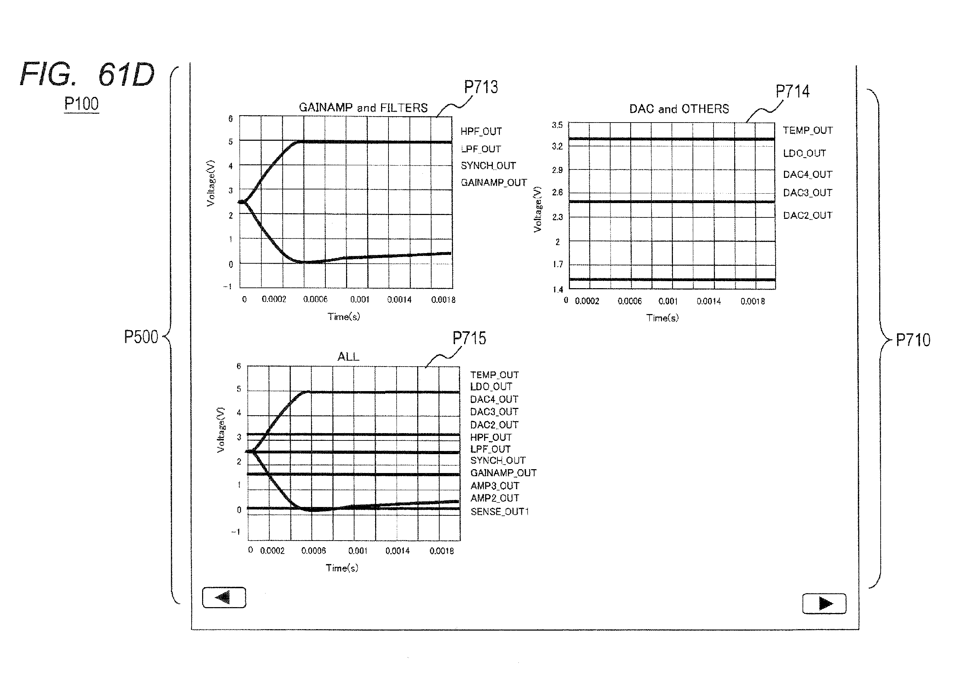

The result graph P711 in Fig. 61C displays output signal SENSE_OUT1 of the sensor. AMP3_OUT and AMP2_OUT are displayed in the result graph P712 in Fig. 61C. HPF_OUT; LPF_OUT; SYNCH_OUT; and GAINAMP_OUT are displayed in the result graph P713 in Fig. 61D. TEMP_OUT; LDO_OUT; DAC4_OUT; DAC3_OUT; and DAC2_OUT are displayed in the result graph P714 in Fig. 61D. TEMP_OUT; LDO_OUT; DAC4_OUT; DAC3_OUT; DAC2_OUT; HPF_OUT; LPF_OUT; SYNCH_OUT; GAINAMP_OUT; AMP3_OUT; AMP2_OUT; and SENCE_OUT1, which are all displayed in any of the result graphs P711 to P714, are displayed in the result graph P715 in Fig. 61D.

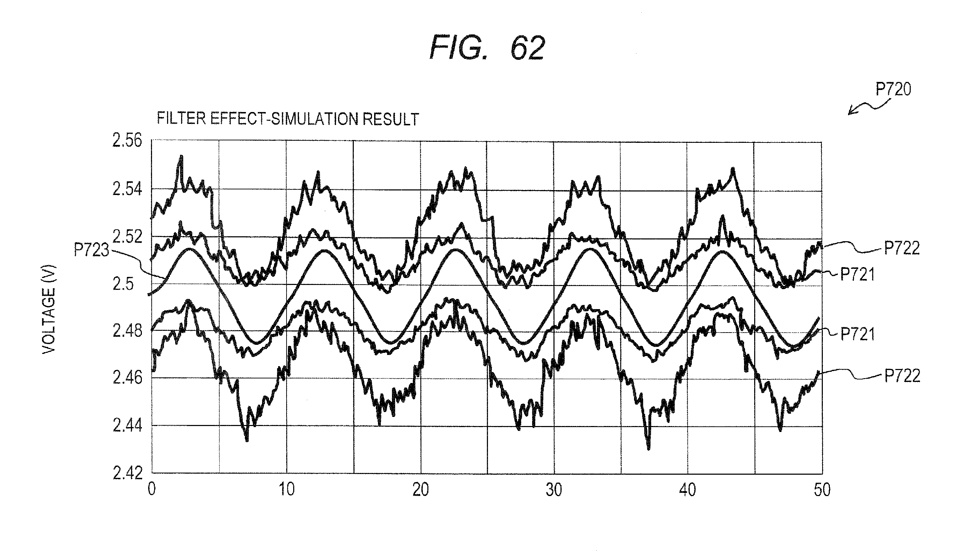

Fig. 62 is a diagram showing a display example of a result graph displaying the results of the filter effect analysis processing in Fig. 36. After the filter effect analysis is executed by clicking "Filter Effect" button P535, a filter effect result screen is displayed under the simulation screen P500. Plural result graphs are displayed on the filter effect result screen as is the case with the transient analysis results, and one of the result graphs is a result graph P720 in Fig. 62.

The result graph P720 displays in a lot (superimposedly) a sensor output signal P721 including a noise; an amplifier output signal P722 obtained by amplifying the sensor output signal P721 using an amplifier; and a filter output signal P723 obtained by removing the noise from the amplifier output signal P722 using an filter. Displaying the sensor output signal P721 and the amplifier output signal P722, both of which are signals before being filtered, and the filter output signal P723 after being filtered in a superimposed manner makes it possible to easily compare these signal waves before and after the filtering and to check the filter effect in a glance.

In the related art, checking a filter effect is performed with the use of the frequency characteristics of signals plotted along the horizontal axis representing frequencies, with the result that it becomes difficult to visually understand the filter effect. On the other hand, displaying the signals in such a way as shown in Fig. 62 makes it easier for a user to check the filter effect, so that it can be said that this method is user-friendly.

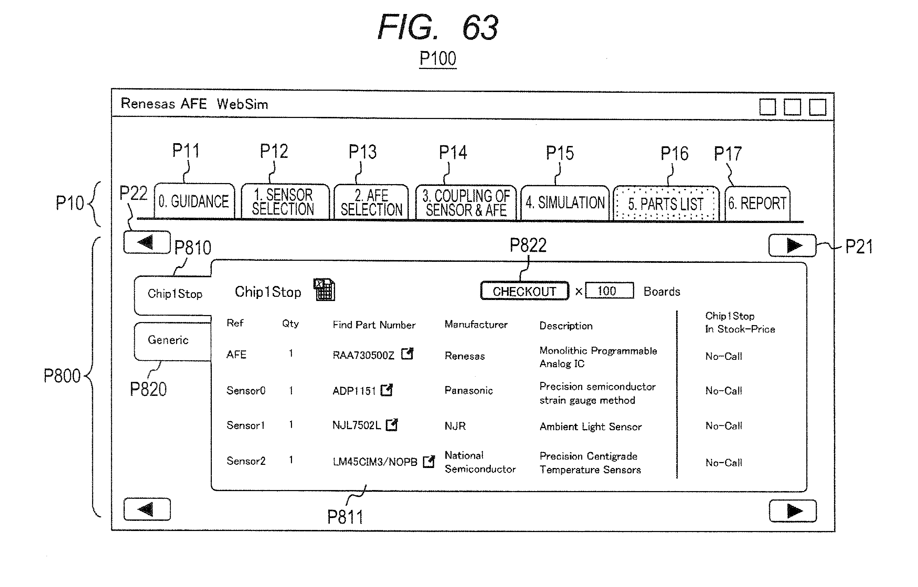

Fig. 63 is a diagram showing a display example of the parts list screen displayed at step S110 in Fig. 29. If "Parts List" tab P16 is selected on the web simulator screen P100 in Fig. 38, Fig. 39, Fig. 56, Fig. 57, Fig. 58, or the like, a parts list screen P800 is displayed as shown in Fig. 63.

On the parts list screen P800, a tab P810 and a tab P820 used for selecting parts dealers are displayed. A parts list P811 is displayed by selecting "Chip1Stop tab P810. On the parts list P811, the semiconductor device 1 and the list of sensors, which are selected at the time of simulation, are displayed. Information about individual parts is displayed in plural columns on the parts list P811. In Fig. 63, the name, the quantity, the part number, the manufacturer, the description, and the price for each part are displayed respectively in the columns "Ref", "Qty", "Find Part Number", "Manufacturer", "Description", and "In Stock-Price". By clicking "CHECOUT" button P822, parts can be purchased.

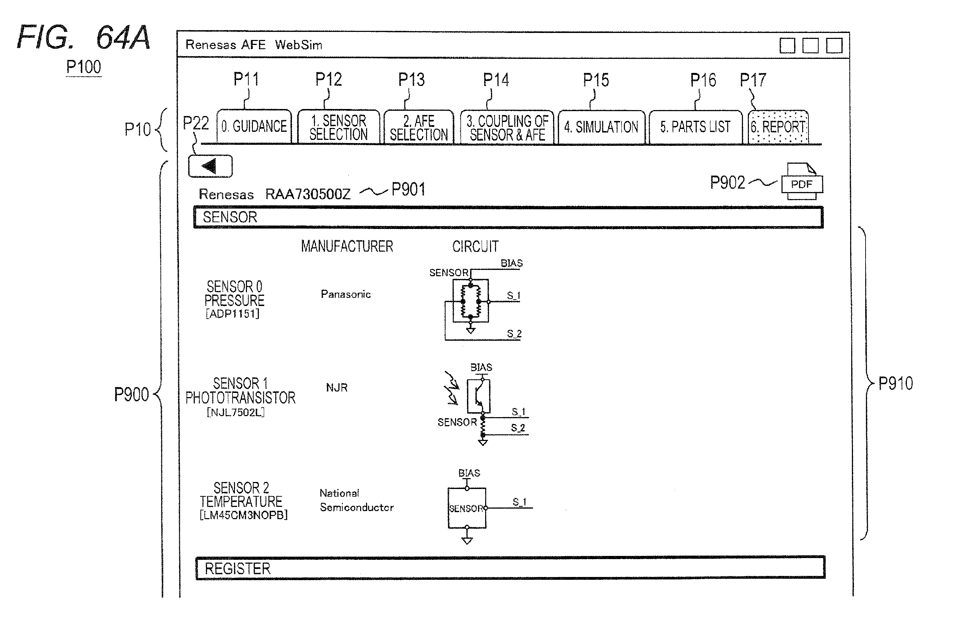

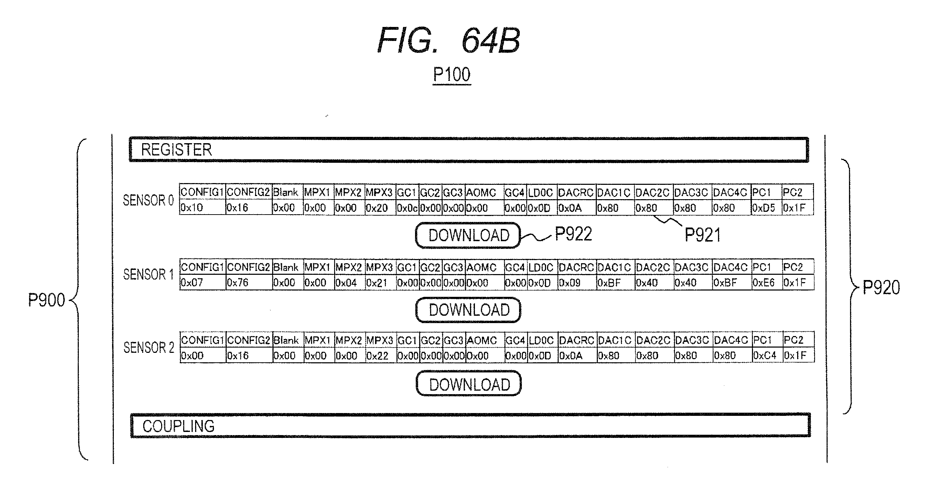

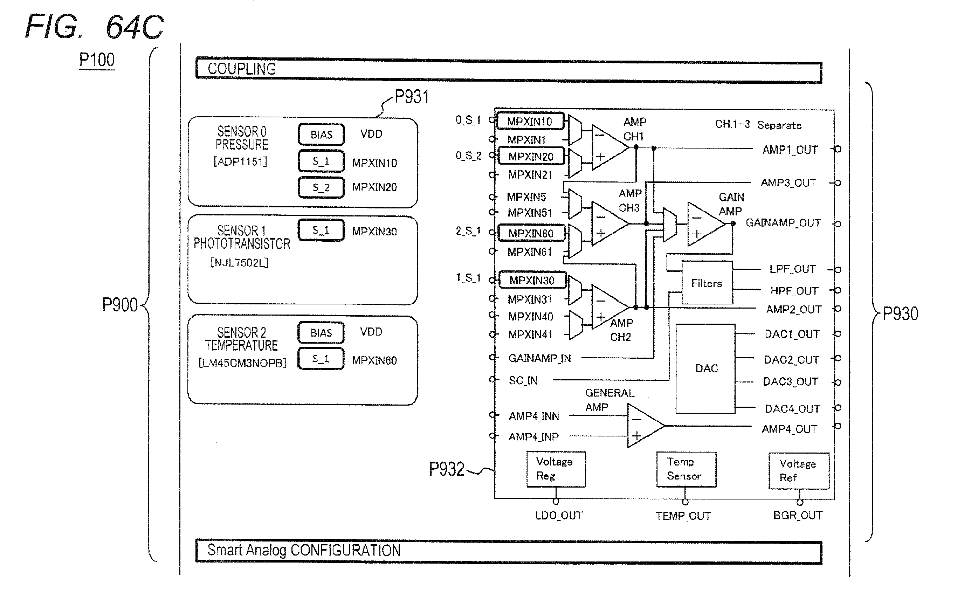

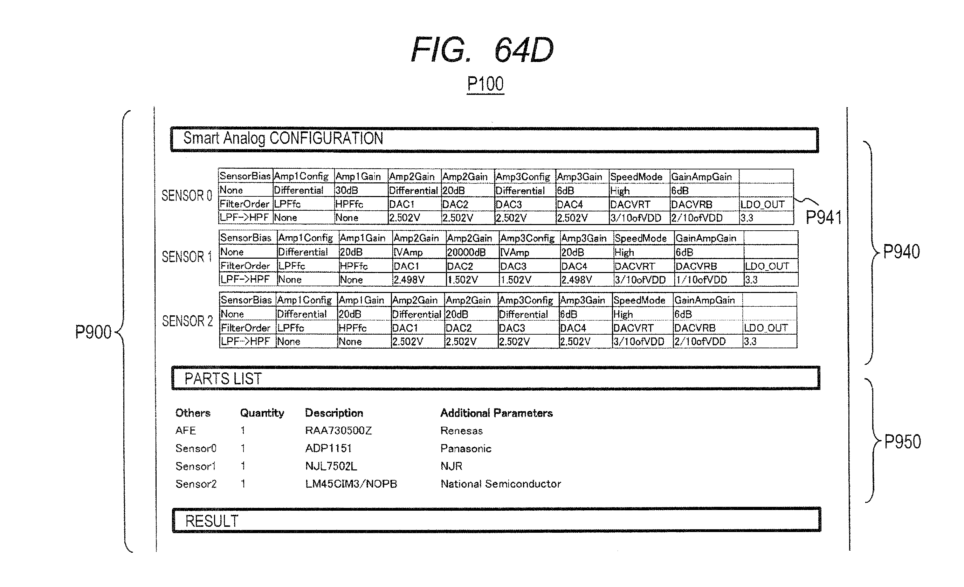

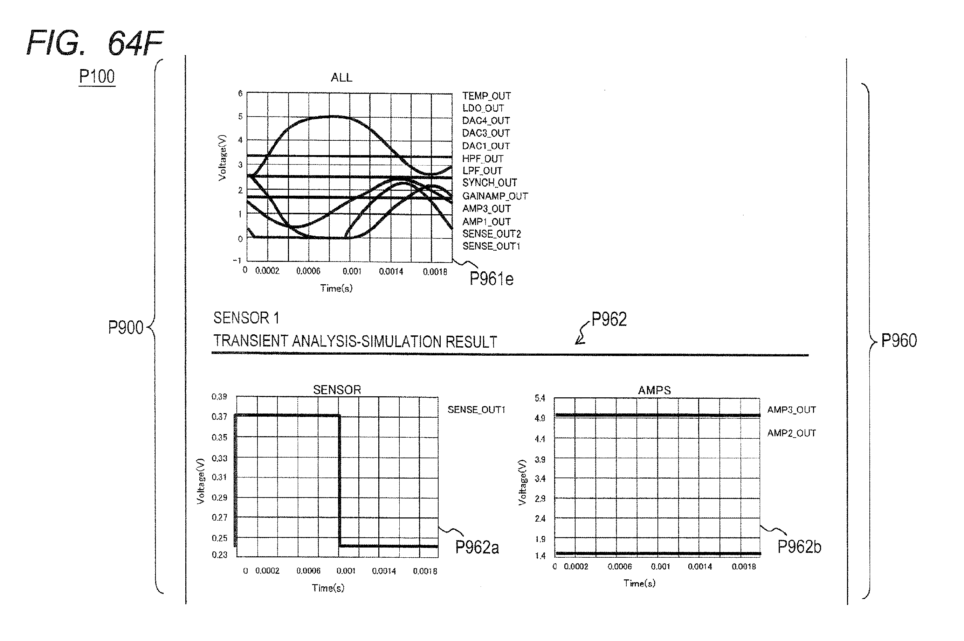

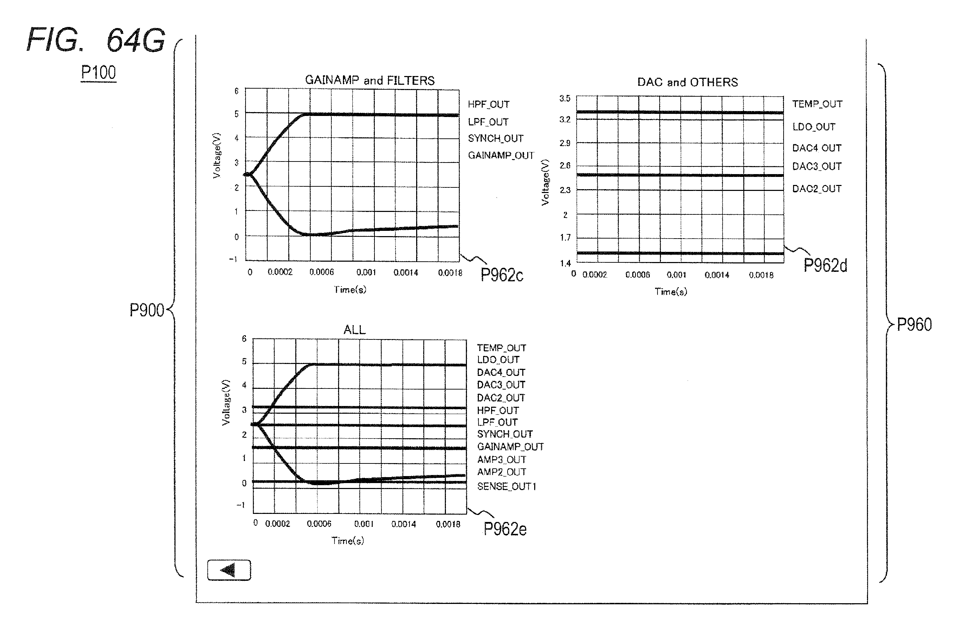

Fig. 64A to Fig. 64G are display examples of the report screens displayed at step S112 in Fig. 29. Here, Fig. 64A to Fig. 64G are parts of the report screen that are continuously to be displayed in this order. In other words, the entirety of the report screen is divided into seven parts for convenience of display.

If "Report" tab P17 is selected on the web simulator screen P100 in Fig. 38, Fig. 39, Fig. 56, Fig. 57, Fig. 58, Fig. 63 or the like, a report screen P900 is displayed as shown in Fig. 64A to Fig. 64G.

In the upper part of the report screen P900, a semiconductor device identification area P901, which is used for identifying a semiconductor device on which simulation is executed, is displayed. The part number of the semiconductor device, which is selected at the AFE selection screen and on which the simulation is executed, is displayed in the semiconductor device identification area P901. In an example shown in Fig. 64A, the part number "RAA730500Z", which is selected in Fig. 56, is displayed in the semiconductor device identification area P901.

In addition, a PDF icon P902 is displayed to the right side of the semiconductor device identification area P901. By clicking the PDF icon P902, a PDF file, which includes the entirety of the report screen P900 in a PDF file format, is downloaded to the user terminal 3. In other words, all the contents, which are included in the semiconductor device identification area P901, a sensor display area P910, a register display area P920, a coupling display area P930, a Smart Analog display area P940, a parts list display area P950, and a result display area P960, are written in a PDF file, and the PDF file is downloaded.

On the report screen P900, a sensor display area P910 is displayed under the semiconductor device identification area P901. The sensor types, the part numbers, and the manufacturers of the sensors, which are selected at the sensor selection screen and on which the simulation is executed, are displayed in the sensor display area P910, and in addition, the bias circuits, which are selected at the bias circuit screen and on which the simulation is executed, are displayed for individual sensors in the sensor display area P910. In the example shown in Fig. 64A, the pressure sensor, the phototransistor, and the temperature sensor, which are selected in Fig. 40, are displayed on the sensor display area P910, and the bias circuits, which are selected in Fig. 44, Fig. 45, or Fig. 48, are displayed in association with the corresponding sensors.

On the report screen P900, a register display area P920 is displayed under the sensor display area P910. In the register display area P920, register information table P921 and "Download" button P922 are displayed for each sensor. By clicking a "Download" button P922, register information displayed in the corresponding register information table P921 is downloaded to the user terminal 3.

In the register information table P921, the register information corresponding to the circuitry of the semiconductor device 1, which is configured on the simulation screen and on which the simulation is executed, is displayed. As described at step S111 in Fig. 29, the register information to be configured in the register 181 of the semiconductor device 1 is generated on the basis of the configured circuit information and parameters.

On the report screen P900, a coupling display area P930 is displayed under the register display area P920. In the coupling display area 930, the coupling relation between the sensors and the semiconductor device 1, which are configured in the sensor AFE selection screen and on which the simulation is executed, is displayed. In the coupling display area P930, as is the case with Fig. 57, a sensor selection frame P931 and a semiconductor device image P932 are displayed.

On the report screen P900, a Smart Analog (a semiconductor device) display area P940 is displayed under the coupling display area P930. In the Smart Analog display area P940, a configuration information table P941 about the semiconductor device 1 is displayed for each sensor.

In the configuration information table P941, the configuration information about the circuitry of the semiconductor device 1, which is configured in the simulation screen and on which the simulation is executed, is displayed. In the configuration information table P941, the configured values of the parameters of the semiconductor device 1 configured in Fig. 58 are displayed. In addition, the configuration information table P941 and the above described register information table P921 displayed in the register display area are compliant with each other, so that the contents configured in the register information table P921 can be checked with the use of the configuration information table P941.

On the report screen P900, a parts list display area 950 is displayed under the Smart Analog display area P940. In the parts list display area P950, a parts list including the semiconductor device 1 and the sensors that are used in the simulation is displayed. In the parts list display area P950, as is the case with the parts list screen P800, the name, the quantity, the part number, and the manufacturer for each part are displayed respectively in the columns "Others", "Quantity", "Description", and "Additional Parameters".

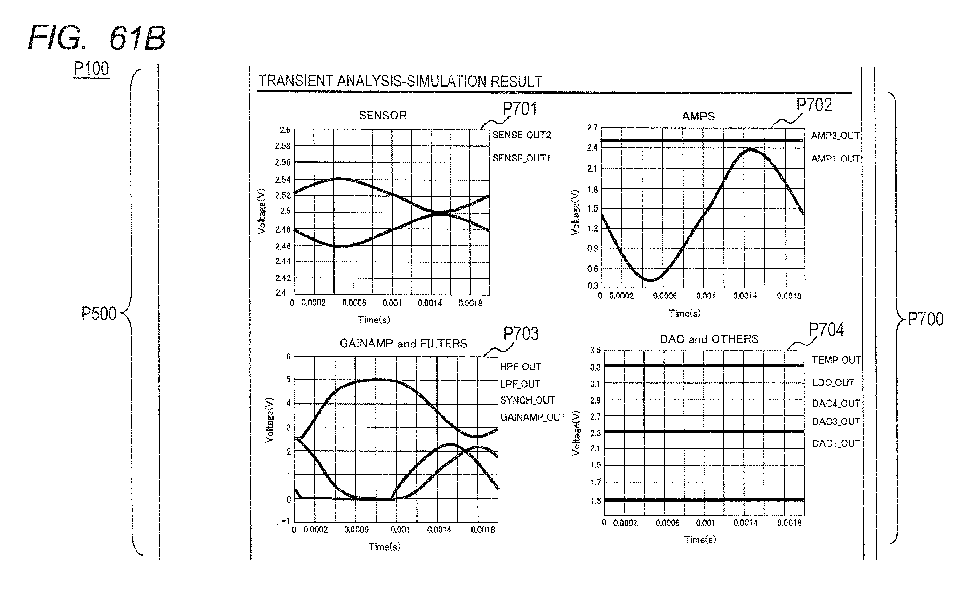

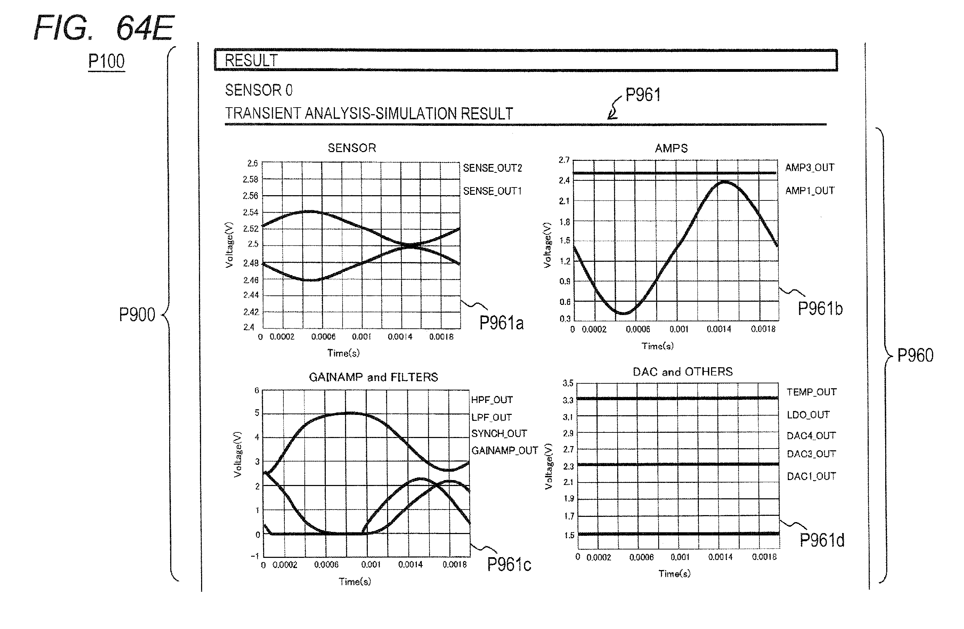

On the report screen P900, a result display area P960 is displayed under the parts list display area P950. The simulation results, which are obtained after simulation and displayed on the simulation screen, are displayed in the result display area P960. In Fig. 64E to Fig. 64G, as is the case with Fig. 61B to Fig. 61D, a transient analysis result P961 of the sensor 0 and a transient analysis result P962 of the sensor 1 are displayed. Result graphs P961a to P961e are displayed in the transient analysis result P961 as is the case with the result graphs P701 to P705 in Fig. 61B to Fig. 61D, and result graphs P962a to P962e are displayed in the transient analysis result P962 as is the case with the result graphs P711 to P715 in Fig. 61B to Fig. 61D.

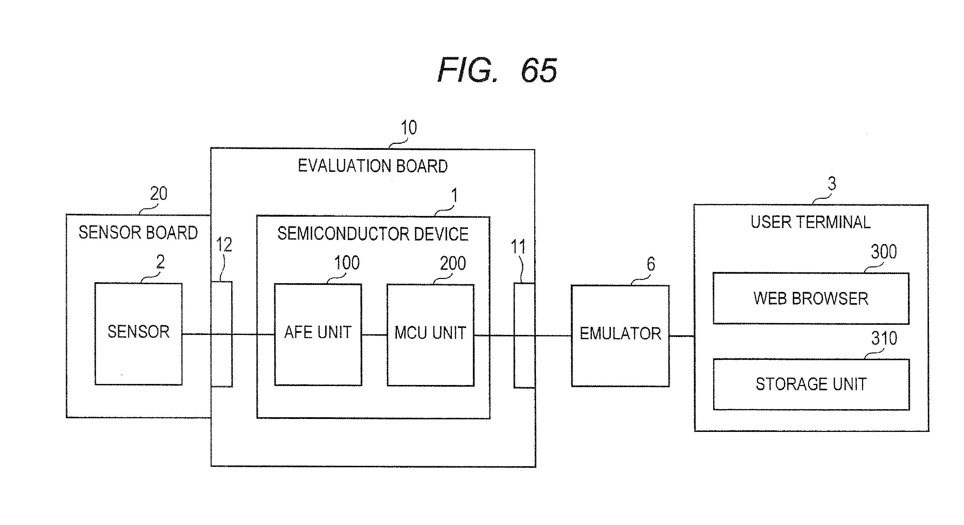

Fig. 65 is a diagram showing an example of a block diagram of a configuration system of a semiconductor device according to this embodiment. This configuration system is a system in which a user terminal 3 configures a semiconductor device 1 with register information the user terminal 3 receives from a web simulator 4. As shown in Fig. 65, this configuration system includes an evaluation board 10 on which the semiconductor device 1 is mounted; a sensor board 20 on which a sensor 2 is mounted; the user terminal 3; and an emulator 6.

The evaluation board 10 includes a USB interface 11 and a sensor interface 12. The user terminal 3 is coupled to the USB interface 11 with the emulator therebetween via a USB cable. The user terminal 3 and the emulator 6 are coupled to the semiconductor device 1 via the USB interface 11 so that the user terminal 3, the emulator 6, and the semiconductor device 1 can communicate with each other. The sensor board 20 is coupled to the semiconductor device 1 via the sensor interface 12, and the sensor 2 is coupled to the semiconductor device 1 via the sensor interface 12 so that the sensor 2 and the semiconductor device 1 can communicate with each other.

The emulator 6 is coupled to an MCU unit 200 of the semiconductor 1, and emulates the MCU 200. Owing to the coupling between the user terminal 3 and the emulator 6, the user terminal 3 can write register information to an AFE unit 100 and programs to the MCU unit 200.

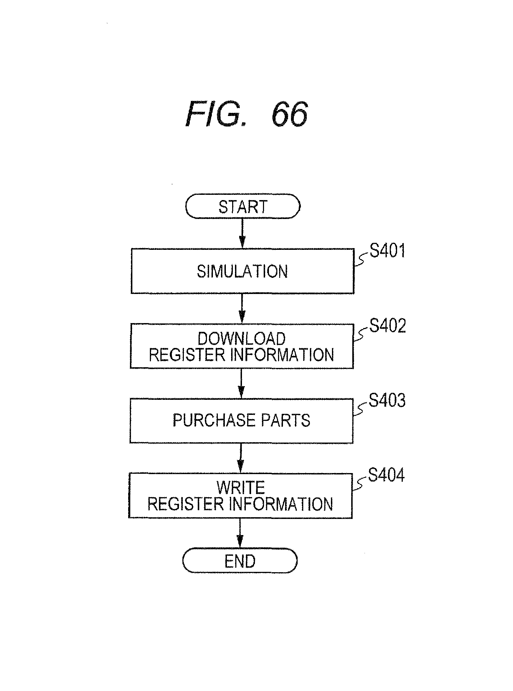

Fig. 65 is a flowchart showing a configuration method of the semiconductor device 1 in the configuration system in Fig. 65. As shown in Fig. 66, first, the operation of the semiconductor device 1 is simulated by the web simulator 4 (at step S401). In the system shown in Fig. 26, the user terminal 3 accesses the web simulator 4, and executes the simulation on the web simulator 4. As described above, the user terminal 3 accesses the simulation screen of the web simulator 4, and causes the web simulator 4 to simulate the operation of the semiconductor device 1 that is configured in accordance with the sensor and the corresponding bias circuit.

Next, the user terminal 3 downloads register information (at step S402). As described above, the user terminal 3 accesses the report screen of the web simulator 4, so that the user terminal downloads the register information of the semiconductor device 1 that is generated by the web simulator 4. The user terminal 3 stores the downloaded register information in a storage unit 310.

Next, the user terminal 3 purchases parts (at step S403). As described above, the user terminal 3 accesses the parts list screen of the web simulator 4, and purchases the sensors and the semiconductor device 1 on which the simulation is executed from the corresponding parts dealers. The user configures the configuration system shown in Fig. 65 by mounting the purchased sensors on the sensor board 20, and by coupling the purchased semiconductor device 1 to the evaluation board 10.

Next, the user terminal 3 writes the register information in the semiconductor device 1 (at step S404). In the configured configuration system shown in Fig. 65, the user terminal 3 writes the register information downloaded from the web simulator 4 in the register 181 of the semiconductor device 1 via the emulator 6.

After the above procedure, the configuration of the AFE unit 100 of the semiconductor device 1 is completed. Successively, if the semiconductor device 1 is launched, the circuitry and characteristics of the AFE unit 100 are configured with reference to the register information written in the register 181, and the AFE unit 100 starts its operation. In other words, it becomes possible to cause the semiconductor device 1 that has the configuration obtained by the simulation to run.

As described above, this embodiment of the present invention makes it possible to simulate the operation of the semiconductor device whose circuitry and circuit characteristics are variable by the web simulator. Because a simulation can be executed on the web simulator, it is not necessary for the user terminal to have a simulation environment, so that a user can freely execute a simulation. Because a simulation is executed on an analog circuit (AFE) that is the same as a semiconductor device 1 whose circuitry and circuit characteristics are variable, a user can execute various simulations on analog circuits having various circuitries and circuit characteristics with simple operations.

The web simulator according to this embodiment makes it possible for a user to arbitrarily select sensors and bias circuits to be coupled to a semiconductor device. When the user selects a sensor, plural bias circuits well-adapted to the selected sensor are automatically displayed to the user. The user can select a desired bias circuit from the plural bias circuits well-adapted to the sensor. In the related art, when a sensor is selected, the circuitry of a bias circuit corresponding to the sensor is fixed; therefore, the circuitry of a bias circuit that is well-suited to the user's application environment cannot be selected. According to this embodiment, a bias circuit well-suited to the actual application environment can be selected from among plural bias circuits; therefore, a simulation can be executed on a semiconductor device with an optimal circuitry.

In addition, if a sensor and the corresponding bias circuit are selected, the web simulator according to this embodiment automatically determines the circuitry of the configurable amplifier in accordance with the circuitries of the selected sensor and bias circuit. In addition, the gain and offset of the configurable amplifier are also configured in accordance with the characteristics of the selected sensor and bias circuit. Therefore, it becomes unnecessary for a user to check sensors and bias circuits or to examine the circuitry and characteristics of a semiconductor device 1 well-adapted to the selected sensor and bias circuit, with the result that the user can easily simulate the semiconductor device 1 with an optimal circuitry and characteristics.

In addition, the web simulator according to this embodiment is configured so that the input pattern of a physical quantity to be input to a sensor can be selected from among predefined waveform patterns. Simulating the operations of sensors and a semiconductor device with various types of waveform patterns as input patterns to the sensors makes it possible to effectively check various characteristics of an analog circuit including the sensors and the semiconductor device. For example, a user can easily check the frequency characteristics of the analog circuit by simulating the analog circuit with sine waves as input waveforms; the response characteristics by simulating the analog circuit with square waves or step responses as input waveforms; and the clipped characteristics by simulating the analog circuit with triangular waves as input waveforms.

Although the present invention made by inventors has been concretely described on the basis of the embodiment, the present invention is not limited to this embodiment, and it goes without saying that there may be various modifications without departing from the spirit and the scope of the present invention.

According to an exemplary embodiment, there is provided a simulator, which is used for simulating a semiconductor device including an AFE unit whose circuitry can be modified, includes: a circuitry configuration unit for configuring the circuitry of the AFE unit in accordance with a sensor that is coupled to the AFE unit; an input pattern selection unit for selecting a waveform pattern of a signal to be input to the sensor; and a simulation execution unit for executing a simulation on a combination of the sensor and the AFE unit that has the configured circuitry using the selected waveform pattern as an input condition.

## Claims

1. A simulator for simulating a semiconductor device including an analog front-end circuit whose circuitry can be modified, the simulator comprising:
an input pattern storage unit for storing a plurality of waveform patterns of signals that enter a sensor;
a circuitry configuration unit for configuring the circuitry of the analog front-end circuit in accordance with a sensor that is coupled to the analog front-end circuit;
an input pattern display unit for displaying the waveform patterns stored in the input pattern storage unit;
an input pattern selection unit for selecting a waveform pattern of a signal to be input to the sensor from among the displayed waveform patterns in accordance with a user operation; and
a simulation execution unit for executing a simulation on a combination of the sensor and the analog front-end circuit that has the configured circuitry using the selected waveform pattern as an input condition.

2. The simulator for simulating a semiconductor device according to claim 1, wherein the waveform patterns are represented by time-series data of time-serially continuous physical quantities.

3. The simulator for simulating a semiconductor device according to claim 1 or 2, wherein the waveform patterns include a sine wave pattern and/or a square wave pattern and/or a triangular wave pattern.

4. The simulator for simulating a semiconductor device according to claim 3, wherein the simulation execution unit configures (sets) the number of the stages of a configurable amplifier included in the analog front-end circuit in accordance with the frequency characteristic of an output signal of the analog front-end circuit in the case of the analog front-end circuit receiving the sine wave pattern.

5. The simulator for simulating a semiconductor device according to claim 3 or 4, wherein the input pattern selection unit specifies the sine wave pattern with the use of parameters including a minimum value, a maximum value, and a frequency of the sine wave.

6. The simulator for simulating a semiconductor device according to claim 3, wherein the simulation execution unit configures (sets) the operation mode of a configurable amplifier included in the analog front-end circuit in accordance with the response characteristic of an output signal of the analog front-end circuit in the case of the analog front-end circuit receiving the square wave pattern.

7. The simulator for simulating a semiconductor device according to claim 3 or 6, wherein the input pattern selection unit specifies the square wave pattern with the use of parameters including a minimum value, a maximum value, and a rise speed and a fall speed of the square wave.

8. The simulator for simulating a semiconductor device according to claim 3, wherein the simulation execution unit configures (sets) the offset or gain of a configurable amplifier included in the analog front-end circuit in accordance with the clipped state of an output signal of the analog front-end circuit in the case of the analog front-end circuit receiving the triangular wave pattern.

9. The simulator for simulating a semiconductor device according to one of claims 3 or 8, wherein the input pattern selection unit specifies the triangular wave pattern with the use of parameters including a minimum value, a maximum value, and a frequency of the triangular wave.

10. The simulator for simulating a semiconductor device according to one of claims 5, 7 or 9, wherein the input pattern selection unit determines the minimum value and the maximum value in accordance with the characteristic of a sensor coupled to the analog front-end circuit.

11. The simulator for simulating a semiconductor device according to one of claims 1 to 10, wherein the simulation execution unit executes a simulation on the combination of the sensor and the analog front-end circuit using the selected waveform pattern on which a noise pattern is superimposed.

12. The simulator for simulating a semiconductor device according to claim 11,
wherein the analog front-end circuit includes a filter for canceling the noise pattern; and
wherein the simulation execution unit superimposed-displays a signal before passing through the filter and the signal after passing through the filter.

13. A simulation method for simulating a semiconductor device including an analog front-end circuit whose circuitry can be modified, the simulation method comprising the steps of:
storing a plurality of waveform patterns of signals that enter a sensor in an input pattern storage unit;
configuring the circuitry of the analog front-end circuit in accordance with a sensor that is coupled to the analog front-end circuit;
displaying the waveform patterns stored in the input pattern storage unit;
selecting a waveform pattern of a signal to be input to the sensor from among the displayed waveform patterns in accordance with a user operation; and
executing a simulation on a combination of the sensor and the analog front-end circuit that has the configured circuitry using the selected waveform pattern as an input condition.

14. A computer readable media storing a simulation program for causing a computer to perform simulation processing on a semiconductor device including an analog front-end circuit whose circuitry can be modified, the simulation program including:
storing a plurality of waveform patterns of signals that enter a sensor in an input pattern storage unit;
configuring the circuitry of the analog front-end circuit in accordance with a sensor that is coupled to the analog front-end circuit;
displaying the waveform patterns stored in the input pattern storage unit;
selecting a waveform pattern of a signal to be input to the sensor from among the displayed waveform patterns in accordance with a user operation; and
executing a simulation on a combination of the sensor and the analog front-end circuit that has the configured circuitry using the selected waveform pattern as an input condition.
